# EUROPEAN PATENT APPLICATION

(11) **EP 1 686 655 A1**
(43) Date of publication of application: **02.08.2006**
(21) Application number: 04818539.1
(22) Date of filing: 15.11.2004
(51) Int. Cl.: H01R 11/01

(54) **ANISOTROPIC CONDUCTIVE SHEET, MANUFACTURING METHOD THEREOF, AND PRODUCT USING THE SAME**

(30) Priority: 17.11.2003 JP 2003386987; 03.02.2004 JP 2004026798
(71) Applicant: JSR Corporation, Tokyo 104-0045 (JP)
(72) Inventor: SENO, Koji, c/o JSR Corporation, Tokyo 1040045 (JP); HARUTA, Yuichi, c/o JSR Corporation, Tokyo 1040045 (JP)
(74) Representative: TBK-Patent
(86) International application number: PCT/JP2004/016945
(87) International publication number: WO 2005/048407

(57) **Abstract**

An anisotropically conductive sheet that can surely achieve necessary electrical connection even to an object to be connected, the arrangement pitch of electrodes to be connected of which is extremely small, a production process thereof, and applied products equipped with the anisotropically conductive sheet.

The anisotropically conductive sheet according to the present invention has an insulating sheet body formed of an elastic polymeric substance, in which a plurality of through-holes for forming conductive paths, each extending in a thickness-wise direction of the insulating sheet body, have been formed, and conductive path elements integrally provided in the respective through-holes for forming conductive paths of the insulating sheet body. The through-holes for forming conductive paths are formed by using a mask for exposure, in which a plurality of through-holes for beam transmission, the diameter of each of which becomes gradually small from one surface toward the other surface of the mask, have been formed in accordance with a pattern corresponding to a pattern of conductive path elements to be formed, and irradiating the insulating sheet body with a laser beam through the through-holes for beam transmission from the other surface side of the mask for exposure.

## Description

### TECHNICAL FIELD

The present invention relates to an anisotropically conductive sheet suitably used as a connector upon electrical inspection of, for example, circuit devices such as semiconductor integrated circuits, a production process thereof, and applied products thereof.

### BACKGROUND ART

An anisotropically conductive sheet is a sheet exhibiting conductivity only in its thickness-wise direction or having pressure-sensitive conductive conductor parts exhibiting conductivity only in its thickness-wise direction when it is pressurized in the thickness-wise direction. Since the anisotropically conductive sheet has such features that compact electrical connection can be achieved without using any means such as soldering or mechanical fitting, and that soft connection is feasible with mechanical shock or strain absorbed therein, it is widely used as a connector for achieving electrical connection between a circuit device, for example, a printed circuit board, and a leadless chip carrier, liquid crystal panel or the like making the best use of such features in fields of, for example, electronic computers, electronic digital clocks, electronic cameras and computer key boards.

On the other hand, in electrical inspection of circuit devices such as printed circuit boards and semiconductor integrated circuits, in order to achieve electrical connection between electrodes to be inspected formed on one surface of a circuit board, which is an object of inspection, and inspection electrodes formed on a front surface of a circuit board for inspection, it is conducted to cause an anisotropically conductive elastomer sheet to intervene between a region of electrodes to be inspected of an electric circuit part and a region of inspection electrodes of the circuit board for inspection.

As such anisotropically conductive sheets, those of various structures have heretofore been known. For example, Japanese Patent Application Laid-Open No. 93393/1976 of Patent Art. 1 discloses an anisotropically conductive elastomer sheet (hereinafter referred to as "dispersion type anisotropically conductive elastomer sheet") obtained by uniformly dispersing metal particles in an elastomer, and Japanese Patent Application Laid-Open No. 147772/1978 of Patent Art. 2 discloses an anisotropically conductive elastomer sheet (hereinafter referred to as "uneven distribution type anisotropically conductive elastomer sheet") obtained by unevenly distributing particles of a conductive magnetic substance in an elastomer to form a great number of conductive path-forming parts extending in a thickness-wise direction thereof and an insulating part mutually insulating them. Further, Japanese Patent Application Laid-Open No. 250906/1986 of Patent Art. 3 discloses an uneven distribution type anisotropically conductive elastomer sheet with a difference in level defined between the surface of each conductive path-forming part and an insulating part.
In the uneven distribution type anisotropically conductive elastomer sheet, since the conductive path-forming parts are formed in accordance with a pattern antipodal to a pattern of electrodes of a circuit device to be connected, it is advantageous compared with the dispersion type anisotropically conductive elastomer sheet in that electrical connection between electrodes can be achieved with high reliability even to a circuit device small in the arrangement pitch of electrodes to be connected, i.e., center distance between adjacent electrodes.

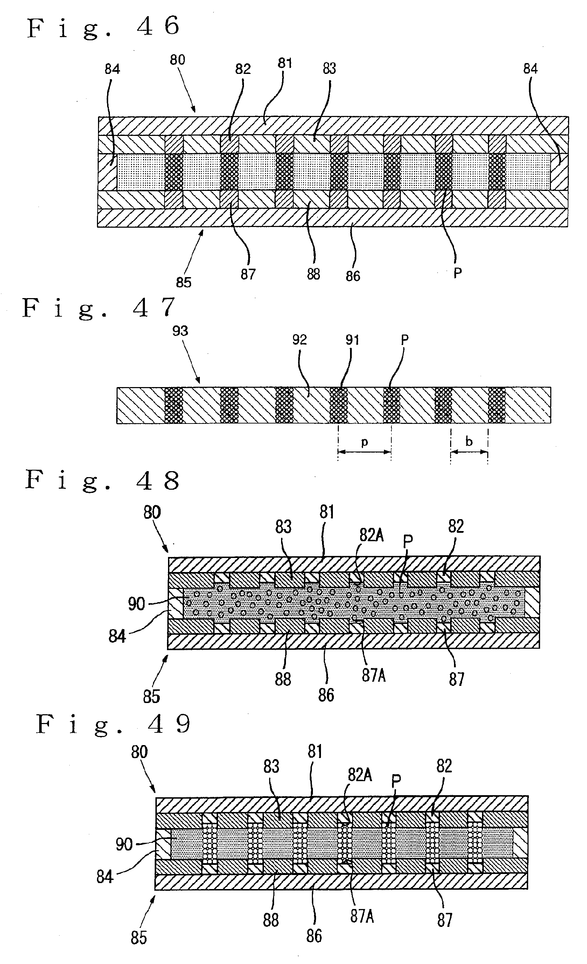

As an example of a process for producing such an uneven distribution type anisotropically conductive elastomer sheet, is known, for example, such a process as described below.
As illustrated in Fig. 45, a mold, in which a top force 80 and a bottom force 85 making a pair therewith are arranged so as to be opposed to each other through a frame-like spacer 84 to form a cavity between a lower surface of the top force 80 and an upper surface of the bottom force 85, is provided. A sheet-molding material with conductive particles exhibiting magnetism dispersed in a polymeric substance-forming material, which will become an elastic polymeric substance by a curing treatment, is fed into this mold to form a sheet-molding material layer 90. Here, the conductive particles P contained in the sheet-molding material layer 90 is in a state dispersed in the sheet-molding material layer 90.
Each of the top force 80 and bottom force 85 in the mold has, on a base plate 81 or 86 composed of, for example, a ferromagnetic substance, a molding surface composed of a plurality of ferromagnetic substance layers 82 or 87 formed in accordance with a pattern corresponding to a pattern of conductive path-forming parts of an anisotropically conductive elastomer sheet to be molded and non-magnetic substance layers 83 or 88 formed at other potions than the portions at which these ferromagnetic substance layers 82 or 87 have been formed, and both forces are arranged in such a manner that their corresponding ferromagnetic substance layers 82 and 87 are opposed to each other.

As illustrated in Fig. 46, a pair of, for example, electromagnets (not illustrated) are arranged on an upper surface of the top force 80 and a lower surface of the bottom force 85, and the electromagnets are operated, thereby applying a magnetic field having higher intensity at portions between ferromagnetic substance layers 82 of the top force 80 and their corresponding ferromagnetic substance layers 87 of the bottom force 85, i.e., portions to become conductive path-forming parts, than the other portions to the sheet-molding material layer 90 in a thickness-wise direction of the molding material layer 90. As a result, the conductive particles P dispersed in the sheet-molding material layer 90 are gathered at the portions applied by the magnetic field having the higher intensity in the molding material layer 90, i.e., the portions between the ferromagnetic substance layers 82 of the top force 80 and their corresponding ferromagnetic substance layers 87 of the bottom force 85, and further oriented so as to align in the thickness-wise direction. In this state, the sheet-molding material layer 90 is subjected to a curing treatment, thereby producing an uneven distribution type anisotropically conductive,elastomer sheet 93 composed of a plurality of conductive path-forming parts 91, in which the conductive particles P are contained in a state oriented so as to align in the thickness-wise direction, and an insulating part 92 for mutually insulating these conductive path-forming parts 91 as illustrated in Fig. 47.

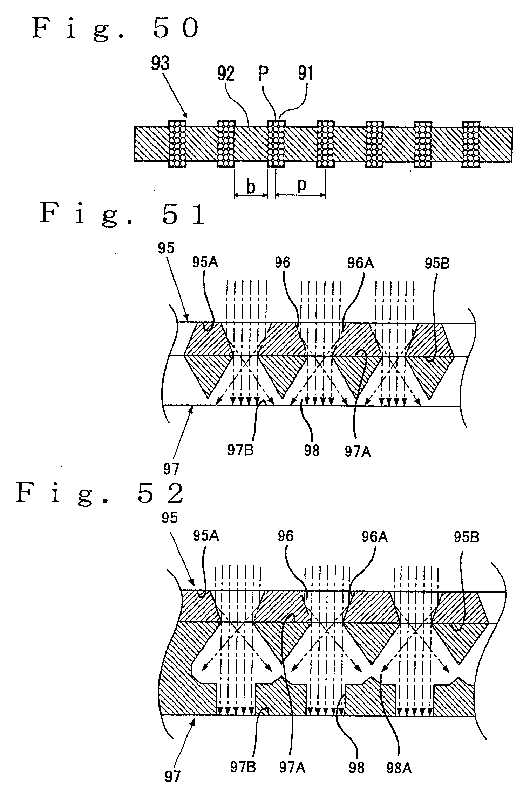

There has been proposed that in which conductive path-forming parts are formed in a projected state for the purpose of more surely achieving electrical connection to an object of connection. As a process for producing such an uneven distribution type anisotropically conductive elastomer sheet, is used, for example, a mold that recesses 82A and 87A for forming projected parts on an anisotropically conductive elastomer sheet are formed at positions where the ferromagnetic substance layers 82 and 87 in the molding surfaces of the top force 80 and bottom force 85 arranged so as to be opposed to each other through the frame-like spacer 84 are located as illustrated in Fig. 48. A sheet-molding material layer 90 is formed in the mold in the same manner as described above. As illustrated in Fig. 49, a pair of, for example, electromagnets (not illustrated) are arranged on an upper surface of the top force 80 and a lower surface of the bottom force 85, and the electromagnets are operated, whereby the conductive particles P dispersed in the sheet-molding material layer 90 are gathered at portions between the ferromagnetic substance layers 82 of the top force 80 and their corresponding ferromagnetic substance layers 87 of the bottom force 85, and further oriented so as to align in the thickness-wise direction. In this state, the sheet-molding material layer 90 is subjected to a curing treatment, thereby producing an uneven distribution type anisotropically conductive elastomer sheet 93 composed of a plurality of conductive path-forming parts 91, in which the conductive particles P are contained in a state oriented so as to align in the thickness-wise direction, and an insulating part 92 for mutually insulating these conductive path-forming parts 91, said conductive path-forming parts 91 projecting from the surfaces as illustrated in Fig. 50. In Figs. 48 and 49, reference numerals 81 and 86 designate base plates composed of a ferromagnetic substance, and reference numerals 83 and 88 indicate non-magnetic substance layers formed at other positions than the positions where the ferromagnetic substance layers 82 and 87 are formed.

In order to achieve sufficient insulating property between adjacent conductive path-forming parts 91 in such a production process as described above, however, it is necessary to control a width of the insulating part 92, i.e., a clearance between adjacent conductive path-forming parts 91 to, for example, at least 50 µm. In the production of an anisotropically conductive elastomer sheet having conductive path-forming parts 91 extremely small in arrangement pitch p, there is thus a problem that it is difficult to obtain an anisotropically conductive elastomer sheet equipped with conductive path-forming parts 91 having sufficient conductive property and strength, since it is necessary to secure the insulating property between the conductive path-forming parts 91 by making the width of the conductive path-forming parts 91 themselves small.

On the other hand, it is known to produce an uneven distribution type anisotropically conductive elastomer sheet, in which conductive path elements are formed integrally with an insulating sheet base composed of, for example, an elastic polymeric substance, by forming a plurality of through-holes for forming conductive paths, each of which extend in a thickness-wise direction of the insulating sheet base, in the insulating sheet base, charging a conductive path element-forming material obtained by dispersing conductive particles in a polymeric substance-forming material, which will become an elastic polymeric substance by being cured, into the through-holes for forming conductive paths, and subjecting the conductive path element-forming material to a curing treatment (see, for example, Patent Art. 4).

As examples of a method for forming the through-holes for forming conductive paths in the insulating sheet base in the production process of such an anisotropically conductive elastomer sheet, may be mentioned a method that a mask for exposure, in which through-holes for beam transmission have been formed in accordance with a pattern of conductive path elements to be formed, is used, and an insulating sheet base is irradiated with a laser beam through the through-holes for beam transmission in the mask for exposure, thereby forming a plurality of through-holes for forming conductive paths (see, for example, Patent Art. 5), and a method that through-holes for beam transmission are formed in a thin metal layer integrally formed on one surface of an insulating sheet base in accordance with a pattern of conductive path elements to be formed, and the insulating sheet base is irradiated with a laser beam through the through-holes for beam transmission in the thin metal layer, thereby forming a plurality of through-holes for forming conductive paths (see, for example, Patent Art. 4 and Patent Art. 6) from the reason that a plurality of the through-holes for forming conductive parts can be formed at proper positions with high productivity.
Since the mask for exposure is obtained by, for example, arranging a mask base on a working stage in a series of steps of producing an anisotropically conductive elastomer sheet, forming a resist layer, in which patterned holes are formed in accordance with a prescribed pattern, on one surface of the mask base, subjecting the mask base to an etching treatment, thereby forming through-holes for beam transmission, and then releasing the resist layer, the resultant mask for exposure is transferred in parallel from the working stage and arranged in such a manner that the other surface of the mask for exposure comes into contact with one surface of the insulating sheet base, and one surface of the mask for exposure that is a surface, on which the resist layer has been formed upon the formation of the through-holes for beam transmission, is used as a surface to be irradiated with a laser beam (see, for example, Fig. 51) from the viewpoints of easiness of operation and improvement of operation efficiency. As a method for forming the through-holes for beam transmission in the mask for exposure, may also be mentioned a method by conducting, for example, drill machining or the like. For the reason that such a method is difficult to form the through-holes for beam transmission at a fine pitch, however, the method that the through-holes for beam transmission are formed by such an etching treatment as described above is preferably used.

Patent Art. 1: Japanese Patent Application Laid-Open No. 093393/1976;
Patent Art. 2: Japanese Patent Application Laid-Open No. 147772/1978;
Patent Art. 3: Japanese Patent Application Laid-Open No. 250906/1986.
Patent Art. 4: Japanese Patent Application Laid-Open No. 354178/1999;
Patent Art. 5: Japanese Patent Application Laid-Open No. 199208/1997;
Patent Art. 6: Japanese Patent Application Laid-Open No. 2002-196018.

### DISCLOSURE OF THE INVENTION

With the miniaturization or high-density wiring of electric products in recent years, circuit devices used therein, such as integrated circuit devices, tend to arrange electrodes at a high density because the number of electrodes increases, and the arrangement pitch of the electrodes becomes smaller, and so the uneven distribution type anisotropically conductive elastomer sheet obtained by using such a mask for exposure as described above is required to form the conductive path elements at a fine arrangement pitch for the purpose of achieving sufficient electrical connection to such a circuit device.

In the case where an anisotropically conductive sheet fine in the arrangement pitch of conductive path-forming parts is produced by such a process as described above, however, the following problems arise.
Namely, as illustrated in Fig. 51, each of the through-holes 96 for beam transmission of the mask 95 for exposure formed by the etching process is unavoidably formed into a shape that the diameter becomes gradually small from one surface (resist layer-formed surface) toward the other surface, for example, a tapered shape because the one surface of the mask base is exposed longer than the interior thereof to an etchant, so that a part of a laser beam (indicated by an alternate long and short dash line in Fig. 51) is irregularly reflected on the tapered inner wall surface 96A of the through-hole 96 for beam transmission, whereby through-holes 98 for forming conductive paths, each of which has a shape that the diameter becomes gradually large from one surface 97A toward the other surface 97B, are formed in an insulating sheet base 97. As a result, the resultant anisotropically conductive sheet becomes such that respective conductive paths are formed connectively to one another at, for example, the other side portion of the insulating sheet body, and the conductive path elements are short-circuited by one another when the anisotropically conductive sheet is used in electrical inspection of circuit devices. After all, there is a problem that such an anisotropically conductive sheet cannot surely achieve necessary electrical connection.
As illustrated in Fig. 52, through-holes 98 for forming conductive paths, which each have a shape having a maximum portion 98A, the diameter of which becomes maximum in the interior of an insulating sheet base 97, formed by a part of the laser beam irregularly reflected on the tapered inner wall surface 96A in each through-hole 96 for beam transmission, are formed when the thickness of the insulating sheet base 97 is great. As a result, the resultant anisotropically conductive sheet becomes such that respective conductive paths are formed in a state insulated from one another at its both surfaces, whereas the respective maximum portions 98A are connected to one another in the interior of the insulating sheet body. After all, such an anisotropically conductive sheet cannot surely achieve necessary electrical connection.

Such problems also arise in the technique disclosed in Patent Art. 4 and Patent Art 6, i.e., the case where the through-holes for beam transmission are formed in the thin metal layer integrally provided on one surface of the insulating sheet base, and the insulating sheet base is irradiated with the laser beam through the through-holes for beam transmission to form the through-holes for forming conductive paths, and are particularly marked in the case where an anisotropically conductive sheet having conductive path elements, whose arrangement pitch is at most 200 µm is produced.

In the case where an anisotropically conductive sheet with conductive path elements formed in a state protruding from both surfaces of the insulating sheet body is produced by such a process as described above, there is, for example, a process in which a mask for printing with openings formed in accordance with a pattern corresponding to an arrangement pattern of the conductive path elements is used, a conductive path element-forming material is charged into the openings of the mask for printing, the conductive path element-forming material is subjected to a curing treatment, and the mask for printing is then separated to form projected parts. However, such a process involves a problem that the projected parts may be broken off in some cases, and so conductive path elements having the expected conductive property cannot be surely formed.

The present invention has been made on the basis of the foregoing circumstances and has as its first object the provision of an anisotropically conductive sheet that can surely achieve necessary electrical connection even to an object to be connected, the arrangement pitch of electrodes to be connected of which is extremely small.
A second object of the present invention is to provide a process capable of advantageously and surely producing an anisotropically conductive sheet that can surely achieve necessary electrical connection even to an object to be connected, the arrangement pitch of electrodes to be connected of which is extremely small.
A third object of the present invention is to provide an anisotropically conductive connector, which is equipped with the above-described anisotropically conductive sheet and can surely achieve necessary electrical connection to a circuit device to be connected even when the pitch of electrodes in the circuit device is small, and a process capable of advantageously and surely producing such an anisotropically conductive connector.
A fourth object of the present invention is to provide a probe for circuit inspection, which is equipped with the above-described anisotropically conductive sheet and has high reliability on connection to each of electrodes to be inspected in a circuit device that is an object of inspection even when the pitch of the electrodes to be inspected in the circuit device is small.
A fifth object of the present invention is to provide an electrical inspection apparatus for circuit devices, which is equipped with the above-described anisotropically conductive sheet and can surely achieve necessary electrical connection to a circuit device that is an object of inspection even when the pitch of electrodes to be inspected in the circuit device is small.

The anisotropically conductive sheet provided by the present invention is an anisotropically conductive sheet comprising an insulating sheet body formed of an elastic polymeric substance, in which a plurality of through-holes for forming conductive paths, each extending in a thickness-wise direction of the insulating sheet body, have been formed, and conductive path elements integrally provided in the respective through-holes for forming conductive paths of the insulating sheet body, wherein,
the through-holes for forming conductive paths in the insulating sheet body are formed by using a mask for exposure, in which a plurality of through-holes for beam transmission, the diameter of each of which becomes gradually small from one surface toward the other surface of the mask, have been formed in accordance with a pattern corresponding to a pattern of conductive path elements to be formed, and irradiating the insulating sheet body with a laser beam through the through-holes for beam transmission in the mask for exposure from the other surface side of the mask for exposure.

In the anisotropically conductive sheet according to the present invention, it may be preferable that the conductive path elements contain conductive particles exhibiting magnetism in a state oriented in a thickness-wise direction thereof.
In the anisotropically conductive sheet according to the present invention, it may also be preferable that the elastic polymeric substance forming the insulating sheet body be silicone rubber.
In the anisotropically conductive sheet according to the present invention, it may further be preferable that each of the conductive path elements be so formed that a projected part protruding from at least one surface of the insulating sheet body is provided, and the one surface-side projected part protruding from the one surface of the insulating sheet body may have a tapered shape that its diameter becomes gradually small from the proximal end toward the distal end thereof.

The process provided by the present invention for producing an anisotropically conductive sheet is a process comprising:
the first step of providing a mask for exposure, in which a plurality of through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed, arranging the mask for exposure on one surface of an insulating sheet base formed of an elastic polymeric substance in such a manner that the one surface of the mask for exposure comes into contact with the one surface of the insulating sheet base, and irradiating the insulating sheet base with a laser beam through the through-holes for beam transmission in the mask for exposure from the other surface side of the mask for exposure, thereby forming an insulating sheet body in which a plurality of through-holes for forming conductive paths, each extending in a thickness-wise direction of the sheet body, have been formed, and
the second step of charging a conductive path element-forming material with conductive particles dispersed in a polymeric substance-forming material, which will become an elastic polymeric substance by being cured, into each of the through-holes for forming conductive paths in the insulating sheet body, thereby forming conductive path element-forming material layers in the respective through-holes for forming conductive paths in the insulating sheet body, and subjecting the conductive path element-forming material layers to a curing treatment, thereby forming conductive path elements provided integrally with the insulating sheet body.

In the process according to the present invention for producing the anisotropically conductive sheet, it may be preferable that particles exhibiting magnetism be used as the conductive particles in the conductive path element-forming material, and
a magnetic field be applied to the conductive path element-forming material layers formed integrally with the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers be subjected to the curing treatment in this state, thereby forming the conductive path elements.
It may also be preferable that a plurality of the through-holes for forming conductive paths be formed at a time by irradiating the insulating sheet base with the laser beam through a plurality of the through-holes for beam transmission in the mask for exposure.
It may further be preferable that the conductive path element-forming material layers be formed by charging the conductive path element-forming material into the through-holes for forming conductive paths in the insulating sheet body and the through-holes for beam transmission in the mask for exposure in a state that the mask for exposure has remained arranged on the one surface of the insulating sheet body, and the conductive path element-forming material layers be subjected to the curing treatment, thereby forming conductive path elements each having a one surface-side projected part outwardly protruding from the one surface of the insulating sheet body, said projected part having a shape that its diameter becomes gradually small from the proximal end toward the distal end thereof.

The process provided by the present invention for producing an anisotropically conductive sheet is a process for producing an anisotropically conductive sheet having an insulating sheet body formed of an elastic polymeric substance, in which a plurality of through-holes for forming conductive paths, each extending in a thickness-wise direction of the insulating sheet body, have been formed, and conductive path elements integrally provided in the respective through-holes for forming conductive paths of the insulating sheet body in a state protruding from at least one surface of the insulating sheet body, the process comprising:
the steps of providing a mask for exposure, in which a plurality of through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed,
preparing a laminate with a resin layer for forming projected parts formed on at least one surface of an insulating sheet base composed of the elastic polymeric substance, arranging the mask for exposure on one surface of the laminate in such a manner that the one surface of the mask for exposure comes into contact with the one surface of the laminate, and irradiating the insulating sheet base with a laser beam through the through-holes for beam transmission in the mask for exposure from the other surface side of the mask for exposure to form a plurality of through-holes for forming conductive paths, each extending in a thickness-wise direction of the insulating sheet base, in the insulating sheet base of the laminate, and at the same time form a plurality of through-holes for forming projected parts, each extending continuously with its corresponding through-hole for forming a conductive path in the thickness-wise direction, in the resin layer for forming projected parts of the laminate, thereby forming a primary composite body with the resin layer for forming projected parts formed on at least one surface of an insulating sheet body,
the steps of charging a conductive path element-forming material with conductive particles dispersed in a polymeric substance-forming material, which will become an elastic polymeric substance by being cured, into spaces for forming conductive path elements, including internal spaces of the through-holes for forming conductive paths in the insulating sheet body and internal spaces of the through-holes for forming projected parts in the resin layer for forming projected parts, thereby forming conductive path element-forming material layers in the respective spaces for forming conductive paths, and subjecting the conductive path element-forming material layers to a curing treatment to form conductive path elements, thereby forming a secondary composite body with a plurality of the conductive path elements integrally provided in the spaces for forming conductive path elements in the primary composite body, and
the step of dissolving the resin layer for forming projected parts of the secondary composite body to remove it, thereby forming projected parts protruding from at least one surface of the insulating sheet body on the respective conductive path elements.

In the process according to the present invention for producing the anisotropically conductive sheet, it may be preferable that silicone rubber be used as the elastic polymeric substance forming the insulating sheet body, and polyvinyl alcohol be used as a resin layer-forming material forming the resin layer for forming projected parts. In this case, it may be preferable to use that having an average polymerization degree of 100 to 5,000 as the polyvinyl alcohol.
It may also be preferable to form the resin layer for forming projected parts in a thickness of 5 to 100 µm.

In the process according to the present invention for producing the anisotropically conductive sheet, it may further be preferable that particles exhibiting magnetism be used as the conductive particles in the conductive path element-forming material,
a magnetic field be applied to the conductive path element-forming material layers formed in the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers be subjected to the curing treatment in this state, thereby forming the conductive path elements.
It may still further be preferable that a plurality of the through-holes for forming conductive paths be formed at a time by irradiating the insulating sheet base with the laser beam through a plurality of the through-holes for beam transmission in the mask for exposure.
It may yet still further be preferable that a laminate with a resin layer for forming projected parts formed on the other surface of the insulating sheet base is used to form a primary composite body with the resin layer for forming projected parts formed on the other surface of the insulating sheet body,
the conductive path element-forming material be charged into spaces for forming conductive path elements, including internal spaces of the through-holes for beam transmission in the mask for exposure, internal spaces of the through-holes for forming conductive paths in the insulating sheet body and internal spaces of the through-holes for forming projected parts in the resin layer for forming projected parts, in a state that the mask for exposure has remained arranged on one surface of the insulating sheet body in the primary composite body to form the conductive path element-forming material layers, the conductive path element-forming material layers be subjected to the curing treatment to form conductive path elements,
the mask for exposure be removed to expose one end portions of the conductive path elements, thereby forming one surface-side projected parts each having a shape that its diameter becomes gradually small from the proximal end toward the distal end thereof, and the resin layer for forming projected parts be dissolved and removed, thereby forming the other surface-side projected parts protruding from the other surface of the insulating sheet body.

In the processes according to the present invention for producing the anisotropically conductive sheet, it may be preferable that the laser beam be emitted by means of a carbon dioxide gas laser.
In the processes according to the present invention for producing the anisotropically conductive sheet, it may also be preferable that a mask having a thickness of 5 to 100 µm be used as the mask for exposure, a mask having an opening diameter ratio r2/r1 of an opening diameter r2 in the other surface of the mask to an opening diameter r1 in one surface of the mask of from 0.2 to 0.98, preferably from 0.2 to 0.95, more preferably from 0.3 to 0.9 be used as the mask for exposure, and a mask composed of a metal be used as the mask for exposure.
In the present description, "the opening diameter of the through-hole for beam transmission" means its diameter when the sectional form of the opening is circular, or a width in a direction that the through-holes adjoining each other are arranged when the sectional form of the opening is in any other form than the circle.

The anisotropically conductive connector provided by the present invention is an anisotropically conductive connector comprising a frame plate having an opening and the above-described anisotropically conductive sheet arranged so as to close the opening in the frame plate and supported by an opening edge of the frame plate.

The anisotropically conductive connector provided by the present invention is an anisotropically conductive connector suitable for use in conducting electrical inspection of each of a plurality of integrated circuits formed on a wafer in a state of the wafer, which comprises:
a frame plate, in which a plurality of openings have been formed correspondingly to regions, in which electrodes to be inspected in all of the integrated circuits formed on the wafer, which is an object of inspection, have been arranged, and a plurality of anisotropically conductive sheets respectively arranged so as to close the openings in the frame plate and supported by their corresponding opening edges of the frame plate, wherein each of the anisotropically conductive sheets is the above-described anisotropically conductive sheet.

The anisotropically conductive connector provided by the present invention is an anisotropically conductive connector suitable for use in conducting electrical inspection of each of a plurality of integrated circuits formed on a wafer in a state of the wafer, which comprises:
a frame plate, in which a plurality of openings have been formed correspondingly to regions, in which electrodes to be inspected in a plurality of integrated circuits selected from among the integrated circuits formed on the wafer, which is an object of inspection, have been arranged, and a plurality of anisotropically conductive sheets respectively arranged so as to close the openings in the frame plate and supported by their corresponding opening edges of the frame plate, wherein each of the anisotropically conductive sheets is the above-described anisotropically conductive sheet.

The process provided by the present invention for producing an anisotropically conductive connector is a process comprising:
the first step of providing a frame plate, in which an opening has been formed, forming a layer of a polymeric substance-forming material, which will become an elastic polymeric substance by being cured, in the opening of the frame plate and at a peripheral edge portion thereof and subjecting the polymeric substance-forming material layer to a curing treatment, thereby forming a primary composite body with an insulating sheet base composed of the elastic polymeric substance and formed so as to close the opening in the frame plate supported by an opening edge of the frame plate,
the second step of irradiating the insulating sheet base with a laser beam through a plurality of through-holes for beam transmission in a mask for exposure, in which the through-holes for beam transmission, the diameter of each of which becomes gradually great from one surface toward the other surface of the mask, and each of which extends in a thickness-wise direction of the mask, have been formed in accordance with a pattern corresponding to a pattern of conductive path elements to be formed, from the side of the one surface of the mask for exposure, thereby forming a secondary composite body with an insulating sheet body, in which a plurality of through-holes for forming conductive paths, each extending in a thickness-wise direction of the sheet body, have been formed, and which has been formed so as to close the opening in the frame plate, supported by the opening edge of the frame plate, and
the third step of charging a conductive path element-forming material with conductive particles dispersed in a polymeric substance-forming material, which will become an elastic polymeric substance by being cured, into each of the through-holes for forming conductive paths in the secondary composite body, thereby forming conductive path element-forming material layers, and subjecting the conductive path element-forming material layers to a curing treatment, thereby forming an anisotropically conductive sheet with conductive path elements integrally provided in the through-holes for forming conductive path elements of the insulating sheet body.

The process provided by the present invention for producing an anisotropically conductive connector is a process comprising:
the first step of providing a frame plate, in which a plurality of openings each extending in a thickness-wise direction of the frame plate have been formed correspondingly to regions, in which electrodes to be inspected in all of integrated circuits formed on a wafer, which is an object of inspection, have been arranged, or regions, in which electrodes to be inspected in a plurality of integrated circuits selected from among the integrated circuits formed on the wafer have been arranged,
forming a layer of a polymeric substance-forming material, which will become an elastic polymeric substance by being cured, in each of the openings of the frame plate and at a peripheral edge portion thereof and subjecting the polymeric substance-forming material layer to a curing treatment, thereby forming a primary composite body with a plurality of insulating sheet bases each composed of the elastic polymeric substance and formed so as to close the openings in the frame plate supported by their corresponding opening edges of the frame plate,
the second step of irradiating the insulating sheet bases with a laser beam through a plurality of through-holes for beam transmission in a mask for exposure, in which the through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed, from the side of the other surface of the mask for exposure, thereby forming a secondary composite body with a plurality of insulating sheet bodies, in which a plurality of through-holes for forming conductive paths, each extending in a thickness-wise direction of each of the sheet bodies, have been formed, supported by their corresponding opening edges of the frame plate, and
the third step of charging a conductive path element-forming material with conductive particles dispersed in a polymeric substance-forming material, which will become an elastic polymeric substance by being cured, into each of the through-holes for forming conductive paths in the secondary composite body, thereby forming conductive path element-forming material layers, and subjecting the conductive path element-forming material layers to a curing treatment, thereby forming anisotropically conductive sheets with conductive path elements integrally provided in the through-holes for forming conductive path elements of each of the insulating sheet bodies.

In the processes according to the present invention for producing the anisotropically conductive connector, it may be preferable that particles exhibiting magnetism be used as the conductive particles in the conductive path element-forming material, and
a magnetic field be applied to the conductive path element-forming material layers formed in the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers be subjected to the curing treatment in this state, thereby forming the anisotropically conductive sheet with the conductive path elements integrally provided in the through-holes for forming conductive path elements of the insulating sheet body.

In the processes according to the present invention for producing the anisotropically conductive connector, it may also be preferable that the polymeric substance-forming material be applied on to one surface of a flat plate-like supporting plate, the frame plate be arranged in such a manner that the other surface of the frame plate is separated from and opposed to the one surface of the supporting plate, the mask for exposure be arranged in such a manner that one surface of the mask is separated from and opposed to one surface of the frame plate, these be superimposed on one another to pressurize them, thereby forming polymeric substance-forming material layers of the intended form in forming spaces including internal spaces of the openings of the frame plate, spaces between the frame plate and the mask for exposure and internal spaces of the through-holes for beam transmission in the mask for exposure, and the polymeric substance-forming material layers be subjected to the curing treatment, thereby forming a primary composite body, in which a plurality of insulating sheet bases each having projected part-forming portions are arranged so as to close the openings in the frame plate, and peripheral edge portions of the insulating sheet bases are supported by their corresponding opening edges of the frame plate,
the insulating sheet bases be irradiated with the laser beam through the through-holes for beam transmission in the mask for exposure from the other surface side of the mask for exposure, thereby forming a secondary composite body with a plurality of insulating sheet bodies, in which through-holes for forming conductive paths, each extending in a thickness-wise direction of the sheet body, have been formed in the projected part-forming portions, supported by their corresponding opening edges of the frame plate, and
the conductive path element-forming material with the conductive particles dispersed in the polymeric substance-forming material, which will become the elastic polymeric substance by being cured, be charged into the through-holes for forming conductive paths of the respective projected part-forming portions in the secondary composite body, thereby forming conductive path element-forming material layers, and the conductive path element-forming material layers be subjected to the curing treatment, thereby forming anisotropically conductive sheets with conductive path elements each having a one surface-side projected part protruding from the one surface of the insulating sheet body integrally provided in the through-holes for forming conductive path elements in each of the insulating sheet bodies. In this case, it may be preferable to use, as the supporting plate, one composed of the same material as used in the frame plate.

The process provided by the present invention for producing an anisotropically conductive connector is a process for producing an anisotropically conductive connector equipped with a frame plate having an opening and an anisotropically conductive sheet arranged so as to close the opening in the frame plate and supported by an opening edge of the frame plate, in the anisotropically conductive sheet of which a plurality of conductive path elements each extending in a thickness-wise direction of the sheet are formed in a state protruding from at least one surface of an insulating sheet base composed of an elastic polymeric substance, the process comprising:
the steps of providing the frame plate, in which the opening has been formed, forming a layer of a polymeric substance-forming material, which will become the elastic polymeric substance by being cured, in the opening of the frame plate and at an opening edge portion thereof, and subjecting the polymeric substance-forming material layer to a curing treatment, thereby forming an insulating sheet base composed of the elastic polymeric substance in the opening of the frame plate and at the opening edge portion thereof to prepare a laminate with a resin layer for forming projected parts formed on at least one surface of the insulating sheet base,
the steps of arranging a mask for exposure, in which a plurality of through-holes for beam transmission, the diameter of each of which becomes gradually small from one surface toward the other surface of the mask, have been formed in accordance with a pattern corresponding to a pattern of conductive path elements to be formed, on one surface of the laminate in such a manner that the one surface of the mask for exposure comes into contact with the one surface of the laminate, and irradiating the insulating sheet base with a laser beam through the through-holes for beam transmission in the mask for exposure from the other surface side of the mask for exposure to form a plurality of through-holes for forming conductive paths, each extending in a thickness-wise direction of the insulating sheet base, in the insulating sheet base of the laminate, and at the same time form a plurality of through-holes for forming projected parts, each extending continuously with its corresponding through-hole for forming a conductive path in the thickness-wise direction, in the resin layer for forming projected parts of the laminate, thereby forming a primary composite body with the resin layer for forming projected parts formed on at least one surface of an insulating sheet body provided in the opening of the frame plate and at the opening edge portion thereof,
the steps of charging a conductive path element-forming material with conductive particles dispersed in a polymeric substance-forming material, which will become an elastic polymeric substance by being cured, into spaces for forming conductive path elements, including internal spaces of the through-holes for forming conductive paths in the insulating sheet body and internal spaces of the through-holes for forming projected parts in the resin layer for forming projected parts, thereby forming conductive path element-forming material layers in the respective spaces for forming conductive paths, and subjecting the conductive path element-forming material layers to a curing treatment to form conductive path elements, thereby forming a secondary composite body with a plurality of the conductive path elements integrally provided in the spaces for forming conductive path elements in the primary composite body, and
the step of dissolving the resin layer for forming projected parts of the secondary composite body to remove it, thereby forming projected parts protruding from at least one surface of the insulating sheet body on the respective conductive path elements.

The process provided by the present invention for producing an anisotropically conductive connector is a process comprising:
the steps of providing a frame plate, in which a plurality of openings each extending in a thickness-wise direction of the frame plate have been formed correspondingly to regions, in which electrodes to be inspected in all of integrated circuits formed on a wafer, which is an object of inspection, have been arranged, or regions, in which electrodes to be inspected in a plurality of integrated circuits selected from among the integrated circuits formed on the wafer have been arranged,
forming a layer of a polymeric substance-forming material, which will become an elastic polymeric substance by being cured, in each of the openings of the frame plate and at an opening edge portion thereof and subjecting the polymeric substance-forming material layer to a curing treatment, thereby preparing a laminate, in which insulating sheet bases composed of the elastic polymeric substance and formed so as to close the respective openings in the frame plate are supported by their corresponding opening edges of the frame plate, and a resin layer for forming projected parts is formed on at least one surface of the insulating sheet base,
the steps of arranging a mask for exposure, in which a plurality of through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed, on one surface of the laminate in such a manner that the one surface of the mask for exposure comes into contact with the one surface of the laminate, and irradiating the insulating sheet bases with a laser beam through the through-holes for beam transmission in the mask for exposure from the other surface side of the mask for exposure to form a plurality of through-holes for forming conductive paths, each extending in a thickness-wise direction of the insulating sheet base, in the insulating sheet bases of the laminate, and at the same time form a plurality of through-holes for forming projected parts, each extending continuously with its corresponding through-hole for forming a conductive path in the thickness-wise direction, in the resin layer for forming projected parts of the laminate, thereby forming a primary composite body with the resin layer for forming projected parts formed on at least one surface of each of insulating sheet bodies provided in the opening of the frame plate and at the opening edge portion thereof,
the steps of charging a conductive path element-forming material with conductive particles dispersed in a polymeric substance-forming material, which will become an elastic polymeric substance by being cured, into spaces for forming conductive path elements, including internal spaces of the through-holes for forming conductive paths in the insulating sheet bodies and internal spaces of the through-holes for forming projected parts in the resin layer for forming projected parts, thereby forming conductive path element-forming material layers in the respective spaces for forming conductive paths, and subjecting the conductive path element-forming material layers to a curing treatment to form conductive path elements, thereby forming a secondary composite body with a plurality of the conductive path elements integrally provided in the spaces for forming conductive path elements in the primary composite body, and
the step of dissolving the resin layer for forming projected parts of the secondary composite body to remove it, thereby forming projected parts protruding from at least one surface of each of the insulating sheet bodies on the respective conductive path elements.

In the processes according to the present invention for producing the anisotropically conductive connector, it may be preferable that silicone rubber be used as the elastic polymeric substance forming the insulating sheet body, and polyvinyl alcohol be used as a resin layer-forming material forming the resin layer for forming projected parts. In this case, it may be preferable to use that having an average polymerization degree of 100 to 5,000 as the polyvinyl alcohol.
It may also be preferable to form the resin layer for forming projected parts in a thickness of 5 to 100 µm.

In the processes according to the present invention for producing the anisotropically conductive sheet, it may further be preferable that particles exhibiting magnetism be used as the conductive particles in the conductive path element-forming material,
a magnetic field be applied to the conductive path element-forming material layers formed in the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers be subjected to the curing treatment in this state, thereby forming the conductive path elements integrally provided in the through-holes for forming conductive path elements of the insulating sheet body.

In the processes according to the present invention for producing the anisotropically conductive connector, it may also be preferable that a laminate material be prepared by forming a resin layer for forming projected parts on one surface of a flat plate-like supporting plate, the polymeric substance-forming material be applied on to either or both of one surface of the laminate material and one surface of the mask for exposure to form a polymeric substance-forming material layer, the frame plate be arranged in such a manner that the other surface of the frame plate is separated from and opposed to the one surface of the laminate material, the mask for exposure be arranged in such a manner that the one surface of the mask is separated from and opposed to one surface of the frame plate, these be superimposed on one another to pressurize them, thereby forming polymeric substance-forming material layers of the intended form in forming spaces including internal spaces of the openings of the frame plate, spaces between the frame plate and the mask for exposure and internal spaces of the through-holes for beam transmission in the mask for exposure, and the polymeric substance-forming material layers be subjected to the curing treatment, thereby forming insulating sheet bases,
the insulating sheet bases be irradiated with the laser beam through the through-holes for beam transmission in the mask for exposure from the other surface side of the mask for exposure to form a plurality of through-holes for forming conductive paths, each extending in the thickness-wise direction, in each of the insulating sheet bases, and at the same time form a plurality of through-holes for forming projected parts, each extending continuously with its corresponding through-hole for forming a conductive path in the thickness-wise direction, in each of the resin layers for forming projected parts, thereby forming a primary composite body with the resin layer for forming projected parts provided on the other surface of an insulating sheet body provided in each of the openings in the frame plate and at an opening edge portion thereof,
the conductive path element-forming material be charged into spaces for forming conductive path elements, including internal spaces of the through-holes for forming conductive paths in the insulating sheet bodies and internal spaces of the through-holes for forming projected parts in the resin layers for forming projected parts, thereby forming conductive path element-forming material layers, and the conductive path element-forming material layers be subjected to the curing treatment to form conductive path elements, and
the mask for exposure be removed to expose one end portions of the conductive path elements, thereby forming one surface-side projected parts each having a shape that its diameter becomes gradually small from the proximal end toward the distal end thereof, and the resin layers for forming projected parts be dissolved and removed, thereby forming the other surface-side projected parts protruding from the other surface of each of the insulating sheet bodies. In this case, it may be preferable to use, as the supporting plate, one composed of the same material as used in the frame plate.

In the processes according to the present invention for producing the anisotropically conductive connector, it may further be preferable that the laser beam be emitted by means of a carbon dioxide gas laser.
It may still further be preferable that a mask having a thickness of 5 to 100 µm be used as the mask for exposure, a mask having an opening diameter ratio r2/r1 of an opening diameter r2 in the other surface of the mask to an opening diameter r1 in one surface of the mask of from 0.2 to 0.98, preferably from 0.2 to 0.95, more preferably from 0.3 to 0.9 be used as the mask for exposure, and a mask composed of a metal be used as the mask for exposure.

The probe for circuit inspection provided by the present invention is a probe for circuit inspection, which comprises a circuit board for inspection, on the surface of which inspection electrodes have been formed in accordance with a pattern corresponding to a pattern of electrodes to be inspected of a circuit device, which is an object of inspection, and the above-described anisotropically conductive sheet or the above-described anisotropically conductive connector arranged on the surface of the circuit board for inspection.

The probe for circuit inspection provided by the present invention is a probe for circuit inspection that is suitable for use in conducting electrical inspection of each of a plurality of integrated circuits formed on a wafer in a state of the wafer, which comprises:
a circuit board for inspection, on the surface of which inspection electrodes have been formed in accordance with a pattern corresponding to a pattern of electrodes to be inspected in all of the integrated circuits formed on the wafer, which is an object of inspection, and the above-described anisotropically conductive connector arranged on the surface of the circuit board for inspection.

The probe for circuit inspection provided by the present invention is a probe for circuit inspection that is suitable for use in conducting electrical inspection of each of a plurality of integrated circuits formed on a wafer in a state of the wafer, which comprises:
a circuit board for inspection, on the surface of which inspection electrodes have been formed in accordance with a pattern corresponding to a pattern of electrodes to be inspected in a plurality of integrated circuits selected from among the integrated circuits formed on the wafer, which is an object of inspection, and the above-described anisotropically conductive connector arranged on the surface of the circuit board for inspection.

In the probes for circuit inspection according to the present invention, it may be preferable that a sheet-like connector composed of an insulating sheet and a plurality of electrode structures each extending through in a thickness-wise direction of the insulating sheet and arranged in accordance with a pattern corresponding to the pattern of the inspection electrodes in the circuit board for inspection be arranged on the anisotropically conductive connector.

The electrical inspection apparatus for circuit devices provided by the present invention is an electrical inspection apparatus for circuit devices comprising the probe for circuit inspection.

According to the anisotropically conductive sheet of the present invention, the through-holes for forming conductive paths in the insulating sheet body are each formed by using the mask for exposure in accordance with the specific method, whereby adjacent conductive path elements can be surely prevented from joining with each other even when the arrangement pitch of conductive path elements to be formed is small, the individual conductive path elements can be formed independently of one another, and the expected electrical connection can be surely achieved even to an object to be connected, the arrangement pitch of electrodes to be connected of which is extremely small.

According to the processes of the present invention for producing the anisotropically conductive sheet, the mask for exposure, in which a plurality of the through-holes for beam transmission each having the shape that the diameter becomes gradually small from one surface toward the other surface of the mask have been formed is arranged on one surface of the insulating sheet base in such a manner that the one surface of the mask for exposure comes into contact with the one surface of the insulating sheet base, and the insulating sheet base is irradiated with a laser beam through a plurality of the through-holes for beam transmission from the other surface side of the mask for exposure to form an insulating sheet body in which a plurality of through-holes for forming conductive paths, each extending in a thickness-wise direction of the sheet body, have been formed, whereby the laser beam is restricted by the opening edge of each of the through-holes for beam transmission on the side of the other surface of the mask for exposure to strike perpendicularly on the one surface of the insulating sheet base, so that the through-holes for forming conductive paths can be formed at the necessary positions so as to extend linearly in the thickness-wise direction of the insulating sheet body. As a result, a plurality of the conductive path elements, the mutual insulating property of which is sufficiently retained, can be formed at an extremely small pitch without making the width of the conductive path element itself small. Accordingly, an anisotropically conductive sheet that can surely achieve the expected electrical connection even to an object to be connected, the arrangement pitch of electrodes to be connected of which is extremely small can be surely obtained.
In addition, since it is only necessary to conduct the simple process that the mask for exposure is arranged in such a manner that one surface thereof comes into contact with one surface of the insulating sheet base, the expected anisotropically conductive
sheet can be advantageously produced.

According to the processes of the present invention for producing the anisotropically conductive sheet, the projected part of each of the conductive path elements is formed by forming a projected part-forming portion in the through-hole for forming a projected part of the resin layer for forming projected parts and dissolving and removing the resin layer for forming projected parts, whereby the projected parts having the expected conductive property can be surely formed on all conductive path elements even when the arrangement pitch of the conductive path elements is extremely small. Accordingly, there can be surely obtained an anisotropically conductive sheet, by which the expected electrical connection can be surely achieved with high reliability even to an object to be connected, the arrangement pitch of electrodes to be connected of which is extremely small.

According to the anisotropically conductive connector of the present invention, it has the anisotropically conductive sheet described above, so that the expected electrical connection can be surely achieved even to an object to be connected, the arrangement pitch of electrodes to be connected of which is extremely small.

According to the processes of the present invention for producing the anisotropically conductive connector, there can be surely and advantageously produced an anisotropically conductive connector, by which the expected electrical connection can be surely achieved even to an object to be connected, the arrangement pitch of electrodes to be connected of which is extremely small.
In addition, an anisotropically conductive sheet, in which a plurality of the conductive path elements each having the projected part having the expected conductive property have been formed at an extremely arrangement pitch in a state mutual insulating property has been sufficiently retained, can be surely formed in each of openings of the frame and at an opening edge portion thereof. Accordingly, there can be surely obtained an anisotropically conductive connector, by which the expected electrical connection can be surely achieved with high reliability even to an object to be connected, the arrangement pitch of electrodes to be connected of which is extremely small.

According to the proves for circuit inspection and inspection apparatus for circuit devices of the present invention, the anisotropically conductive connector coming into contact with an object to be connected in the proves for circuit inspection is equipped with the anisotropically conductive sheets integrally provided with the conductive path elements in the through-holes for forming conductive paths of the insulating sheet bodies, said through-holes having been formed by using the mask for exposure in accordance with the specific method, and the anisotropically conductive sheets are so formed that adjacent conductive path elements are surely prevented from joining with each other even when the arrangement pitch of the conductive path elements is small, and the individual conductive path elements are independent of one another, so that the expected electrical connection can be surely achieved even when the pitch of electrodes to be inspected in a circuit device, which is an object of inspection, is small.

### BRIEF DESCRIPTION OF THE DRAWINGS

[Fig. 1] is a cross-sectional view schematically illustrating the construction of an exemplary anisotropically conductive sheet according to the present invention.
[Fig. 2] is a cross-sectional view schematically illustrating the construction of an exemplary mask for exposure used upon production of the anisotropically conductive sheet according to the present invention.
[Fig. 3] is a cross-sectional view illustrating a state that the mask for exposure has been arranged on one surface of an insulating sheet base.
[Fig. 4] is a cross-sectional view illustrating the construction of an insulating sheet body obtained by forming through-holes for forming conductive paths in the insulating sheet base.
[Fig. 5] is a cross-sectional view illustrating a state that conductive path element-forming material layers have been formed in the respective interiors of the through-holes for forming conductive paths in the insulating sheet body.
[Fig. 6] is a cross-sectional view illustrating a state that a conductive path element-forming material is applied on to the surface of the insulating sheet body under a reduced pressure atmosphere in an example of means for forming the conductive path element-forming material layers.
[Fig. 7] is a cross-sectional view illustrating a state that a conductive path element-forming material has been charged into spaces for forming conductive path elements of the insulating sheet body by controlling to an atmospheric pressure atmosphere in an example of means for forming the conductive path element-forming material layers.
[Fig. 8] is a cross-sectional view illustrating a state that a parallel magnetic field has been applied to the conductive path element-forming material layers.
[Fig. 9] is a cross-sectional view schematically illustrating the construction of another exemplary anisotropically conductive sheet according to the present invention.
[Fig. 10] is a cross-sectional view illustrating a state that conductive path element-forming material layers have been formed in the respective interiors of the through-holes for forming conductive paths in an insulating sheet body and the respective interiors of through-holes for beam transmission in a mask for exposure.
[Fig. 11] is a cross-sectional view illustrating a state that a parallel magnetic field has been applied to the conductive path element-forming material layers.
[Fig. 12] is a cross-sectional view schematically illustrating the construction of a further exemplary anisotropically conductive sheet according to the present invention.
[Fig. 13] is a cross-sectional view illustrating a state that a mask for exposure has been arranged on one surface of an insulating sheet base in a laminate. [Fig. 14] is a cross-sectional view illustrating a
state that through-holes for forming conductive paths have been formed in the insulating sheet base, and a resin layer for forming projected parts have been formed in a resin layer for forming projected parts.
[Fig. 15] is a cross-sectional view illustrating a state that conductive path element-forming material layers have been formed in respective spaces for forming conductive path elements.
[Fig. 16] is a cross-sectional view illustrating a state that a parallel magnetic field has been applied to the conductive path element-forming material layers.
[Fig. 17] is a cross-sectional view illustrating a state that the whole of a secondary composite body, in which one surface-side projected parts were formed, has been immersed in a solvent.
[Fig. 18] is a plan view schematically illustrating the construction of an exemplary anisotropically conductive connector according to the present invention.
[Fig. 19] is a cross-sectional view illustrating, on an enlarged scale, a principal part of the anisotropically conductive connector shown in Fig. 18.
[Fig. 20] is a cross-sectional view illustrating a state that a supporting plate, on which polymeric substance-forming material layers were formed, a lower surface-side spacer, a frame plate, an upper surface-side spacer and a mask for exposure have been arranged in alignment between a lower surface-side pressurizing plate and an upper surface-side pressurizing plate.
[Fig. 21] is a cross-sectional view illustrating a state that polymeric substance-forming material layers of the intended form have been formed in spaces for forming an anisotropically conductive sheet, including internal spaces of openings of the frame plate, internal spaces of respective openings of the lower surface-side spacer and upper surface-side spacer, and internal spaces of through-holes for beam transmission in the mask for exposure.
[Fig. 22] is a cross-sectional view illustrating the construction of a primary composite body obtained by subjecting the polymeric substance-forming material layers to a curing treatment.
[Fig. 23] is a cross-sectional view illustrating the construction of a secondary composite body obtained by forming respective through-holes for forming conductive path elements in insulating sheet bases of the primary composite body.
[Fig. 24] is a cross-sectional view illustrating a state that conductive path element-forming material layers have been formed in the respective through-holes for forming conductive paths in the secondary composite body.
[Fig. 25] is a cross-sectional view illustrating a state that a parallel magnetic field has been applied to the conductive path element-forming material layers.
[Fig. 26] is a cross-sectional view illustrating, on an enlarged scale, the construction of a principal part of another exemplary anisotropically conductive connector according to the present invention.
[Fig. 27] is a cross-sectional view illustrating a state that a laminate material, on which a polymeric substance-forming material layer was formed, a lower surface-side spacer, a frame plate, an upper surface-side spacer, a mask for exposure and a releasing film have been arranged in alignment between a lower surface-side pressurizing plate and an upper surface-side pressurizing plate.
[Fig. 28] is a cross-sectional view illustrating a state that a polymeric substance-forming material layer of the intended form has been formed in a space for forming an anisotropically conductive sheet, including an internal space of an opening of the frame plate, internal spaces of respective openings of the lower surface-side spacer and upper surface-side spacer, and internal spaces of through-holes for beam transmission in the mask for exposure.
[Fig. 29] is a cross-sectional view illustrating a state that an insulating sheet base supported by the opening of the frame plate and an opening edge thereof has been formed by subjecting the polymeric substance-forming material layer to a curing treatment.
[Fig. 30] is a cross-sectional view illustrating the construction of a secondary composite body obtained by forming respective through-holes for forming conductive path elements in the insulating sheet base of a primary composite body.
[Fig. 31] is a cross-sectional view illustrating a state that conductive path element-forming material layers have been formed in the respective through-holes for forming conductive paths in the secondary composite body.
[Fig. 32] is a cross-sectional view illustrating a state that a parallel magnetic field has been applied to the conductive path element-forming material layers.
[Fig. 33] is a cross-sectional view illustrating a state that the whole of a secondary composite body, in which one surface-side projected parts were formed, has been immersed in a solvent.
[Fig. 34] is a cross-sectional view illustrating the construction of a principal part of an exemplary wafer inspection apparatus according to the present invention.
[Fig. 35] is a cross-sectional view illustrating, on an enlarged scale, a principal part of an exemplary probe for circuit inspection according to the present invention.
[Fig. 36] is a cross-sectional view illustrating, on an enlarged scale, a principal part of another exemplary probe for circuit inspection according to the present invention.
[Fig. 37] is a cross-sectional view illustrating the construction of a principal part of another exemplary wafer inspection apparatus according to the present invention.
[Fig. 38] is a cross-sectional view illustrating, on an enlarged scale, a principal part of a further exemplary probe for circuit inspection according to the present invention.
[Fig. 39] is a cross-sectional view illustrating the construction of a principal part of a further exemplary wafer inspection apparatus according to the present invention.
[Fig. 40] is a plan view illustrating the construction of a wafer for evaluation fabricated in Example.
[Fig. 41] illustrates a position of a region of electrodes to be inspected of an integrated circuit formed on the wafer for evaluation.
[Fig. 42] illustrates the electrodes to be inspected of the integrated circuit formed on the wafer for evaluation.
[Fig. 43] is a plan view illustrating the construction of a frame plate produced in Example. [Fig. 44] illustrates, on an enlarged scale, a part of the frame plate shown in Fig. 43.
[Fig. 45] is a cross-sectional view illustrating a state that a sheet-molding material layer has been formed in a mold in a process for producing a conventional anisotropically conductive sheet.
[Fig. 46] is a cross-sectional view illustrating a state that conductive particles in the sheet-molding material layer have been gathered at portions, which will become conductive path-forming parts, in the sheet-molding material layer.
[Fig. 47] is a cross-sectional view schematically illustrating the construction of an exemplary uneven distribution type anisotropically conductive sheet.
[Fig. 48] is a cross-sectional view illustrating a state that a sheet-molding material layer has been formed in a mold in a process for producing another conventional anisotropically conductive sheet.
[Fig. 49] is a cross-sectional view illustrating a state that conductive particles in the sheet-molding material layer have been gathered at portions, which will become conductive path-forming parts, in the sheet-molding material layer.
[Fig. 50] is a cross-sectional view schematically illustrating the construction of another exemplary uneven distribution type anisotropically conductive sheet.
[Fig. 51] is a cross-sectional view illustrating a state that an insulating sheet base has been irradiated with a laser beam through a plurality of through-holes for beam transmission in a mask for exposure arranged on one surface of the insulating sheet base in a conventional process for producing an anisotropically conductive sheet, thereby forming through-holes for forming conductive path elements.
[Fig. 52] is a cross-sectional view illustrating a state that in the case where the thickness of an insulating sheet base used has been great, the insulating sheet base has been irradiated with a laser beam through a plurality of the through-holes for beam transmission in the mask for exposure arranged on one surface of the insulating sheet base in the conventional process for producing an anisotropically conductive sheet, thereby forming through-holes for forming conductive path elements.

### DESCRIPTION OF CHARACTERS

- 10: Anisotropically conductive sheet
- 10A: Primary composite body
- 10B: Secondary composite body
- 11: Conductive path element
- 11A: Conductive path element-forming material
- 12A: One surface-side projected part
- 12B: The other surface-side projected part
- 13: Projected part-forming portion
- 15: Insulating sheet body
- 16: Insulating sheet base
- 16A: Polymeric substance-forming material layer
- 16B: Polymeric substance-forming material layer
- 17: Through-hole for forming conductive path
- 18: Resin layer for forming projected part
- 18A: Through-hole for forming projected part
- 19: Laminate
- 20: Mask for exposure
- 20A: One surface
- 20B: The other surface
- 21: Through-holes for beam transmission
- 23: Chamber
- 24: Mask for printing
- 25, 26: Electromagnets
- 30: Anisotropically conductive connector
- 30A: Primary composite body
- 30B: Secondary composite body
- 30C: Laminate
- 31: Frame plate
- 31A: Opening
- 31B: Air inflow hole
- 32: Supporting plate
- 32A: Laminate material
- 33: Upper surface-side spacer
- 33A: Opening
- 34: Lower surface-side spacer
- 34A: Opening
- 35: Upper surface-side pressurizing plate
- 36: Lower surface-side pressurizing plate
- 37: Releasing film
- S: Solvent
- 40: Probe for circuit inspection
- 50: Circuit board for inspection
- 51: Inspection electrode
- 52: Connection terminal
- 53: Internal wiring
- 60: Wafer
- 62: Electrode to be inspected
- 65: Wafer mounting table
- 70: Sheet-like connector
- 71: Insulating sheet
- 72: Electrode structure
- 73: Front-surface electrode part
- 74: Back-surface electrode part
- 75: Short circuit part
- L: Integrated circuit
- A: Region of electrodes to be inspected
- 80: Top force
- 85: Bottom force
- 81, 86: Base Plates
- 82, 87: Ferromagnetic substance layers
- 82A, 87A: Recesses
- 83, 88: Non-magnetic substance layers
- 84: Spacer
- 90: Sheet-molding material layer
- 91: Conductive path-forming part
- 92: Insulating part
- 93: Uneven distribution type anisotropically conductive elastomer sheet
- P: Conductive particle
- 95: Mask for exposure
- 95A: One surface
- 95B: The other surface
- 96: Through-hole for beam transmission
- 96A: Inner wall surface
- 97: Insulating sheet base
- 97A: One surface
- 97B: The other surface
- 98: Through-hole for forming conductive path
- 98A: Maximum portion

### BEST MODE FOR CARRYING OUT THE INVENTION

The embodiments of the present invention will hereinafter be described in details.

### [Anisotropically conductive sheet]

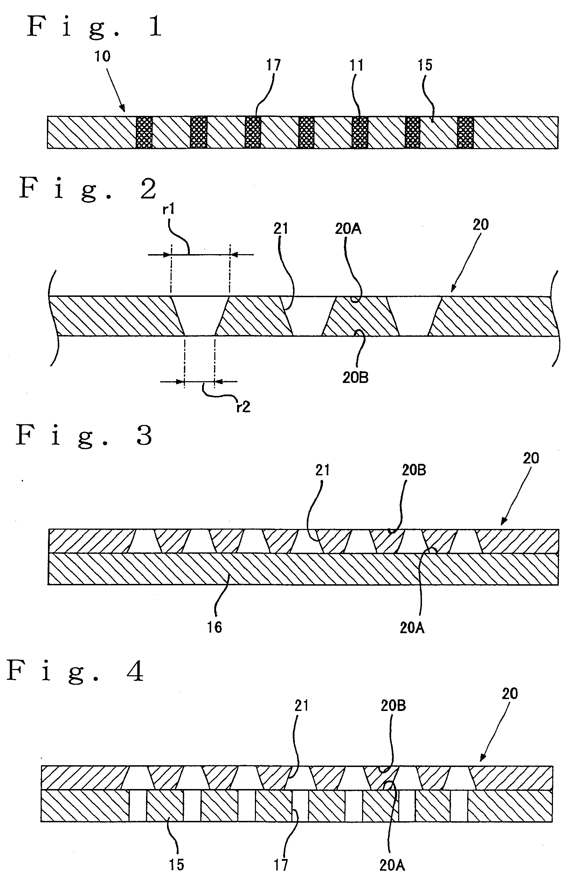

Fig. 1 is a cross-sectional view schematically illustrating the construction of an exemplary anisotropically conductive sheet according to the present invention.
This anisotropically conductive sheet 10 is constructed by an insulating sheet body 15 composed of an elastic polymeric substance, in which a plurality of through-holes 17 for forming conductive paths, each extending in a thickness-wise direction of the sheet base, have been formed in accordance with a pattern corresponding to a pattern of electrodes to be inspected of an object of connection, for example, a circuit device to be inspected, and conductive path elements 11 integrally provided in the respective through-holes 17 for forming conductive paths in the insulating sheet body 15.

As the elastic polymeric substance forming the insulating sheet body 15, is preferred a heat-resistant polymeric substance having a crosslinked structure. Various materials may be used as curable polymeric substance-forming materials usable for obtaining such crosslinked polymeric substances. Specific examples thereof include silicone rubber; conjugated diene rubbers such as polybutadiene rubber, natural rubber, polyisoprene rubber, styrenebutadiene copolymer rubber and acrylonitrilebutadiene copolymer rubber, and hydrogenated products thereof; block copolymer rubbers such as styrenebutadiene-diene block copolymer rubber and styreneisoprene block copolymers, and hydrogenated products thereof; and chloroprene, urethane rubber, polyester rubber, epichlorohydrin rubber, ethylene-propylene copolymer rubber, ethylene-propylene-diene copolymer rubber and soft liquid epoxy rubber. Among these, silicone rubber is preferred from the viewpoints of molding and processing ability and electrical properties.

As the silicone rubber, is preferred that obtained by crosslinking or condensing liquid silicone rubber. The liquid silicone rubber may be any of condensation type, addition type and those containing a vinyl group or hydroxyl group. As specific examples thereof, may be mentioned dimethyl silicone raw rubber, methylvinyl silicone raw rubber and methylphenylvinyl silicone raw rubber.

Among these, vinyl group-containing liquid silicone rubber (vinyl group-containing dimethyl polysiloxane) is generally obtained by subjecting dimethyldichlorosilane or dimethyldialkoxysilane to hydrolysis and condensation reactions in the presence of dimethylvinylchlorosilane or dimethylvinylalkoxysilane and successively fractionating the reaction product by, for example, repeated dissolution-precipitation.
Liquid silicone rubber having vinyl groups at both terminals thereof is obtained by subjecting a cyclic siloxane such as octamethylcyclotetrasiloxane to anionic polymerization in the presence of a catalyst, using, for example, dimethyldivinylsiloxane as a polymerization terminator and suitably selecting other reaction conditions (for example, amounts of the cyclic siloxane and polymerization terminator). As the catalyst for the anionic polymerization in this process, may be used an alkali such as tetramethylammonium hydroxide or n-butylphosphonium hydroxide or a silanolate solution thereof. The reaction is conducted at a temperature of, for example, 80 to 130°C.
Such a vinyl group-containing dimethyl polysiloxane preferably has a molecular weight Mw (weight average molecular weight as determined in terms of standard polystyrene; the same shall apply hereinafter) of 10,000 to 40,000. It also preferably has a molecular weight distribution index (a ratio Mw/Mn of weight average molecular weight Mw as determined in terms of standard polystyrene to number average molecular weight Mn as determined in terms of standard polystyrene; the same shall apply hereinafter) of at most 2 from the viewpoint of the heat resistance of the resulting anisotropically conductive sheet 10.

On the other hand, hydroxyl group-containing liquid silicone rubber (hydroxyl group-containing dimethyl polysiloxane) is generally obtained by subjecting dimethyldichlorosilane or dimethyldialkoxysilane to hydrolysis and condensation reactions in the presence of dimethylhydrochlorosilane or dimethylhydroalkoxysilane and successively fractionating the reaction product by, for example, repeated dissolution-precipitation.
The hydroxyl group-containing liquid silicone rubber is also obtained by subjecting a cyclic silane to anionic polymerization in the presence of a catalyst, using, for example, dimethylhydrochlorosiloxane, methyldihydrochlorosilane or dimethylhydroalkoxysilane as a polymerization terminator and suitably selecting other reaction conditions (for example, amounts of the cyclic siloxane and polymerization terminator). As the catalyst for the anionic polymerization in this process, may be used an alkali such as tetramethylammonium hydroxide or n-butylphosphonium hydroxide or a silanolate solution thereof. The reaction is conducted at a temperature of, for example, 80 to 130°C.

Such a hydroxyl group-containing dimethyl polysiloxane preferably has a molecular weight Mw of 10,000 to 40,000. It also preferably has a molecular weight distribution index of at most 2 from the viewpoint of the heat resistance of the resulting anisotropically conductive sheet 10.
In the present invention, any one of the above-described vinyl group-containing dimethyl polysiloxane and hydroxyl group-containing dimethyl polysiloxane may be used, or both may also be used in combination.

When the anisotropically conductive sheet is used in a probe test or burn-in test as to integrated circuits formed on a wafer, a substance, which is a cured product (hereinafter referred to as "cured silicone rubber") of an addition type liquid silicone rubber, and has a compression set of at most 10%, more preferably at most 8%, still more preferably at most 6% at 150°C, is preferably used as the elastic polymeric substance. If the compression set exceeds 10%, the conductive path elements 11 tend to cause permanent set when the resulting anisotropically conductive sheet is used repeatedly many a time or used repeatedly under a high-temperature environment, whereby a chain of the conductive particles in each of the conductive path elements 11 is disordered. As a result, it may be difficult in some cases to retain necessary conductive property.
In the present invention, the compression set of the cured silicone rubber can be measured by a method in accordance with JIS K 6249.

As the cured silicone rubber, is preferably used that having a durometer A hardness of 10 to 60, more preferably 15 to 60, particularly preferably 20 to 60 at 23°C. If the durometer A hardness is lower than 10, the resulting insulating sheet body 15 is easily over-distorted when pressurized, and it may thus be difficult in some cases to retain necessary insulating property between the conductive path elements 11. If the durometer A hardness exceeds 60 on the other hand, pressurizing force by a considerably heavy load is required for giving proper distortion to the conductive path elements 11, so that for example, an object of inspection tends to cause deformation or breakage.
Further, if that having a durometer A hardness outside the above range is used as the cured silicone rubber, the conductive path elements 11 tend to cause permanent set when the resulting anisotropically conductive sheet is used repeatedly many a time, whereby a chain of the conductive particles in each of the conductive path elements 11 is disordered. As a result, it may be difficult in some cases to retain the necessary conductive property.
When the anisotropically conductive sheet is used in a burn-in test, the cured silicone rubber preferably has a durometer A hardness of 25 to 40 at 23°C. If that having a durometer A hardness outside the above range is used as the cured silicone rubber, the conductive path elements 11 tend to cause permanent set when the resulting anisotropically conductive sheet is used repeatedly in the burn-in test, whereby a chain of the conductive particles in each of the conductive path elements 11 is disordered. As a result, it may be difficult in some cases to retain necessary conductive property. In the present invention, the durometer A hardness of the cured silicone rubber can be measured by a method in accordance with JIS K 6249.

Further, as the cured silicone rubber, is preferably used that having tear strength of at least 8 kN/m, more preferably at least 10 kN/m, still more preferably at least 15 kN/m, particularly preferably at least 20 kN/m at 23°C. If the tear strength is lower than 8 kN/m, the resulting anisotropically conductive sheet tends to deteriorate durability when it is distorted in excess.
In the present invention, the tear strength of the cured silicone rubber can be measured by a method in accordance with JIS K 6249.

As the addition type liquid silicone rubber, may be used that cured by a reaction of a vinyl group with an Si-H bond, or any of a one-pack type (one-component type) composed of polysiloxane containing both vinyl group and Si-H bond and a two-pack type (two-component type) composed of polysiloxane containing a vinyl group and polysiloxane containing an Si-H bond. However, addition type liquid silicone rubber of the two-pack type is preferably used.

As the addition type liquid silicone rubber, is preferably used that having a viscosity of 100 to 1,250 Pa·s, more preferably 150 to 800 Pa·s, particularly preferably 250 to 500 Pa·s at 23°C. If this viscosity is lower than 100 Pa·s, precipitation of the conductive particles in such addition type liquid silicone rubber is easy to occur in a conductive path element-forming material 11A for obtaining the conductive path elements 11, which will be described subsequently, so that good storage stability is not achieved. In addition, the conductive particles are not oriented so as to align in the thickness-wise direction of a layer 11B of the conductive path element-forming material when a parallel magnetic field is applied to the conductive path element-forming material layer 11B, so that it may be difficult in some cases to form chains of the conductive particles in an even state. If this viscosity exceeds 1,250 Pa·s on the other hand, the viscosity of the resulting conductive path element-forming material 11A for obtaining the conductive path elements 11, which will be described subsequently, becomes too high, so that it may be difficult in some cases to form the conductive path element-forming material layer 11B in each of the through-holes 17 for forming conductive path elements in the insulating sheet body 15. In addition, the conductive particles are not sufficiently moved even when a parallel magnetic field is applied to the conductive path element-forming material layer 11B. Therefore, it may be difficult in some cases to orient the conductive particles so as to align in the thickness-wise direction.
The viscosity of such addition type liquid silicone rubber can be measured by means of a Brookfield type viscometer.

A curing catalyst for curing the polymeric substance-forming material may be contained in the polymeric substance-forming material. As such a curing catalyst, may be used an organic peroxide, fatty acid azo compound, catalyst for hydrosilylation or the like.
Specific examples of the organic peroxide used as the curing catalyst include benzoyl peroxide, bisdicyclobenzoyl peroxide, dicumyl peroxide and di-tert-butyl peroxide.
Specific examples of the fatty acid azo compound used as the curing catalyst include azobisisobutyronitrile.
Specific examples of that used as the catalyst for hydrosilylation reaction include publicly known catalysts such as platinic chloride and salts thereof, platinum-unsaturated group-containing siloxane complexes, vinylsiloxane-platinum complexes, platinum-1,3-divinyltetramethyldisiloxane complexes, complexes of triorganophosphine or phosphite and platinum, acetyl acetate platinum chelates, and cyclic diene-platinum complexes.
The amount of the curing catalyst used is suitably selected in view of the kind of the polymeric substance-forming material, the kind of the curing catalyst and other curing treatment conditions. However, it is generally 3 to 15 parts by weight per 100 parts by weight of the polymeric substance-forming material.

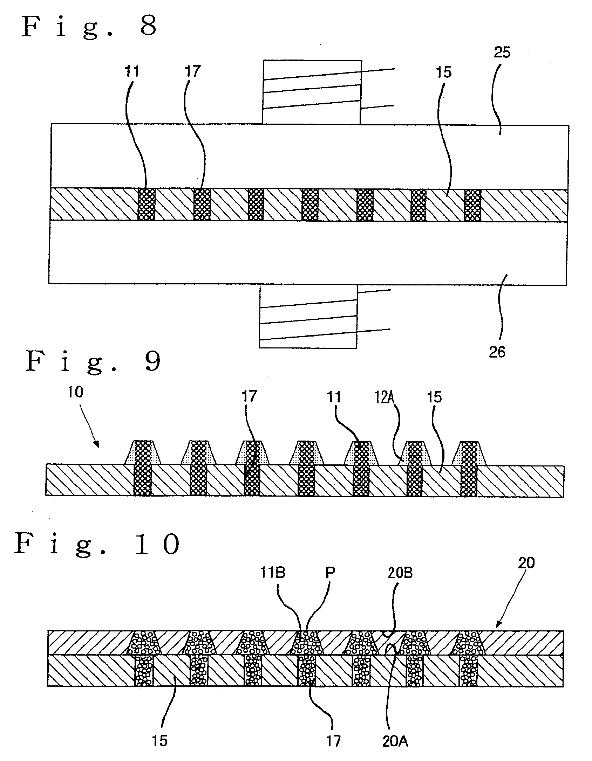

The conductive path element 11 is formed by containing the conductive particles P in the elastic polymeric substance in a state oriented so as to align in the thickness-wise direction, and a conductive path is formed in a thickness-wise direction of the conductive path element 11 by chains of the conductive particles P.
This conductive path element 11 is formed by subjecting a flowable conductive path element-forming material 11A (see Fig. 6) obtained by dispersing the conductive particles P in a polymeric substance-forming material, which will become an elastic polymeric substance by being cured, to a curing treatment.

As the polymeric substance-forming material used for the conductive path element-forming material 11A, may be used the same materials as those exemplified as the curable polymeric substance-forming materials usable for obtaining the elastic polymeric substance forming the insulating sheet body 15.

As the conductive particles P used in the conductive path element-forming material 11A, those exhibiting magnetism are preferably used from the viewpoint of permitting easy movement of the conductive particles P in the conductive path element-forming material 11A by a process, which will be described subsequently. Specific examples of such conductive particles P exhibiting magnetism include particles of metals exhibiting magnetism, such as iron, nickel and cobalt, particles of alloys thereof, particles containing such a metal, particles obtained by using these particles as core particles and plating the core particles with a metal having good conductivity, such as gold, silver, palladium or rhodium, particles obtained by using particles of a non-magnetic metal, inorganic particles such as glass beads or polymer particles as core particles and plating the core particles with a conductive magnetic substance such as nickel or cobalt, and particles obtained by coating core particles with both conductive magnetic substance and metal having good conductivity.
Among these, particles obtained by using nickel particles as core particles and plating their surfaces with a metal having good conductivity, such as gold or silver are preferably used.
No particular limitation is imposed on the means for coating the surfaces of the core particles with the conductive metal. However, the coating may be conducted by, for example, electroless plating.

When particles obtained by coating the surfaces of core particles with a conductive metal are used as the conductive particles P, a coating rate (proportion of coated area with the conductive metal to the surface area of the core particles) of the conductive metal on the surfaces of the particles is preferably at least 40%, more preferably at least 45%, particularly preferably 47 to 95% from the viewpoint of achieving good conductivity.
The coating amount of the conductive metal is preferably 2.5 to 50% by weight, more preferably 3 to 45% by weight, still more preferably 3.5 to 40% by weight, particularly preferably 5 to 30% by weight based on the core particles.

The particle diameter of the conductive particles P is preferably 1 to 500 µm, more preferably 2 to 400 µm, still more preferably 5 to 300 µm, particularly preferably 10 to 150 µm.
The particle diameter distribution (Dw/Dn) of the conductive particles P is preferably 1 to 10, more preferably 1 to 7, still more preferably 1 to 5, particularly preferably 1 to 4.
When conductive particle P satisfying such conditions are used, the resulting anisotropically conductive sheet 10 become easy to deform under pressure, and sufficient electrical contact is achieved among the conductive particles P in the conductive path elements 11 in the anisotropically conductive sheet 10.
No particular limitation is imposed on the form of the conductive particles P. However, they are preferably in the form of a sphere or star, or a mass of secondary particles obtained by aggregating these particles from the viewpoint of permitting easy dispersion of the conductive particles in the polymeric substance-forming material.

The water content in the conductive particles P is preferably at most 5%, more preferably at most 3%, still more preferably at most 2%, particularly preferably at most 1%. The use of conductive particles P satisfying such conditions can surely prevent or inhibit generation of bubbles in the conductive path element-forming material layers 11B when the conductive path element-forming material layers 11B are subjected to a curing treatment in a production process, which will be described subsequently.

Those obtained by treating surfaces of the conductive particles P with a coupling agent such as a silane coupling agent may be suitably used. By treating the surfaces of the conductive particles P with the coupling agent, the adhesion property of the conductive particles P to the elastic polymeric substance is improved. As a result, the resulting anisotropically conductive sheet 10 becomes high in durability upon repeated use.
The amount of the coupling agent used is suitably selected within limits not affecting the conductivity of the conductive particles P. However, it is preferably such an amount that a coating rate (proportion of an area coated with the coupling agent to the surface area of the conductive core particles) of the coupling agent on the surfaces of the conductive particles P amounts to at least 5%, more preferably 7 to 100%, further preferably 10 to 100%, particularly preferably 20 to 100%.

The proportion of the conductive particles P contained in the polymeric substance-forming material is preferably 10 to 60%, more preferably 15 to 50% in terms of volume fraction. If this proportion is lower than 10%, it may be impossible in some cases to obtain conductive path elements 11 sufficiently low in electric resistance value. If this proportion exceeds 60% on the other hand, the resulting conductive path elements 11 are liable to become brittle, so that elasticity required of the conductive path elements 11 may not be achieved in some cases.

In the conductive path element-forming material 11A, as needed, may be contained an ordinary inorganic filler such as silica powder, colloidal silica, aerogel silica or alumina. By containing such an inorganic filler, the thixotropic property of the resulting conductive path element-forming material 11A is secured, the viscosity thereof becomes high, the dispersion stability of the conductive particles P is improved, and moreover the strength of the conductive path elements 11 obtained by conducting the curing treatment can be made high.
No particular limitation is imposed on the amount of such an inorganic filler used. However, the use in a too great amount is not preferred because the movement of the conductive particles P by a magnetic field in the production process, which will be described subsequently, is greatly impeded.

In this anisotropically conductive sheet 10, the respective through-holes 17 for forming conductive paths in the insulating sheet body 15 making up the anisotropically conductive sheet 10 are formed by using a mask 20 for exposure (see Fig. 2), in which a plurality of through-holes 21 for beam transmission, the diameter of each of which becomes gradually small from one surface 20A toward the other surface 20B of the mask, have been formed in accordance with a pattern corresponding to a pattern of the conductive path elements 11 to be formed, and irradiating the insulating sheet body with a laser beam through the through-holes 21 for beam transmission from the side of the other surface 20B of the mask 20 for exposure.
The through-holes 21 for forming conductive paths in the insulating sheet body 15 each has a shape for forming a cylindrical internal space extending perpendicularly to the one and other surfaces of the insulating sheet body 15 and are in a state independent of each other, i.e., a state separated in such a manner that conductive path elements to be formed in the through-holes 21 for forming conductive path elements secure sufficient insulating property between them.

In this anisotropically conductive sheet 10, the overall thickness (thickness of a portion where the conductive path element 11 has been formed) thereof is preferably, for example, at least 20 µm, more preferably 50 to 3,000 µm, particularly preferably 100 to 2,000 µm. For example, when this thickness is 50 µm or greater, an anisotropically conductive sheet 10 having sufficient strength is provided with certainty. When this thickness is 3,000 µm or smaller on the other hand, conductive path elements 11 having necessary conductive property can be provided with certainty.

The anisotropically conductive sheet 10 described above can be produced, for example, in the following manner.
[First step]
In this first step, as illustrated in Fig. 2, a mask 20 for exposure, in which a plurality of through-holes 21 for beam transmission, the diameter of each of which becomes gradually small from one surface 20A toward the other surface 20B of the mask, and each of which extends in a thickness-wise direction of the mask, have been formed in accordance with a pattern corresponding to an arrangement pattern of the conductive path elements 11 to be formed, is first provided.
As illustrated in Fig. 3, this mask 20 for exposure is arranged on one surface of an insulating sheet base 16 formed of an elastic polymeric substance in such a manner that the one surface 20A of the mask 20 for exposure comes into contact with the one surface of the insulating sheet base 16, and the insulating sheet base 16 is irradiated with a laser beam through a plurality of the through-holes 21 for beam transmission in the mask 20 for exposure from the side of, for example, the other surface 20B of the mask 20 for exposure as illustrated in Fig. 4, thereby forming an insulating sheet body 15 in which a plurality of through-holes 17 for forming conductive paths, each extending in a thickness-wise direction of the sheet body, have been formed.

As the mask 20 for exposure, is used that obtained by forming a plurality of the through-holes 21 for beam transmission by an etching method in a mask base composed of a metallic material having excellent thermal conductivity, for example, copper, in accordance with the pattern corresponding to the arrangement pattern of the conductive path elements 11 to be formed. By using the mask 20 for exposure composed of a metal, thermal expansion is prevented or inhibited by virtue of the heat radiating property of the mask 20 for exposure itself upon molding of a polymeric substance-forming material in a state that the mask 20 for exposure has remained arranged on the one surface of the insulating sheet body 15 in a production step of the anisotropically conductive sheet, which will be described subsequently, so that an anisotropically conductive sheet 10 of the intended form can be surely provided with high dimensional accuracy.
As the mask 20 for exposure, is also preferably used that having an opening diameter ratio r2/r1 of an opening diameter r2 in the other surface 20B of the mask to an opening diameter r1 in one surface 20A of, for example, from 0.2 to 0.98, more preferably from 0.2 to 0.95, still more preferably from 0.3 to 0.9. By using the mask that the opening diameter ratio r2/r1 satisfies the above range, the laser beam irradiated is prevented from being irregularly reflected by the inner wall surface of each of the through-holes 21 for beam transmission in the mask 20 for exposure, so that a plurality of the through-holes 17 for forming conductive paths, independent of each other, can be surely obtained.
The thickness of the mask 20 for exposure used is preferably, for example, 5 to 100 µm.
Such a mask 20 for exposure as described above is used, whereby in an anisotropically conductive sheet fundamentally having a construction that conductive path elements 11 each has a one surface-side projected part 12A protruding from one surface of an insulating sheet body 15, which will be described subsequently, the conductive path elements 11 having the expected conductive property can be surely formed.

As the laser beam for forming the through-holes 17 for forming conductive paths in the insulating sheet base 16, may be used that emitted by means of, for example, a carbon dioxide gas laser.
In this first step, the insulating sheet body 15 may be formed either by dividing a plane region of the other surface 20B of the mask 20 for exposure into a plurality of treatment unit regions, irradiating the insulating sheet base with the laser beam through a plurality of the through-holes 21 for beam transmission in one treatment unit region to form a plurality of through-holes 17 for forming conductive paths and conducting this treatment repeatedly and successively, or by irradiating the insulating sheet base through all the through-holes 21 for beam transmission in the mask 20 for exposure to form all the through-holes 17 for forming conductive paths at a time.
Specific conditions for irradiating with the laser beam upon the formation of the through-holes 17 for forming conductive paths may be suitably selected in view of the kind and thickness of the polymeric substance-forming material forming the insulating sheet base 16, and other constructional conditions.

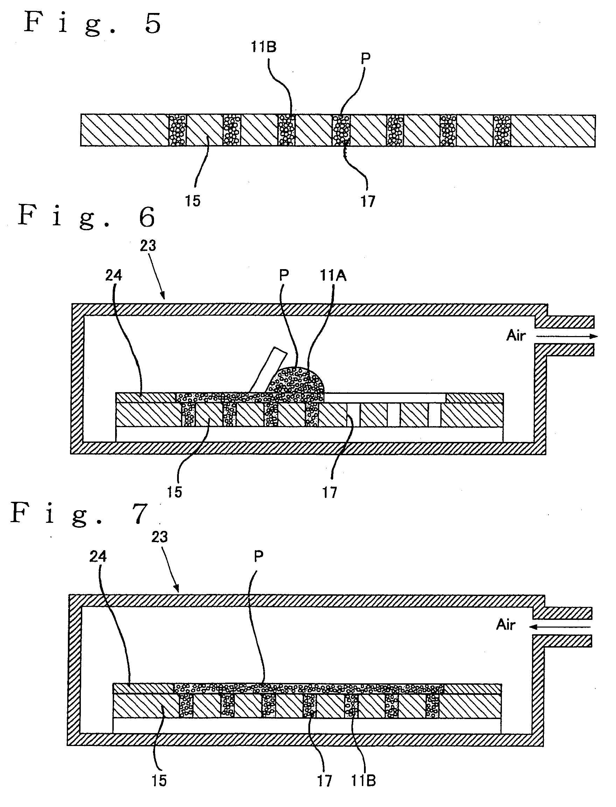

[Second step]
In the second step, the above-described conductive path element-forming material is first applied on to one surface of the insulating sheet body 15 obtained by the first step, thereby charging the conductive path element-forming material into the respective interiors of the through-holes 17 for forming conductive paths in the insulating sheet body 15 as illustrated in Fig. 5, whereby conductive path element-forming material layers 11B are formed in the respective interiors of the through-holes 17 for forming conductive paths in the insulating sheet body 15.

In the above-described step, as a means for applying the conductive path element-forming material 11A, may be used a means by a printing method, for example, screen printing.
In the second step, it is preferable to form the conductive path element-forming material layers 11B by applying the conductive path element-forming material 11A on to one surface of the insulating sheet body 15 by means of a mask 24 for printing in a state that the other surface sides of the through-holes 17 for forming conductive paths in the insulating sheet body 15 have been closed within a chamber 23, the internal space of which has been controlled to a reduced pressure atmosphere of, for example, 1 x 10⁻³ atm. or lower, preferably 1 x 10⁻⁴ down to 1 x 10⁻⁵ atm., as illustrated in Fig. 6, and then raising the pressure of the atmosphere within the chamber 23 to, for example, an atmospheric pressure as illustrated in Fig. 7, thereby charging the conductive path element-forming material 11A into the through-holes 17 for forming conductive paths.
According to such a process, the pressure of the atmosphere within the chamber 23 is raised, whereby the conductive path element-forming material 11A can be charged into the through-holes 17 for forming conductive paths at a high density by virtue of a pressure difference between the pressure of the atmosphere and the pressure within the through-holes 17 for forming conductive paths in the insulating sheet body 15. It can thus be prevented to generate bubbles in the resulting conductive path element-forming material layers 11B.

As a method for forming the conductive path element-forming material layers 11B within the through-holes 17 for forming conductive paths in the insulating sheet body 15, may also be used a method, in which the conductive particles P are first charged into the through-holes 17 for forming conductive paths in the insulating sheet body 15, and the polymeric substance-forming material, which will become an elastic polymeric substance by being cured, is then charged into the through-holes 17 for forming conductive paths in the insulating sheet body 15, in place of the method of applying the conductive path element-forming material 11A on to the insulating sheet body 15.

As illustrated in Fig. 8, the insulating sheet body 15, in which the conductive path element-forming material layers 11B have been formed within the through-holes 17 for forming conductive paths, is then arranged between a pair of electromagnets 25 and 26, and the electromagnets 25 and 26 are operated, thereby applying a parallel magnetic field to the conductive path element-forming material layers 11B in a thickness-wise direction thereof to orient the conductive particles P dispersed in the conductive path element-forming material layers 11B in the thickness-wise direction. In this state, the conductive path element-forming material layers 11B are subjected to a curing treatment, thereby forming conductive path elements 11 integrally provided within the respective through-holes 17 for forming conductive paths in the insulating sheet body 15, thus obtaining the anisotropically conductive sheet 10 of the construction shown in Fig. 1.

In this second step, the curing treatment of the conductive path element-forming material layers 11B may be conducted in the state that the parallel magnetic field has been applied. However, the treatment may also be conducted after the application of the parallel magnetic field is stopped.
The intensity of the parallel magnetic field applied to the conductive path element-forming material layers 11B is preferably an intensity that it amounts to, for example, 0.1 to 3 T (teslas) on the average.

The curing treatment of the conductive path element-forming material layers 11B is suitably selected according to the materials used. However, the treatment may be conducted by, for example, heating the insulating sheet body 15, in which the conductive path element-forming material layers 11B have been formed within the through-holes 17 for forming conductive paths, in a state pressurized under pressing force of a prescribed intensity. When the curing treatment of the conductive path element-forming material layers is conducted by such a method, it is only necessary to provide a heater on the electromagnets 25 and 26. Specific pressurizing conditions, heating temperature and heating time are suitably selected in view of the kind of the polymeric substance-forming material forming the conductive path element-forming material layers 11B, or the like, the time required for movement of the conductive particles P, and the like.

According to the anisotropically conductive sheet 10 of the construction described above, the through-holes 17 for forming conductive paths in the insulating sheet body 15 are each formed by using the mask 20 for exposure in accordance with the specific method, whereby adjacent conductive path elements 11 can be surely prevented from being formed joining each other even when the arrangement pitch of the conductive path elements 11 to be formed is small, so that the individual conductive path elements 11 can be formed independently of one another.

In other words, the mask 20 for exposure is arranged in such a manner that one surface 20A of the mask comes into contact with one surface of the insulating sheet base 16, and the insulating sheet base is irradiated with the laser beam from the side of the other surface 20B of the mask 20 for exposure, whereby the laser beam is restricted by the opening edge, which has a smaller opening diameter, of each of the through-holes 21 for beam transmission on the side of the other surface 20B of the mask 20 for exposure to strike perpendicularly on the one surface of the insulating sheet base 16, so that the through-holes 17 for forming conductive paths are formed at the necessary positions in a state having a cylindrical internal space extending perpendicularly to the one and other surfaces of the insulating sheet body 15, specifically, a state that assuming that the size of the opening diameter of a through-hole 17 for forming a conductive path on the one surface side in the insulating sheet body 15 is a, the size of the opening diameter of the through-hole 17 for forming the conductive path on the other surface side is b, and the size of the opening diameter of the through-hole 17 for forming the conductive path at a portion where the diameter becomes maximum in a thickness-wise direction of the insulating sheet body 15 is c, an opening diameter ratio a/b falls within a range of 0.5 to 1.5, or an opening diameter ratio c/a falls within a range of 0.5 to 1.5.
Accordingly, a plurality of the conductive path elements 11 independent of one another can be formed at an extremely small arrangement pitch of, for example, 100 µm or smaller without making the width of the conductive path element 11 itself small, so that the expected electrical connection can be surely achieved even to an object to be connected, the arrangement pitch of electrodes to be connected of which is extremely small.
In addition, since the through-holes 17 for forming conductive paths, which have a substantially even opening diameter in the thickness-wise direction can be formed, there is no limitation on the thickness of the anisotropically conductive sheet for preventing the conductive path elements 11 from being formed joining with each other, so that the degree of freedom of design can be made high in case that the arrangement pitch of the conductive path element 11 to be formed is small.

Further, since it is only necessary to arrange the mask 20 for exposure in such a manner that one surface 20A thereof comes into contact with one surface of the insulating sheet base 16, i.e., to conduct a simple process that the mask for exposure is produced, and this mask is then turned upside down in a series of production steps, the expected anisotropically conductive sheet 10 can be produced with high yield and advantage.

The anisotropically conductive sheet according to the present invention preferably has a construction that the conductive path elements are formed so as to protrude from at least one surface of the insulating sheet body.
Fig. 9 is a cross-sectional view schematically illustrating the construction of another exemplary anisotropically conductive sheet according to the present invention. This anisotropically conductive sheet 10 is so constructed that conductive path elements 11 each has a one surface-side projected part 12A protruding from one surface of the insulating sheet body 15. The one surface-side projected part 12A has a shape that its diameter becomes gradually small from the proximal end toward the distal end thereof, for example, a truncated cone form.
The projected height of the one surface-side projected part 12A in the conductive path element 11 is preferably at least 10%, more preferably at least 20% of the thickness of the anisotropically conductive sheet 10 at a portion where the one surface-side projected part 12A is located. By forming the one surface-side projected parts 12A having such a projected height, the conductive path elements 11 are sufficiently compressed by small pressurizing force, so that good conductive property is surely achieved.
The projected height of the one surface-side projected part 12A is also preferably at most 100%, more preferably at most 70% of the shortest width (width at the distal end surface) of the one surface-side projected part 12A. By forming the one surface-side projected parts 12A having such a projected height, such one surface-side projected parts 12A are not buckled when they are pressurized, so that the expected conductive property is surely achieved.

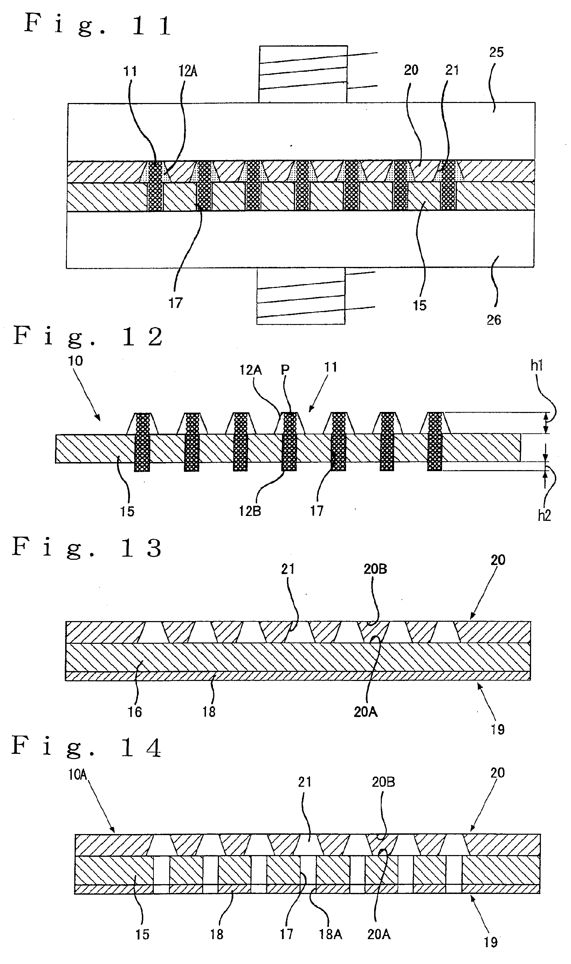

This anisotropically conductive sheet 10 can be produced by conducting the second step in the above-described production process in a state that the mask 20 for exposure has remained arranged on the one surface of the insulating sheet body 15.
Specifically, as illustrated in Fig. 10, the conductive path element-forming material 11A is applied in a state that the mask 20 for exposure has remained arranged on the one surface of the insulating sheet body 15 obtained in the first step, thereby charging the conductive path element-forming material 11A into the respective interiors of the through-holes 17 for forming conductive paths in the insulating sheet body 15 and the respective interiors of through-holes 21 for beam transmission in the mask 20 for exposure to form conductive path element-forming material layers 11B in the respective interiors of the through-holes 17 for forming conductive paths in the insulating sheet body 15 and the respective interiors of through-holes 21 for beam transmission in the mask 20 for exposure.
As illustrated in Fig. 11, a laminate composed of the insulating sheet body 15 and the mask 20 for exposure, in which the conductive path element-forming material layers 11B have been formed within the forming spaces including the through-holes 17 for forming conductive paths and the through-holes 21 for beam transmission in the mask 20 for exposure is then arranged between a pair of electromagnets 25 and 26, and the electromagnets 25 and 26 are operated, thereby applying a parallel magnetic field to the conductive path element-forming material layers 11B in a thickness-wise direction thereof to orient the conductive particles P dispersed in the conductive path element-forming material layers 11B in the thickness-wise direction thereof. In this state, the conductive path element-forming material layers 11B are subjected to a curing treatment, thereby forming the conductive path elements 11 integrally provided in the insulating sheet body 15 and each having the one surface-side projected part 12A protruding from the one surface of the insulating sheet body 15.
Thereafter, the mask 20 for exposure is removed, thereby obtaining the anisotropically conductive sheet 10 of the construction shown in Fig. 9.

According to the anisotropically conductive sheet 10 of the construction described above, the same effects as those brought about by the anisotropically conductive sheet (one of the construction shown in Fig. 1), both surfaces of which are made substantially flat, are fundamentally achieved, and moreover the expected electrical connection can be achieved with higher reliability because the conductive path elements 11 each has the one surface-side projected part of the shape that the diameter becomes gradually small from the proximal end toward the distal end thereof.

Fig. 12 is a cross-sectional view schematically illustrating the construction of a further exemplary anisotropically conductive sheet according to the present invention. This anisotropically conductive sheet 10 has an insulating sheet body 15 composed of an elastic polymeric substance, in which a plurality of through-holes 17 for forming conductive paths, each extending in a thickness-wise direction of the sheet base, have been formed in accordance with a pattern corresponding to a pattern of electrodes to be inspected of an object of connection, for example, a circuit device to be inspected, and conductive path elements 11 integrally provided in the respective through-holes 17 for forming conductive paths in the insulating sheet body 15. The conductive path elements 11 are formed so as to have projected parts 12A and 12B respectively protruding from both surfaces of the insulating sheet body 15.

The conductive path elements 11 in this anisotropically conductive sheet 10 are formed in such a manner that the one surface-side projected part 12A protruding from one surface of the insulating sheet body 15 has a shape that its diameter becomes gradually small from the proximal end toward the distal end thereof, for example, a truncated cone form, and the other surface-side projected part 12B protruding from the other surface of the insulating sheet body 15 has, for example, a columnar form.

The projected heights h1 and h2 of the one surface-side projected part 12A and the other surface-side projected part 12B in the conductive path element 11 are both preferably at least 10%, more preferably at least 20% of the thickness of the anisotropically conductive sheet 10 at a portion where the conductive path element 11 has been formed. By forming the one surface-side projected part 12A and other surface-side projected part 12B having such projected heights h1 and h2, the conductive path elements 11 are sufficiently compressed by small pressurizing force, so that good conductive property is surely achieved.
The projected height h1 of the one surface-side projected part 12A is also preferably at most 100%, more preferably at most 70% of the shortest width (for example, a width at the distal end surface in the one surface-side projected part) of the one surface-side projected part 12A. The same shall apply to the projected height h2 of the other surface-side projected part 12B.
By forming the one surface-side projected part 12A and other surface-side projected part 12B having such projected heights h1 and h2, such one surface-side projected parts 12A and other surface-side projected part 12B are not buckled when they are pressurized, so that the expected conductive property is surely achieved.

The anisotropically conductive sheet 10 described above can be produced, for example, in the following manner.
[First step]
In this first step, a laminate 19 with a resin layer 18 for forming projected parts integrally provided on at least one surface of an insulating sheet base 16 composed of an elastic polymeric substance is first prepared (see Fig. 13). In this embodiment, the resin layer 18 for forming projected parts is provided only on the other surface of the insulating sheet base 16.
As a means for forming the resin layer 18 for forming projected parts, it may be formed by applying a resin layer-forming material on to the insulating sheet base 16 and heating the resultant coating film to dry it, or by transferring a resin layer-forming material layer formed in the form of a film to the insulating sheet base 16 to stick it on the sheet base.

As the resin layer-forming material, is preferred that having properties described below. As specific examples thereof, may be mentioned polyvinyl alcohol, polyacrylic acid, polyacrylamide, polyethylene oxide, polyvinyl pyrrolidone, polyvinyl amide and polyamine. Among these, polyvinyl alcohol is preferred for the reason that it has properties of being easily dissolved in water and scarcely deformed by heating upon laser beam machining.
As polyvinyl alcohol, is preferably used, for example, that having a weight average polymerization degree of 100 to 5,000, more preferably 1,000 to 2,000. By using such polyvinyl alcohol, it may be surely dissolved in and removed by water, which is a solvent, in a step of removing the resin layer, which will be described subsequently.

[Properties required]
(1) To be capable of conducting perforation by a laser beam.
(2) Not to impede the curing of the polymeric substance-forming material.
(3) To have heat resistance.
(4) To be dissolved in water or a solvent in a proportion of at least 5%.
(5) To be swollen with water or the solvent.

The thickness of the resin layer 18 for forming projected parts is preferably, for example, 5 to 100 µm, more preferably 15 to 40 µm. By providing the resin layer having such a thickness, the resin layer 18 for forming projected parts can be surely dissolved and removed by a proper solvent to surely form projected parts capable of achieving the expected conductive property.

[Second step]
In this second step, as illustrated in Fig. 13, the mask 20 for exposure of the construction described above is arranged on one surface of the laminate 19 in such a manner that one surface 20A of the mask comes into contact with one surface of the laminate 19, and the insulating sheet base is then irradiated with a laser beam through a plurality of the through-holes 21 for beam transmission in the mask 20 for exposure from the side of the other surface 20B of the mask 20 for exposure to form a plurality of through-holes 17 for forming conductive paths, each extending in a thickness-wise direction of the insulating sheet base 16, in the insulating sheet base 16, and at the same time form through-holes 18A for forming projected parts, each extending continuously with its corresponding through-hole 17 for forming a conductive path in the thickness-wise direction, in the resin layer 18 for forming projected parts as illustrated in Fig. 14, thereby forming a primary composite body 10A with the resin layer for forming projected parts formed on the other surface of an insulating sheet body 15.

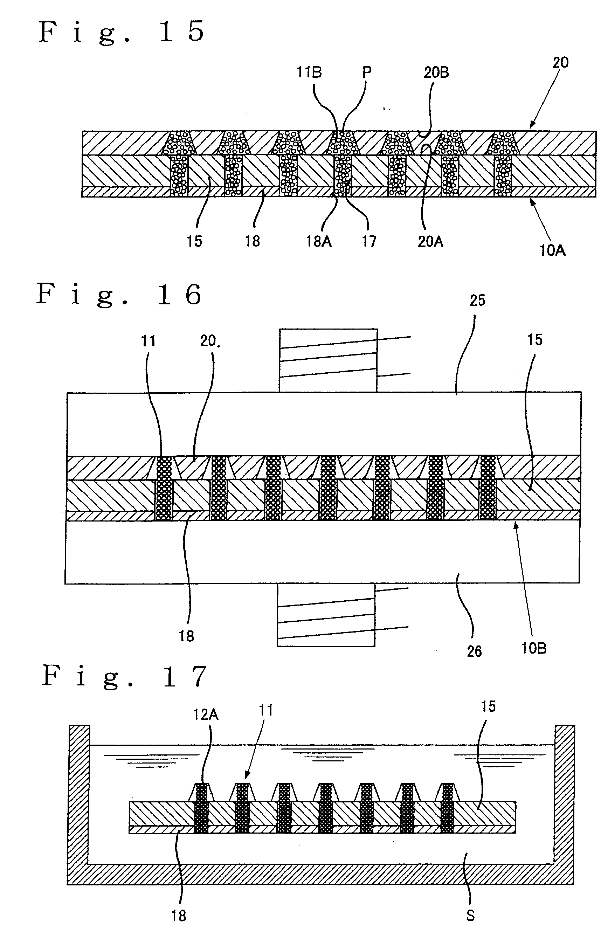

[Third step]
In this third step, as illustrated in Fig. 15, the above-described conductive path element-forming material 11A is first applied in a state that the mask 20 for exposure has remained arranged on one surface of the primary composite body 10A, in which the through-holes 17 for forming conductive paths and the through-holes 18A for forming projected parts have been formed, thereby charging the conductive path element-forming material 11A into spaces for forming conductive path elements, including internal spaces of the through-holes 21 for beam transmission in the mask 20 for exposure, internal spaces of the through-holes 17 for forming conductive paths in the insulating sheet body 15 and internal spaces of the through-holes 18A for forming projected parts in the resin layer 18 for forming projected parts, to form conductive path element-forming material layers 11B in the respective spaces for forming conductive paths.

As illustrated in Fig. 16, the laminate of the mask 20 for exposure, the insulating sheet body 15 and the resin layer 18 for forming projected parts, in which the conductive path element-forming material layers 11B have been formed within the spaces for forming conductive path elements, is then arranged between a pair of electromagnets 25 and 26, and the electromagnets 25 and 26 are operated, thereby applying a parallel magnetic field to the conductive path element-forming material layers 11B in a thickness-wise direction thereof to orient the conductive particles P dispersed in the conductive path element-forming material layers 11B in the thickness-wise direction of the conductive path element-forming material layers 11B. In this state, the conductive path element-forming material layers 11B are subjected to a curing treatment, thereby forming conductive path elements 11 to form a secondary composite body composed of the laminate of the mask 20 for exposure, the insulating sheet body 15 and the resin layer 18 for forming projected parts, in which the conductive path elements 11 have been formed within the spaces for forming conductive path elements.

In the second and third steps described above, the treatment conditions for forming the through-holes 17 for forming conductive paths and the through-holes 18A for forming projected parts, the treatment conditions for forming the conductive path element-forming material layers 11B, and the treatment conditions for forming the conductive path elements 11 are the same as in the production of the anisotropically conductive sheet of the construction shown in Fig. 1.

[Fourth step]
In this fourth step, the mask 20 for exposure is separated and removed from the one surface of the secondary composite body 10B to expose one end portions of the conductive path elements 11 so as to form the one surface-side projected parts 12A. In this state, the whole of the secondary composite body 10B is immersed in a proper solvent S as illustrated in Fig. 17 to dissolve and remove the resin layer 18 for forming projected parts, thereby exposing the other end portions of the conductive path elements 11 so as to form the other surface-side projected parts 12B, thus obtaining the anisotropically conductive sheet 10 of the construction shown in Fig. 12.

The solvent used for removing the resin layer 18 for forming projected parts requires not impeding the properties, form and the like of the elastic polymeric substance forming the insulating sheet body 15 and may be suitably selected in view of the relation to the material forming the resin layer 18 for forming projected parts. Specific examples thereof include water, lower alcohols such as methanol, ethanol and isopropanol, acetone, formaldehyde, acetic acid, ethyl acetate, and aqueous solutions or mixtures of these solvents.
Specific treatment conditions, for example, the temperature of the solvent, and immersion time may be suitably set in view of the kind of the material forming the resin layer 18 for forming projected parts, the thickness of the resin layer, the kind of the solvent used, and the like. For example, the temperature of the solvent is 60 to 90°C, and the immersion time is 0.5 to 24 hours.

In the anisotropically conductive sheet 10 obtained by the above-described process, the through-holes 17 for forming conductive paths in the insulating sheet body 15 are each fundamentally formed by using the mask 20 for exposure in accordance with the specific method, whereby adjacent conductive path elements 11 can be surely prevented from being formed joining each other even when the arrangement pitch of the conductive path elements 11 to be formed is small, so that the individual conductive path elements 11 can be formed independently of one another.
In other words, the mask 20 for exposure is arranged in such a manner that one surface 20A of the mask comes into contact with one surface of the insulating sheet base 16, and the insulating sheet base is irradiated with the laser beam from the side of the other surface 20B of the mask 20 for exposure, whereby the laser beam is restricted by the opening edge, which has a smaller opening diameter, of each of the through-holes 21 for beam transmission on the side of the other surface 20B of the mask 20 for exposure to strike substantially perpendicularly on the one surface of the insulating sheet base 16, so that the through-holes 17 for forming conductive paths are formed at the necessary positions in a state having a cylindrical internal space extending substantially perpendicularly to the one and other surfaces of the insulating sheet body 15. Specifically, they are formed in a state that assuming that the size of the opening diameter of a through-hole 17 for forming a conductive path on the one surface side in the insulating sheet body 15 is a, the size of the opening diameter of the through-hole 17 for forming the conductive path on the other surface side is b, and the size of the opening diameter of the through-hole 17 for forming the conductive path at a portion where the diameter becomes maximum in a thickness-wise direction of the insulating sheet body 15 is c, an opening diameter ratio a/b falls within a range of 0.5 to 1.5, or an opening diameter ratio c/a falls within a range of 0.5 to 1.5. Accordingly, a plurality of the conductive path elements 11 independent of one another can be formed at an extremely small arrangement pitch of, for example, 100 µm or smaller without making the width of the conductive path element 11 itself small.

In addition, the other surface-side projected parts 12B in the conductive path elements 11 are formed by forming projected part-forming portions within the through-holes 18B for forming projected parts in the resin layer 18 for forming projected parts and dissolving and removing the resin layer 18 for forming projected parts, whereby the other surface-side projected parts 12B having the expected conductive property can be surely formed on all the conductive path elements 11 without causing the problem that the projected parts may be broken off in some cases according to, for example, the process making use of the mask for printing to form the projected parts when the mask for printing is separated and removed, even when the arrangement pitch of the conductive path elements 11 is extremely small.
Thus, according to the anisotropically conductive sheet 10 obtained by the above-described process, the expected electrical connection can be surely achieved with high reliability even to an object to be connected, the arrangement pitch of electrodes to be connected of which is extremely small.
In the above-described process, the mask 20 for exposure is separated and removed when the one surface-side projected parts 12A are formed. However, the one surface-side projected parts 12A are substantially not broken off because the mask 20 for exposure is separated along the tapered internal surface of each of the through-holes 21 for beam transmission thereof.

Further, since it is only necessary to arrange the mask 20 for exposure upon the formation of the through-holes 17 for forming conductive parts and through-holes 18A for forming projected parts in such a manner that one surface 20A, which is a surface irradiated with the laser beam in the production process, comes into contact with one surface of the insulating sheet base 16, i.e., to conduct a simple process that the mask for exposure is produced, and this mask is then turned upside down in a series of production steps, the expected anisotropically conductive sheet 10 can be produced with high yield and advantage.
Further, since the through-holes 17 for forming conductive paths, which have a substantially even opening diameter, can be formed in the thickness-wise direction, there is no limitation on the thickness of the anisotropically conductive sheet for preventing the conductive path elements 11 from being formed joining with each other, so that the degree of freedom of design can be made high in case that the arrangement pitch of the conductive path element 11 to be formed is small.

The anisotropically conductive sheets according to the present invention are not limited to the above-described embodiments, and various changes or modifications may be added thereto.
In the above-described embodiments, upon the production of that having the construction that the conductive path elements protrude from one surface (surface of the side on which the laser beam is struck) of the insulating sheet body, description has been given on the process, in which the conductive path element-forming material layers are formed within the spaces for forming conductive path elements, including the internal spaces of the through-holes for beam transmission in the mask for exposure in a state that the mask for exposure has remained arranged, the curing treatment is conducted, and the mask for exposure is removed, thereby forming the one surface-side projected parts. However, the one surface-side projected parts may also be formed by preparing a laminate with resin layers for forming projected parts integrally provided on both surfaces of an insulating sheet base, arranging the mask for exposure on one surface of this laminate in such a manner that one surface of the mask comes into contact with the one surface of the laminate, irradiating the insulating sheet base with a laser beam from the side of the other surface of the mask for exposure to form through-holes for forming projected parts in the resin layers for forming projected parts and at the same time form through-holes for forming conductive parts in the insulating sheet base, forming the conductive path element-forming material layers within the spaces for forming conductive path elements in a state that the mask for exposure has been removed or remained arranged, conducting the curing treatment, and dissolving and removing the resin layer for forming one surface-side projected parts on the side of the one surface.

Upon the production of, for example, the anisotropically conductive sheet having the construction that the conductive path elements are formed so as to protrude from both surfaces of the insulating sheet body, the one surface-side projected parts and other surface-side projected parts may also be formed by also arranging a second mask for exposure, which has the same construction as a first mask for exposure, on the other surface of the insulating sheet body, on the one surface of which the first mask for exposure has been arranged, in such a manner that the other surface thereof comes into contact, charging the conductive path element-forming material into the through-holes for forming conductive paths in the insulating sheet body, the through-holes for beam transmission in the first mask for exposure and the through-holes for beam transmission in the second mask for exposure in a state that any one surface of the masks has been closed, thereby forming conductive path element-forming material layers, subjecting the conductive path element-forming material layers to the curing treatment, thereby forming conductive path elements, and removing the first and second masks for exposure.

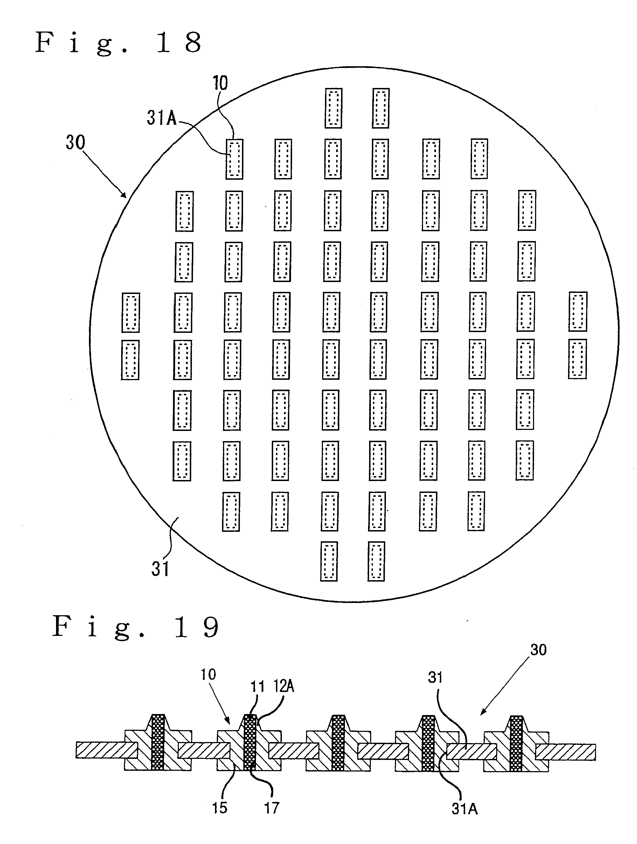

[Anisotropically conductive connector]
Fig. 18 is a plan view schematically illustrating the construction of an exemplary anisotropically conductive connector according to the present invention, and Fig. 19 is a cross-sectional view illustrating, on an enlarged scale, a principal part of the anisotropically conductive connector shown in Fig. 18. This anisotropically conductive connector 30 is suitable for use in conducting electrical inspection of each of a plurality of integrated circuits formed on a wafer in a state of the wafer, and has a frame plate 31, in which a plurality of openings 31A each extending through in a thickness-wise direction of the frame plate have been formed correspondingly to regions, in which electrodes to be inspected in all the integrated circuits formed on the wafer, which is an object of inspection, have been arranged. The anisotropically conductive sheets 10 are arranged in the openings 31A in the frame plate 31 so as to close the openings 31A, and peripheral edge portions of the anisotropically conductive sheets 10 are supported by their corresponding opening edges of the frame plate 31 to integrally fix the anisotropically conductive sheets to the frame plate.
Each of the anisotropically conductive sheets 10 in this embodiment has the same construction as that shown in Fig. 9 except that it has one conductive path element 11, and the conductive path element 11 is formed so as to protrude from one surface of the anisotropically conductive sheet 10.

As a material for forming the frame plate 31 in the anisotropically conductive connector 30, may be used various kinds of materials such as metallic materials, ceramic materials and resin materials. Specific examples thereof include metallic materials such as metals such as iron, copper, nickel, chromium, cobalt, magnesium, manganese, molybdenum, indium, lead, palladium, titanium, tungsten, aluminum, gold, platinum and silver, and alloys or alloy steels composed of a combination of at least two of these metals; ceramic materials such as silicon nitride, silicon carbide and alumina; and resin materials such as aramid nonwoven fabric-reinforced epoxy resins, aramid nonwoven fabric-reinforced polyimide resins and aramid nonwoven fabric-reinforced bismaleimidotriazine resins.
When the anisotropically conductive connector 30 is used in the burn-in test, it is preferable to use a material having a coefficient of linear thermal expansion equivalent or close to that of a material forming a wafer, which is an object of inspection, as a material forming the frame plate 31. Specifically, when the material forming the wafer is silicon, that having a coefficient of linear thermal expansion of at most 1.5 x 10⁻⁴/K, particularly, 3 x 10⁻⁶ to 8 x 10⁻⁶/K is preferably used. Specific examples of such a material include metallic materials such as invar alloys such as invar, Elinvar alloys such as Elinvar, superinvar, covar, and 42 alloy; and aramid nonwoven fabric-reinforced organic resin materials.
No particular limitation is imposed on the thickness of the frame plate 31 so far as its form is retained, and the anisotropically conductive sheets 10 can be held. However, the thickness is, for example, 0.03 to 1 mm, preferably 0.05 to 0.25 mm.

Such an anisotropically conductive connector 30 can be produced in the following manner.
[First step]
A frame plate 31, in which a plurality of openings 31A are formed correspondingly to electrode regions, in which electrodes to be inspected in all integrated circuits formed on a wafer that is an object of inspection have been arranged, is first produced. As a method for forming the openings 31A in the frame plate 31, may be utilized, for example, an etching method or the like.
A mask 20 for exposure, in which a plurality of through-holes 21 for beam transmission, the diameter of each of which becomes gradually small from one surface 20A toward the other surface 20B of the mask, have been formed in accordance with a pattern corresponding to an arrangement pattern of the conductive path elements 11 to be formed, is then provided.

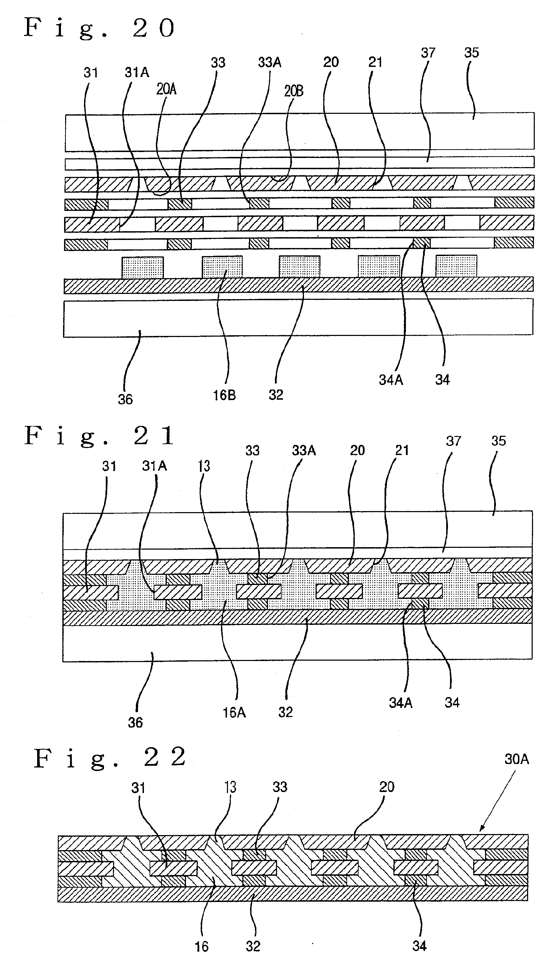

A polymeric substance-forming material, which will become an elastic polymeric substance by being cured, is then applied on to one surface of a flat plate-like supporting plate 32 (see Fig. 20) composed of the same material as the frame plate 31 in accordance with a pattern corresponding to a pattern of the electrode regions in the wafer that is the object of inspection, thereby forming polymeric substance-forming material layers 16B at necessary positions on the one surface of the supporting plate 32. In this step, as a method for applying the polymeric substance-forming material on to the one surface of the supporting plate 32, is preferably used, for example, a screen printing method. According to such a method, the polymeric substance-forming material can be easily applied in accordance with the necessary pattern, and a proper amount of the polymeric substance-forming material can be applied.

As illustrated in Fig. 20, the supporting plate 32, on which the polymeric substance-forming material layers 16B have been formed, is then arranged on a flat plate-like lower surface-side pressurizing plate 36, the frame plate 31 is arranged in alignment over the one surface of the supporting plate 32 through a lower surface-side spacer 34, in which a plurality of openings 34A each having a form conformable to a planar form of the anisotropically conductive sheets 10 to be formed have been formed, an upper surface-side spacer 33, in which a plurality of openings 33A each having a form conformable to the planar form of the anisotropically conductive sheets 10 to be formed have been formed, is arranged in alignment on the frame plate 31, the mask 20 for exposure is further arranged on one surface of the upper surface-side spacer 33 in a state that the one surface 20A thereof has been turned downward, in other words, opposed to the one surface of the upper surface-side spacer 33, a flat plate-like upper surface-side pressurizing plate 35 is arranged through the mask 20 for exposure and a sheet-like releasing film 37 suitably used, and these are superimposed on one another to pressurize them, thereby forming polymeric substance-forming material layers 16A of the intended form (form of the anisotropically conductive sheets 10 to be formed) in spaces for forming anisotropically conductive sheets, including internal spaces of the openings 31A of the frame plate 31, internal spaces of the respective openings 34A, 33A of the lower surface-side spacer 34 and upper surface-side spacer 33, and internal spaces of the through-holes 21 for beam transmission in the mask 20 for exposure as illustrated in Fig. 21.
In this case, the polymeric substance-forming material layers 16B may also be formed on both of the one surface of the supporting plate 32 and the one surface of the mask 20 for exposure. When the polymeric substance-forming material layers 16B are formed on the one surface 20A of the mask 20 for exposure, it is only necessary to form the polymeric substance-forming material layers 16B at necessary positions on the one surface 20A of the mask 20 for exposure in a state charged into the through-holes 21 for beam transmission in the mask 20 for exposure.
By forming the spaces for forming anisotropically conductive sheets by arranging the frame plate 41 and the two spacers 33, 34 in such a manner, the anisotropically conductive sheets 10 of the intended form can be surely formed, and moreover a great number of anisotropically conductive sheets 10 independent of one another can be surely formed because adjacent anisotropically conductive sheets 10 are prevented from joining with each other.

Thereafter, the polymeric substance-forming material layers 16A are subjected to a curing treatment, thereby forming a primary composite body 30A, in which insulating sheet bases 16 each having a projected part-forming portion 13 are arranged so as to close the openings 31A in the frame plate 31, and peripheral edge portions of the insulating sheet bases 16 are supported by their corresponding opening edges of the frame plate 31 to fix the insulating sheet bases 16 as illustrated in Fig. 22.

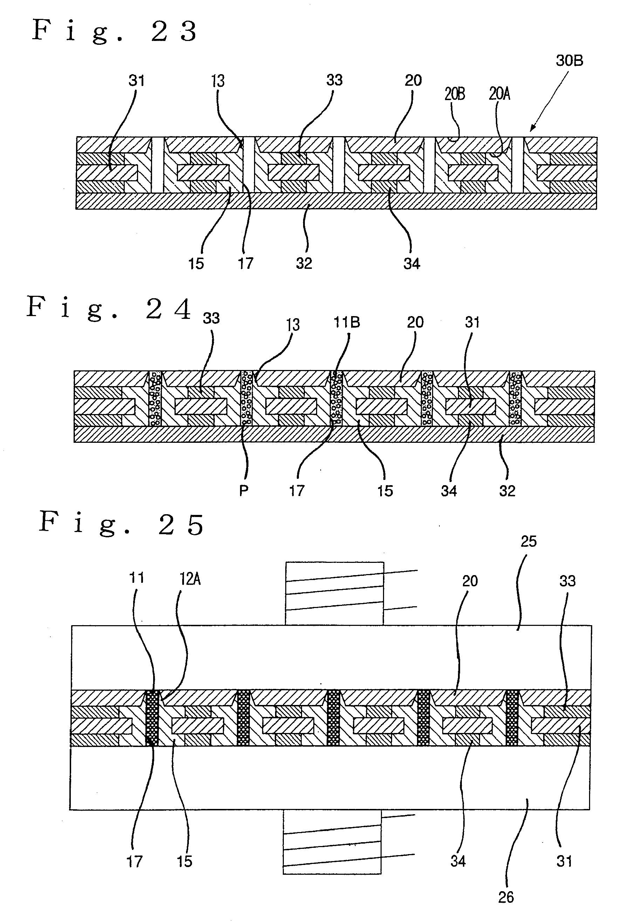

[Second step]
In this second step, as illustrated in Fig. 23, the insulating sheet bases are irradiated with a laser beam through a plurality of the through-holes 21 for beam transmission in the mask 20 for exposure from the side of the other surface 20B of the mask 20 for exposure, thereby forming insulating sheet bodies 15, in which a plurality of through-holes 17 for forming conductive paths, each extending in a thickness-wise direction of the sheet body, have been formed, thus forming a secondary composite body 30B, in which the insulating sheet bodies 15 are arranged so as to close the openings 31A in the frame plate 31, and peripheral edge portions of the insulating sheet bodies 15 are supported by their corresponding opening edges of the frame plate 31 to fix the insulating sheet bodies 15.

[Third step]
In this third step, as illustrated in Fig. 24, the above-described conductive path element-forming material 11A is applied on to one surface of the secondary composite body 30B obtained in the second step to charge the conductive path element-forming material 11A into the respective through-holes 21 for forming conductive paths in the secondary composite body 30B, thereby forming conductive path element-forming material layers 11B in the interiors of the respective through-holes 17 for forming conductive paths in the secondary composite body 30B.
As illustrated in Fig. 25, the secondary composite body 30B, in which the conductive path element-forming material layers 11B have been formed, is then arranged between a pair of electromagnets 25 and 26, and the electromagnets 25 and 26 are operated, thereby applying a parallel magnetic field to the conductive path element-forming material layers 11B in a thickness-wise direction thereof to orient the conductive particles P dispersed in the conductive path element-forming material layers 11B in the thickness-wise direction of the conductive path element-forming material layers 11B. In this state, the conductive path element-forming material layers 11B are subjected to the curing treatment, thereby forming a plurality of anisotropically conductive sheets 10, in which a plurality of conductive path elements 11 have been integrally provided in the insulating sheet bodies 15.
Thereafter, the mask 20 for exposure and the supporting plate 32 are removed, thereby obtaining the anisotropically conductive connector 30 shown in Figs. 18 and 19.

According to the anisotropically conductive connector 30 of the construction described above, it is equipped with the anisotropically conductive sheets 10 with the conductive path elements 11 integrally provided within the through-holes 17 for forming conductive paths in the respective insulating sheet bodies 15, which have been formed by using the mask 20 for exposure in accordance with the specific method, so that the same effects as those brought about by the anisotropically conductive sheet 10 are achieved, and moreover such effects as described below are brought about.
Namely, according to the above-described anisotropically conductive connector 30, the anisotropically conductive sheets 10 are hard to be deformed and easy to handle because they are fixed to the frame plate 31, so that the positioning and the holding and fixing to a wafer, which is an object of inspection, can be easily conducted in an electrically connecting operation to the wafer.
In addition, since the openings 31A in the frame plate 31 are formed correspondingly to electrode regions, in which electrodes to be inspected of all integrated circuits formed on a wafer, which is an object of inspection, have been arranged, and the anisotropically conductive sheet 10 arranged in each of the openings 31A may be small in area, the individual anisotropically conductive sheets 10 are easy to be formed. Further, since the anisotropically conductive sheet 10 small in area is little in the absolute quantity of thermal expansion in a plane direction of the anisotropically conductive sheet 10 even when it is subjected to thermal hysteresis, the thermal expansion of the anisotropically conductive sheet 10 in the plane direction is surely restrained by the frame plate 31 by using a material having a low coefficient of linear thermal expansion as that for forming the frame plate 31. Accordingly, a good electrically connected state can be stably retained even when an object of inspection is a great number of integrated circuits formed on a wafer of a large area, and the burn-in test is collectively performed on these integrated circuits.

The anisotropically conductive sheets making up the anisotropically conductive connector according to the present invention are not limited to such sheets as described above, in which the conductive path elements are formed in a state protruding from one surface of the sheet, and the conductive path elements may be formed in a state protruding from both surfaces of the sheet.

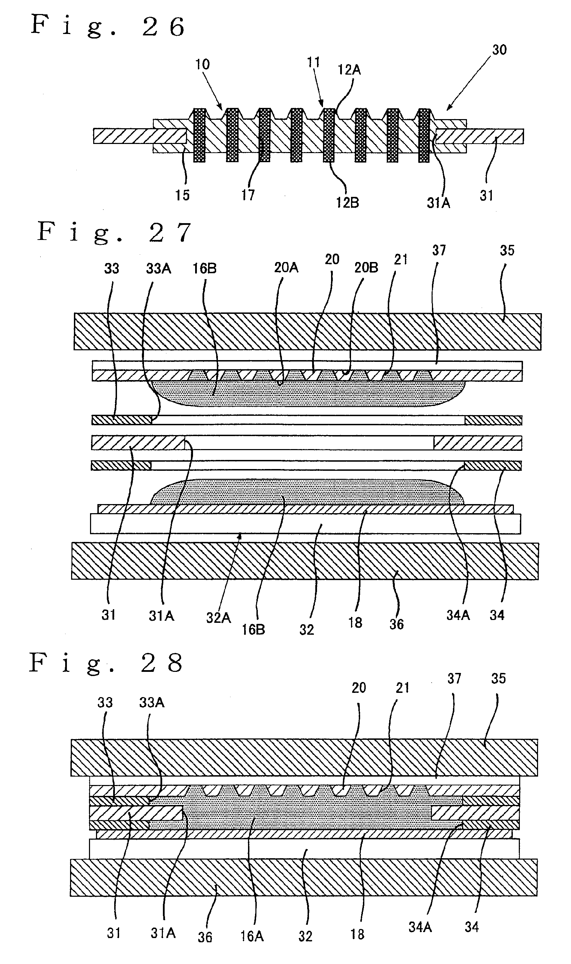

Fig. 26 is a cross-sectional view illustrating, on an enlarged scale, the construction of a principal part of another exemplary anisotropically conductive connector according to the present invention. Each of the anisotropically conductive sheets 10 making up this anisotropically conductive connector 30 is of the construction shown in Fig. 12, i.e., the construction that the conductive path elements 11 are formed in a state protruding from both surfaces of the insulating sheet body 15.

Such an anisotropically conductive connector 30 can be produced in the following manner.
[First step]
In this first step, a frame plate 31, in which a plurality of openings 31A are formed correspondingly to electrode regions, in which electrodes to be inspected in all integrated circuits formed on a wafer that is an object of inspection have been arranged, is first produced. As a method for forming the openings 31A in the frame plate 31, may be utilized, for example, an etching method or the like.
A mask 20 for exposure, in which a plurality of through-holes 21 for beam transmission, the diameter of each of which becomes gradually small from one surface 20A toward the other surface 20B of the mask, have been formed in accordance with a pattern corresponding to an arrangement pattern of the conductive path elements 11 to be formed, is then provided.
Further, a resin layer 18 for forming projected parts having a predetermined thickness is formed on one surface of a flat plate-like supporting plate 32 composed of, for example, the same material as the frame plate 31 to form a laminate material 32A (see Fig. 27). Specifically, the laminate material can be formed by, for example, applying a resin layer-forming material on to the supporting plate and heating and drying the resultant coating film, or transferring a resin layer-forming material layer formed in the form of a film to one surface of the supporting plate 32 to stick it on the support plate.

A polymeric substance-forming material, which will become an elastic polymeric substance by being cured, is applied on to one surface of the resin layer 18 for forming projected parts in the laminate material 32A in accordance with a pattern corresponding to a pattern of the electrode regions in the wafer that is the object of inspection, thereby forming polymeric substance-forming material layers 16B at necessary positions on the one surface of the laminate material 32A.
On the other hand, a polymeric substance-forming material, which will become an elastic polymeric substance by being cured, is applied on to the one surface 20A of the mask 20 for exposure in accordance with the pattern corresponding to the pattern of the electrode regions in the wafer that is the object of inspection in a state that the mask 20 for exposure has been arranged on the other surface of a sheet-like releasing film 37 in such a manner that the other surface 20B of the mask comes into contact with the releasing film, thereby forming polymeric substance-forming material layers 16B at necessary positions on the one surface 20A of the mask 20 for exposure in a state charged into the through-holes 21 for beam transmission in the mask 20 for exposure. In this case, it is not necessary to form the polymeric substance-forming material layers 16B on both of the laminate material 32A and the mask 20 for exposure, and the polymeric substance-forming material layers 16B may be formed on either one of the laminate material 32A or the mask 20 for exposure.
As a method for applying the polymeric substance-forming material on to the laminate material 32A and the mask 20 for exposure, is preferably used, for example, a screen printing method. According to such a method, the polymeric substance-forming material can be easily applied in accordance with the necessary pattern, and a proper amount of the polymeric substance-forming material can be applied.

As illustrated in Fig. 27, the laminate material 32A, on which the polymeric substance-forming material layers 16B have been formed, is then arranged on a flat plate-like lower surface-side pressurizing plate 36, the frame plate 31 is arranged in alignment over the one surface of the laminate material 32A through a lower surface-side spacer 34, in which a plurality of openings 34A each having a form conformable to a planar form of the anisotropically conductive sheets 10 to be formed have been formed, an upper surface-side spacer 33, in which a plurality of openings 33A each having a form conformable to the planar form of the anisotropically conductive sheets 10 to be formed have been formed, is arranged in alignment on one surface of the frame plate 31, a laminate material composed of the mask 20 for exposure, on which the polymeric substance-forming material layers 16B have been formed, and the releasing film 37 is further arranged on one surface of the upper surface-side spacer 33 in a state that the one surface 20A of the mask 20 for exposure has been turned downward, in other words, opposed to the one surface of the upper surface-side spacer 33, a flat plate-like upper surface-side pressurizing plate 35 is arranged on one surface of the sheet-like releasing film 37 in this laminate material, and these are superimposed on one another to pressurize them, thereby forming polymeric substance-forming material layers 16A of the intended form (form of the anisotropically conductive sheets 10 to be formed) in spaces for forming anisotropically conductive sheets, including internal spaces of the openings 31A of the frame plate 31, internal spaces of the respective openings 34A, 33A of the lower surface-side spacer 34 and upper surface-side spacer 33, and internal spaces of the through-holes 21 for beam transmission in the mask 20 for exposure as illustrated in Fig. 28.
By forming the spaces for forming anisotropically conductive sheets by arranging the frame plate 31 and the two spacers 33, 34 in such a manner, the anisotropically conductive sheets 10 of the intended form can be surely formed, and moreover a great number of anisotropically conductive sheets 10 independent of one another can be surely formed because adjacent anisotropically conductive sheets 10 are prevented from joining with each other.

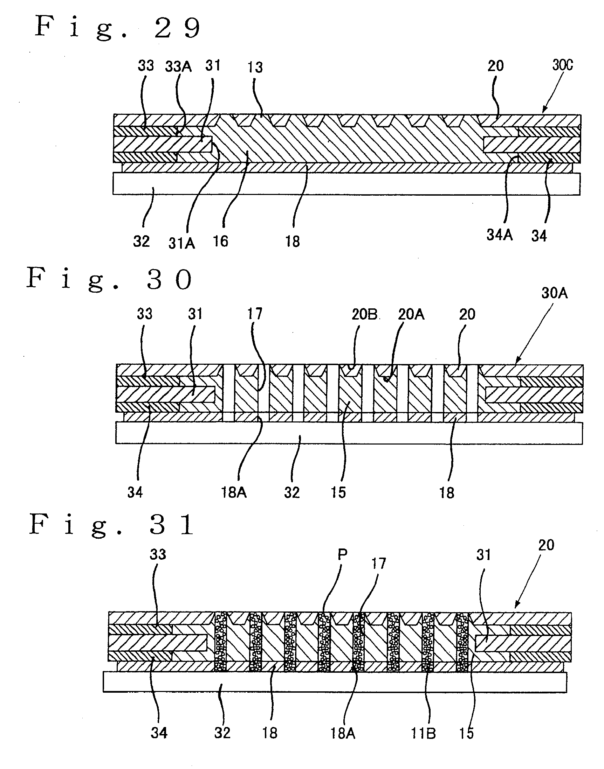

Thereafter, the polymeric substance-forming material layers 16A are subjected to a curing treatment, thereby preparing a laminate 30C, in which insulating sheet bases 16 each having projected part-forming portions 13 are arranged so as to close the openings 31A in the frame plate 31, peripheral edge portions of the insulating sheet bases 16 are supported by their corresponding opening edges of the frame plate 31 to fix the insulating sheet bases 16, the mask 20 for exposure is provided on the side of the one surfaces of the insulating sheet bases 16, and the resin layer for forming projected parts is provided on the side of the other surfaces of the insulating sheet bases 16, as illustrated in Fig. 29.

[Second step]
In this second step, the insulating sheet bases are irradiated with a laser beam through a plurality of the through-holes 21 for beam transmission in the mask 20 for exposure from the side of the other surface 20B of the mask 20 for exposure in the laminate 30C, thereby forming a plurality of through-holes 17 for forming conductive paths, each extending in a thickness-wise direction of the sheet body, in each of the insulating sheet bases 16, and at the same time forming a plurality of through-holes 18A for forming projected parts, each extending continuously with the through-hole 17 for forming a projected part in the thickness-wise direction, in the resin layer 18 for forming projected parts, thus forming a primary composite body 30A, in which insulating sheet bodies 15 are arranged so as to close the openings 31A in the frame plate 31, peripheral edge portions of the insulating sheet bodies 15 are supported by their corresponding opening edges of the frame plate 31 to fix the insulating sheet bodies 15, the mask 20 for exposure is provided on the side of the one surfaces of the insulating sheet bodies 15, and the resin layer 18 for forming projected parts is provided on the side of the other surfaces of the insulating sheet bodies 15, as illustrated in Fig. 30.

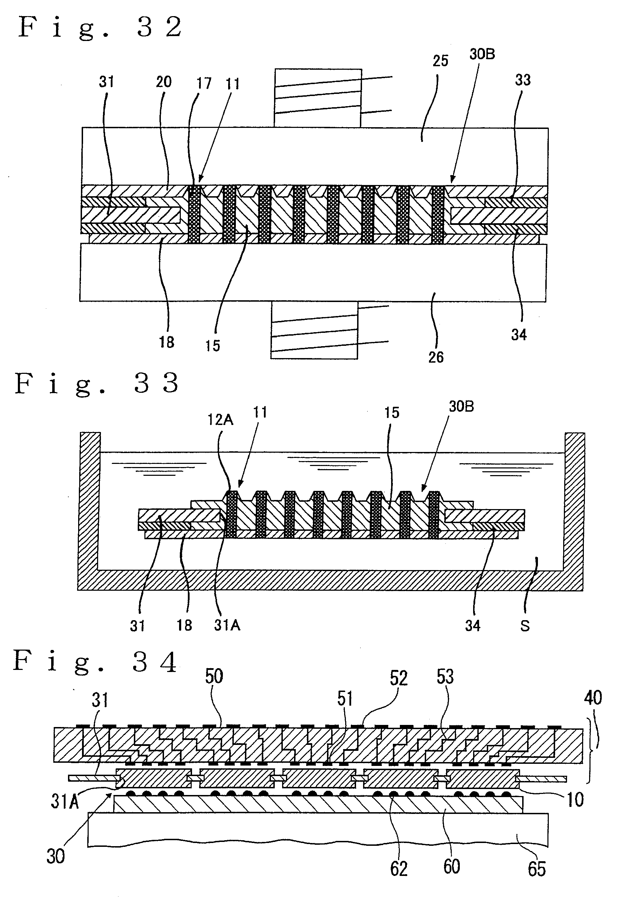

[Third step]
In this third step, as illustrated in Fig. 31, the above-described conductive path element-forming material is applied on to one surface of the primary composite body 30A obtained in the second step to charge the conductive path element-forming material into spaces for forming conductive path elements, including internal spaces of the through-holes 17 for forming conductive paths and internal spaces of the through-holes 18A for forming projected parts in the primary composite body 30A, thereby forming conductive path element-forming material layers 11B in the spaces for forming conductive path elements in the primary composite body 30A.
As illustrated in Fig. 32, the primary composite body 30A, in which the conductive path element-forming material layers 11B have been formed in the spaces for forming conductive path elements, is then arranged between a pair of electromagnets 25 and 26, and the electromagnets 25 and 26 are operated, thereby applying a parallel magnetic field to the conductive path element-forming material layers 11B in a thickness-wise direction thereof to orient the conductive particles P dispersed in the conductive path element-forming material layers 11B in the thickness-wise direction. In this state, the conductive path element-forming material layers 11B are subjected to the curing treatment, thereby forming conductive path elements 11, thus forming a secondary composite body 30B, in which a plurality of the conductive path elements 11 are integrally provided within the through-holes 17 for forming conductive parts in each of the insulating sheet bodies 15 formed in the openings of the frame plate 31 and at opening edge portions thereof, the mask 20 for exposure is provided on the side of the one surfaces of the insulating sheet bodies 15, and the resin layer 18 for forming projected parts is provided on the side of the other surfaces of the insulating sheet bodies 15.

[Fourth step]
In this fourth step, the mask 20 for exposure is separated and removed from the one surface of the secondary composite body 30B to expose one end portions of the conductive path elements 11 so as to form the one surface-side projected parts 12. In this state, the whole of the secondary composite body 30B is immersed in a proper solvent S as illustrated in Fig. 33 to dissolve and remove the resin layer 18 for forming projected parts, thereby exposing the other end portions of the conductive path elements 11 so as to form the other surface-side projected parts 12, thus obtaining the anisotropically conductive connector 30 of the construction shown in Fig. 26.

According to the anisotropically conductive connector 30 obtained by the above-described process, the same effects as those brought about by the anisotropically conductive connector 30 described above are fundamentally achieved. In addition, the other surface-side projected parts 12B in each of the anisotropically conductive sheets 10 are formed by the specific method, so that the conductive path elements come to have the expected conductive property even when the arrangement pitch of the conductive path elements is extremely small. Accordingly, the expected electrical connection can be surely achieved with high reliability even to an object to be connected, the arrangement pitch of electrodes to be connected of which is extremely small.

The anisotropically conductive connectors according to the present invention are not limited to the above-described embodiments, and various changes or modifications may be added thereto.
For example, the anisotropically conductive connector may be so constructed that a plurality of openings are formed in the frame plate corresponding to regions, in which electrodes to be inspected in a plurality of integrated circuits selected from among integrated circuits formed on a wafer, which is an object of inspection, have been arranged, and a plurality of anisotropically conductive sheets are respectively arranged so as to close these openings. In this case, the number of the integrated circuits selected is suitably selected in view of the size of the wafer, the number of the integrated circuits formed on the wafer, the number of electrodes to be inspected in each integrated circuit, and the like, and is, for example, 16, 32, 64 or 128.
The anisotropically conductive connector may also be so constructed that a single opening is formed in the frame plate, and a single anisotropically conductive sheet is arranged so as to close the opening.
The anisotropically conductive sheet may be that of the construction shown in Fig. 1, i.e., the construction that both surfaces of the sheet are made flat.

Upon the production of, for example, an anisotropically conductive connector equipped with the anisotropically conductive sheets having the construction that the conductive path elements are formed so as to protrude from both surfaces of the insulating sheet body, the anisotropically conductive connector may further be so produced that a resin film of, for example, the same material as that forming the resin layer for forming projected parts is interposed and arranged between the upper surface-side spacer and the mask for exposure, these are superimposed on one another to pressurize them, thereby forming polymeric substance-forming material layers of the intended form in spaces for forming anisotropically conductive sheets, including internal spaces of the openings of the frame plate and internal spaces of the respective openings of the lower surface-side spacer and upper surface-side spacer, the polymeric substance-forming material layers are subjected to the curing treatment and irradiated with the laser beam through the through-holes for beam transmission from the other surface side of the mask for exposure, thereby forming through-holes for forming projected parts in the resin film and the resin layer for forming projected parts and at the same time forming through-holes for forming conductive path elements in each of the insulating sheet bases, conductive path element-forming material layers are formed within the spaces for forming conductive path elements in a state that the mask for exposure has been removed or remained arranged, the conductive path element-forming material layers are subjected to the curing treatment, thereby forming conductive path elements, and the resin film and the resin layer for forming projected parts are dissolved and removed to form the one surface-side projected parts and the other surface-side projected parts.

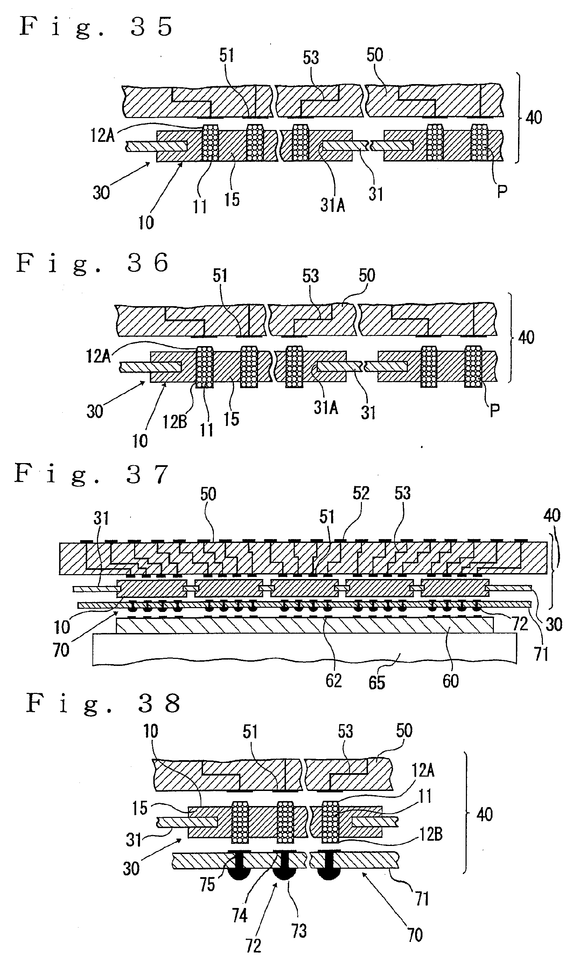

[Electrical inspection apparatus for circuit devices]
The electrical inspection apparatus for circuit devices according to the present invention will now be described taking, as an example, the case of a wafer inspection apparatus that electrical inspection is performed as to a wafer, on which a great number of integrated circuits have been formed.
Fig. 34 is a cross-sectional view illustrating the construction of a principal part of an exemplary wafer inspection apparatus according to the present invention. This wafer inspection apparatus serves to electrically inspect a wafer, on which a great number of integrated circuits each having projected electrodes to be inspected have been formed.
As also illustrated on an enlarged scale in Fig. 35, this wafer inspection apparatus has a probe 40 for circuit inspection, which is composed of a circuit board 50 for inspection, on one surface (lower surface in Figs. 34 and 35) of which a great number of inspection electrodes 51 have been formed in accordance with a pattern corresponding to a pattern of the projected electrodes to be inspected in the wafer that is an object of inspection, and an anisotropically conductive connector 30, which is arranged on one surface of the circuit board 50 for inspection and brought into contact with the wafer that is the object of inspection. A wafer mounting table 65, on which the wafer 60 that is the object of inspection is mounted, is provided at a position below the probe 40 for circuit inspection. The anisotropically conductive connector 30 has the same construction as that shown in Fig. 19 except that anisotropically conductive sheets 10 making up this anisotropically conductive connector each comprise a plurality of conductive path elements 11 each extending in a thickness-wise direction of the anisotropically conductive sheet and formed in accordance with a pattern corresponding to a pattern of electrodes to be inspected of an object of connection, for example, a circuit device to be inspected.

On the other surface (upper surface in the figure) of the circuit board 50 for inspection, a great number of connection terminals 52 connected to a tester are formed in accordance with a proper pattern. These connection terminals 52 are respectively electrically connected to the inspection electrodes 51 through internal wirings 53 in the circuit board 50 for inspection.
No particular limitation is imposed on a base material for the circuit board 50 for inspection so far as it has heat resistance, and various materials ordinarily used as base materials of printed circuit boards may be used. As specific examples thereof, may be mentioned resin materials such as glass fiber-reinforced epoxy resins, glass fiber-reinforced polyimide resins, glass fiber-reinforced bismaleimidotriazine resins, polyimide resins, aramid nonwoven fabric-reinforced epoxy resins, aramid nonwoven fabric-reinforced polyimide resins and aramid nonwoven fabric-reinforced bismaleimidotriazine resins, ceramic materials, glass materials, and metal core materials. When the wafer inspection apparatus is applied to the burn-in test, it is however preferable to use a material having a coefficient of linear thermal expansion equivalent or close to that of a material forming the wafer that is the object of inspection. Specifically, when the wafer is composed of silicon, that having a coefficient of linear thermal expansion of at most 1.5 x 10⁻⁴/K, particularly, 3 x 10⁻⁶ to 8 x 10⁻⁶/K is preferably used.

In such a wafer inspection apparatus, the inspection of the wafer 60 is carried out in the following manner.
The wafer 60, which is the object of inspection, is first arranged on the wafer mounting table 65 in such a manner that electrodes 62 to be inspected thereof are located right under the respective inspection electrodes 51 of the circuit board 50 for inspection in a state that the electrodes 62 to be inspected have been turned upward. The circuit board 50 for inspection is then pressurized downward by a proper pressurizing means, for example, whereby the anisotropically conductive sheets 10 in the anisotropically conductive connector 30 are brought into contact with the electrodes 62 to be inspected of the wafer 60, and moreover held in a state pressurized by the electrodes 62 to be inspected. By this operation, the conductive path elements 11 in the anisotropically conductive sheets 10 are elastically deformed so as to be compressed in the thickness-wise direction of the anisotropically conductive sheets corresponding to the projected height of the electrodes 62 to be inspected of the wafer 60, whereby conductive paths extending in the thickness-wise direction of the anisotropically conductive sheets 10 are respectively formed between the electrodes 62 to be inspected of the wafer 60 and the inspection electrodes 51 of the circuit board 50 for inspection by the conductive particles P in the conductive path elements 11 in the anisotropically conductive sheets 10. As a result, electrical connection between the electrodes 62 to be inspected of the wafer 60 and the inspection electrodes 51 of the circuit board 50 for inspection is achieved. Thereafter, the wafer 60 is heated to a prescribed temperature when the burn-in test is conducted. In this state, necessary electrical inspection is carried out on the wafer 60.

According to the above-described wafer inspection apparatus, the anisotropically conductive connector 30 coming into contact with the wafer 60 in the prove 40 for circuit inspection is equipped with the anisotropically conductive sheets 10 integrally provided with the conductive path elements 11 in the through-holes 17 for forming conductive paths of the insulating sheet bodies 15, said through-holes 17 having been formed by using the mask 20 for exposure in accordance with the specific method, and the anisotropically conductive sheets 10 are so formed that adjacent conductive path elements 11 are surely prevented from joining with each other even when the arrangement pitch of the conductive path elements 11 is small, and the individual conductive path elements 11 are independent of one another, so that the expected electrical connection can be surely achieved even when the pitch of electrodes 62 to be inspected of the wafer 60, which is the object of inspection, is small.

The wafer inspection apparatus according to the present invention is not limited to that of the above-described construction. For example, the anisotropically conductive connector making up the probe 40 for circuit inspection may also be that of the construction shown in Fig. 26 as illustrated in Fig. 26, i.e., the construction that the conductive path elements 11 in the anisotropically conductive sheets 10 are formed in a state protruding from both surfaces of the sheet.
According to the wafer inspection apparatus of such construction, the anisotropically conductive connector 30 coming into contact with the wafer 60 in the prove 40 for circuit inspection is equipped with the anisotropically conductive sheets 10 integrally provided with the conductive path elements 11 each having the one surface-side projected part 12A and other surface-side projected part 12B having the expected conductive property in the through-holes 17 for forming conductive paths of the insulating sheet bodies 15, said through-holes 17 having been formed by using the mask 20 for exposure in accordance with the specific method, and the anisotropically conductive sheets 10 are so formed that adjacent conductive path elements 11 are surely prevented from joining with each other even when the arrangement pitch of the conductive path elements 11 is small, and the individual conductive path elements 11 are independent of one another, so that the expected electrical connection can be more surely achieved even when the pitch of electrodes 62 to be inspected of the wafer 60, which is the object of inspection, is small.

Fig. 37 is a cross-sectional view illustrating the construction of a principal part of another exemplary wafer inspection apparatus according to the present invention. This wafer inspection apparatus serves to electrically inspect a wafer, on which a great number of integrated circuits each having flat electrodes to be inspected have been formed.
As also illustrated on an enlarged scale in Fig. 38, this wafer inspection apparatus has a probe 40 for circuit inspection, which is composed of a circuit board 50 for inspection, on one surface (lower surface in Figs. 37 and 38) of which a great number of inspection electrodes 51 have been formed in accordance with a pattern corresponding to a pattern of the electrodes to be inspected in the wafer that is an object of inspection, an anisotropically conductive connector 30 arranged on one surface of the circuit board 50 for inspection, and a sheet-like connector 70 arranged on one surface (lower surface in Figs. 37 and 38) of this anisotropically conductive connector 30. A wafer mounting table 65, on which the wafer 60 that is the object of inspection is mounted, is provided at a position below the probe 40 for circuit inspection.
The circuit board 50 for inspection has the same construction as the circuit board for inspection in the wafer inspection apparatus shown in Figs. 34 and 35, and the anisotropically conductive connector 30 is so constructed that the conductive path elements 11 in each of the anisotropically conductive sheets 10 thereof are formed in a state protruding from both surfaces of the insulating sheet body 15.

The sheet-like connector 70 has a flexible insulating sheet 71, and in this insulating sheet 71, a plurality of electrode structures 72 extending in the thickness-wise direction of the insulating sheet 71 and composed of a metal are arranged in a state separated from each other in a plane direction of the insulating sheet 71 in accordance with a pattern corresponding to the pattern of the inspection electrodes 51 of the circuit board 50 for inspection, i.e., a pattern corresponding to the pattern of the electrodes 62 to be inspected of the wafer 60 that is the object of inspection. Each of the electrode structures 72 is formed by integrally connecting a projected front-surface electrode part 73 exposed to a front surface (lower surface in the figure) of the insulating sheet 71 and a plate-like back-surface electrode part 74 exposed to a back surface of the insulating sheet 71 to each other by a short circuit part 75 extending through in the thickness-wise direction of the insulating sheet 71.
The sheet-like connector 70 is arranged in such a manner that the electrode structures 72 thereof are located on the respective conductive path elements 11 in each of the anisotropically conductive sheets 10 of the anisotropically conductive connector 30.

No particular limitation is imposed on the insulating sheet 71 in the sheet-like connector 70 so far as it has insulating property and is flexible. For example, a resin sheet formed of a polyimide resin, liquid crystal polymer, polyester, fluorocarbon resin or the like, or a sheet obtained by impregnating a cloth woven by fibers with any of the above-described resins may be used.
No particular limitation is also imposed on the thickness of the insulating sheet 71 so far as such an insulating sheet 71 is flexible. However, it is preferably 10 to 50 µm, more preferably 10 to 25 µm.

As the metal for forming the electrode structures 72, may be used nickel, copper, gold, silver, palladium, iron or the like. The electrode structures 72 may be any of those formed of a simple metal, those formed of an alloy of at least two metals and those obtained by laminating at least two metals.
On the surfaces of the front-surface electrode part 73 and back-surface electrode part 74 in each of the electrode structures 72, a film of a chemically stable metal having high conductivity, such as gold, silver or palladium is preferably formed in that oxidation of the electrode parts is prevented, and electrode parts small in contact resistance are obtained.

The projected height of the front-surface electrode part 73 in the electrode structure 72 is preferably 15 to 50 µm, more preferably 20 to 35 µm in that stable electrical connection to the electrode 62 to be inspected of the wafer 60 can be achieved. The diameter of the front-surface electrode part 73 is preset according to the size and pitch of the electrodes 62 to be inspected of the wafer 60. However, it is, for example, 30 to 80 µm, preferably 30 to 65 µm.
The diameter of the back-surface electrode part 74 in the electrode structure 72 may be greater than the diameter of the short circuit part 75 but smaller than the arrangement pitch of the electrode structures 72 and is preferably great as much as possible. By forming such electrode structures, stable electrical connection can be surely achieved even to the conductive path elements 11 in each of the anisotropically conductive sheets 10 in the anisotropically conductive connector 30. The thickness of the back-surface electrode part 74 is preferably 20 to 50 µm, more preferably 35 to 50 µm in that sufficiently high strength and excellent repetitive durability are achieved.
The diameter of the short circuit part 75 in the electrode structure 72 is preferably 30 to 80 µm, more preferably 30 to 65 µm in that sufficiently high strength is achieved.

The sheet-like connector 70 can be produced, for example, in the following manner.
Namely, a laminate material obtained by laminating a metal layer on an insulating sheet 71 is provided, and a plurality of through-holes extending through in a thickness-wise direction of the insulating sheet 71 are formed in the insulating sheet 71 of the laminate material in accordance with a pattern corresponding to a pattern of electrode structures 72 to be formed by, for example, laser beam machining, dry etch machining or the like. This laminate material is then subjected to photolithography and plating treatment, whereby short circuit parts 75 integrally connected to the metal layer are formed in the through-holes in the insulating sheet 71, and at the same time, projected front-surface electrode parts 73 integrally connected to the respective short circuit parts 75 are formed on a front surface of the insulating sheet 71. Thereafter, the metal layer of the laminate material is subjected to a photo-etching treatment to remove a part thereof, thereby forming back-surface electrode parts 74 to form the electrode structures 72, thus obtaining the sheet-like connector 70.

According to such a wafer inspection apparatus, the probe 40 for circuit inspection is equipped with the sheet-like connector 70, whereby electrical connection can be achieved fundamentally with high reliability. In addition, the anisotropically conductive connector 30 coming into contact with the wafer 60 in the prove 40 for circuit inspection is equipped with the anisotropically conductive sheets 10 integrally provided with the conductive path elements 11 in the through-holes 17 for forming conductive paths of the insulating sheet bodies 15, said through-holes 17 having been formed by using the mask 20 for exposure in accordance with the specific method, the anisotropically conductive sheets 10 are so formed that adjacent conductive path elements 11 are surely prevented from joining with each other even when the arrangement pitch of the conductive path elements 11 is small, and the individual conductive path elements 11 are independent of one another, and all the one surface-side projected parts 12A and the other surface-side projected parts 12B in the conductive path elements 11 are formed as those having necessary conductive property without being broken off, so that the expected electrical connection can be surely achieved even when the pitch of electrodes 62 to be inspected of the wafer 60, which is the object of inspection, is small.

The probes for circuit inspection and electrical inspection apparatus for circuit devices according to the present invention are not limited to the above-described embodiments, and various changes or modifications may be added thereto.
For example, the circuit devices that are the object of inspection are not limited to wafers, on which a great number of integrated circuits have been formed, and the probes and inspection apparatus may be applied to inspection apparatus for semiconductor integrated circuit devices, such as semiconductor chips, and packaged ICMCM such as BGA and CSP, and circuits formed on printed circuit boards or the like.

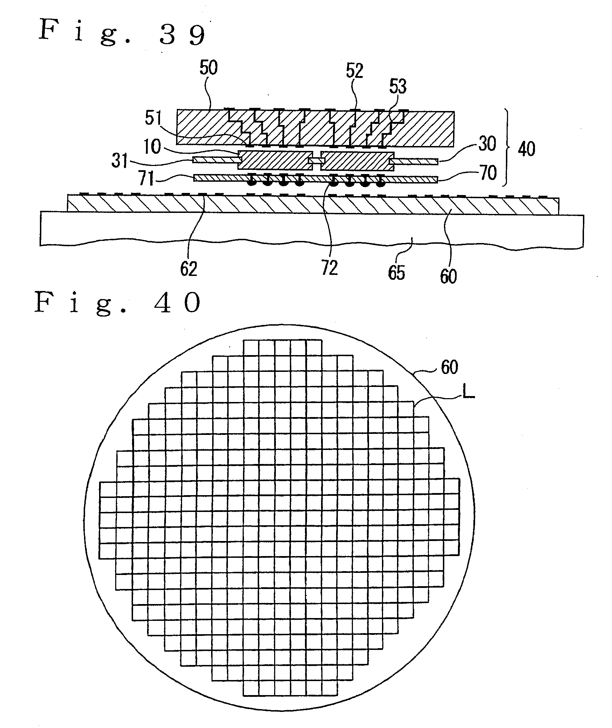

Although eath of the probe 40 for circuit inspection shown in Fig. 35, the probe 40 for circuit inspection shown in Fig. 36 and the probe 40 for circuit inspection shown in Fig. 38 serves to collectively achieve electrical connection to the electrodes 62 to be inspected of all the integrated circuits formed on the wafer 60, they may be those electrically connected to electrodes 62 to be inspected of a plurality of integrated circuits selected from among all the integrated circuits formed on the wafer 60 as illustrated in Fig. 39. The number of the integrated circuits selected is suitably selected in view of the size of the wafer 60, the number of the integrated circuits formed on the wafer 60, the number of electrodes to be inspected in each integrated circuit, and the like, and is, for example, 16, 32, 64 or 128.
In a wafer inspection apparatus having such a probe 40 for circuit inspection, the probe 40 for circuit inspection is electrically connected to electrodes 62 to be inspected of a plurality of integrated circuits selected from among all the integrated circuits formed on the wafer 60 to conduct inspection. Thereafter, the probe 40 for circuit inspection is electrically connected to electrodes 62 to be inspected of a plurality of integrated circuits selected from among the other integrated circuits to conduct the inspection. This process is repeated, whereby the electrical inspection can be conducted as to all the integrated circuits formed on the wafer 60.

### EXAMPLES

The present invention will hereinafter be described specifically by the following examples. However, the present invention is not limited to these examples.

<Example 1>
[Preparation of conductive path element-forming material]
Conductive particles, which will be described subsequently, were added and mixed in a proportion of 30% in terms of a volume fraction into 10 g of addition type liquid silicone rubber that is a polymeric substance-forming material, and the resultant mixture was then subjected to a defoaming treatment by pressure reduction, thereby preparing a conductive path element-forming material.
As the conductive particles, were used those obtained by using nickel particles having an average particle diameter of 10 µm as core particles and subjecting the core particles to chemical plating with gold so as to give a coating amount of 30% by weight based on the weight of the core particles.

[Production of mask for exposure]
A resist layer was formed on one surface of a mask base (having dimensions of 230 mm in a vertical direction and 230 mm in a lateral direction) composed of copper and having a thickness of 18 µm, a positive film mask, in which openings each having dimensions of 220 µm in a vertical direction and 75 µm in a lateral direction had been formed so as to align at a pitch of 100 µm in the lateral direction and a clearance of 6.34 mm in the vertical direction, was arranged on the one surface of the mask base to conduct an exposure treatment, and a development treatment was then conducted to form patterned holes in the resist layer. Thereafter, the mask base was subjected to a spray-etching treatment with an etchant comprising ferric chloride as a principal component at 45°C from the side of the one surface of the mask base, thereby forming a great number of through-holes for beam transmission. The resist layer was then removed, thereby obtaining a mask for exposure.
The through-holes for beam transmission in this mask for exposure each have a form forming an internal space of a substantially truncated pyramidal form that an opening in one surface has dimensions of 220 µm in the vertical direction and 75 µm in the lateral direction, and an opening in the other surface has dimensions of 200 µm in the vertical direction and 60 µm in the lateral direction (an opening diameter ratio being 0.8). The total number of the through-holes for beam transmission is 19,650. The through-holes for beam transmission are arranged so as to align at a pitch of 100 µm in the lateral direction and a clearance of 6.34 mm in the vertical direction.

[Production of anisotropically conductive sheet]
The mask for exposure obtained in the above-described manner was arranged in such a manner that the one surface thereof comes into contact with one surface of an insulating sheet base composed of a cured product of addition type liquid silicone rubber and having a thickness of 100 µm, and the insulating sheet base was irradiated with a laser beam under the following conditions through a plurality of the through-holes for beam transmission from the other surface side of the mask for exposure by means of a laser beam machine "Impact L-500" (manufactured by Sumitomo Heavy Industries, Ltd.), thereby forming an insulating sheet body having a plurality of through-holes for forming conductive paths, each extending through in a thickness-wise direction of the sheet body.
Each of the through-holes for forming conductive paths in the insulating sheet body at one surface thereof was in a form of a substantially truncated pyramid that the diameter becomes gradually small from one surface toward the other surface, the size of an opening diameter a in the one surface was maximum, and an opening diameter ratio a/b of the size of the opening diameter a in the one surface to the size an opening diameter b in the other surface was 1.2.

[Conditions for irradiation of laser beam]
- Laser species: TEA-CO₂
- Frequency (pulse number per second): 50 Hz
- Pattern (beam width): 0.9 x 1.9 mm
- Scanning speed (stage travel speed in the laser beam machine): 814 mm/min
- Voltage (excitation voltage): 20 kV
- Energy density (energy of laser beam irradiated per unit area): 11 J/cm²
- The number of scans: 4

The conductive path element-forming material prepared above was then applied on to one surface of the thus-obtained insulating sheet body within a chamber, the atmosphere in which had been controlled to a reduced pressure of 1 x 10⁻⁴ atm. Thereafter, the pressure of the atmosphere within the chamber was raised to, for example, an atmospheric pressure, thereby charging the conductive path element-forming material into the through-holes for forming conductive paths, thus forming conductive path element-forming material layers in the respective through-holes for forming conductive paths.
Thereafter, the insulating sheet body, in which the conductive path element-forming material layers had been formed in the respective through-holes for forming conductive paths, was arranged between a pair of electromagnets equipped with a heater, and the electromagnets were operated, whereby a parallel magnetic field of 2.2 T (teslas) on the average was applied to the conductive path element-forming material layers in the thickness-wise direction thereof, and the conductive path element-forming material layers were subjected to a heat treatment at 100°C for 1 hour while applying the parallel magnetic field, thereby curing the conductive path element-forming material layers to form conductive path elements integrally provided in the through-holes for forming conductive paths, thus producing an anisotropically conductive sheet of the construction shown in Fig. 1. This anisotropically conductive sheet will hereinafter be referred to as "Anisotropically Conductive Sheet (A)".

The thus-obtained Anisotropically Conductive Sheet (A) is such that its thickness is 100 µm, both surfaces thereof are flat, and columnar conductive path elements of a substantially rectangular sectional form having dimensions of 200 µm in a vertical direction and 60 µm in a lateral direction are arranged therein at a pitch of 100 µm. The proportion of the conductive particles in each of the conductive path elements was 30% in terms of a volume fraction.

<Example 2>
An anisotropically conductive sheet of the construction shown in Fig. 9 was produced in the same manner as in Example 1 except that the conductive path element-forming material was applied on to the other surface of the mask for exposure in a state that the mask for exposure had remained arranged on the one surface of the insulating sheet body, whereby conductive path element-forming material layers were formed in the interiors of the respective through-holes for forming conductive paths in the insulating sheet body and the interiors of the respective through-holes for beam transmission in the mask for exposure, and the conductive path element-forming material layers were subjected to the curing treatment, thereby forming conductive path elements integrally provided in the through-holes for forming conductive paths in the insulating sheet body and each having a (one surface-side) projected part protruding from the one surface of the insulating sheet body. This anisotropically conductive sheet will hereinafter be referred to as "Anisotropically Conductive Sheet (B)".

The thus-obtained Anisotropically Conductive Sheet (B) is such that the conductive path elements are arranged at a pitch of 100 µm, a thickness at a portion where the conductive path element was formed is 118 µm, and the projected height of the conductive path element is 18 µm. Each of the conductive path elements is also such that the dimensions thereof are 200 µm in a vertical direction and 60 µm in a lateral direction in the interior of the insulating sheet body. The proportion of the conductive particles in each of the conductive path elements was 30% in terms of a volume fraction.

<Example 3>
[Preparation of resin layer-forming material]
To 285 g of purified water was added 15 g of powder of polyvinyl alcohol having a weight average polymerization degree of 2,000, and the resultant mixture was stirred at 80°C, thereby preparing a resin layer-forming material composed of an aqueous polyvinyl alcohol solution containing polyvinyl alcohol at a concentration of 5% by weight.

[Production of anisotropically conductive sheet]
The resin layer-forming material prepared above was applied on to the other surface of an insulating sheet base composed of a cured product of addition type liquid silicone rubber and having a thickness of 100 µm, and the resultant coating film was dried at 40°C, thereby forming a resin layer for forming projected parts having a thickness of 25 µm to prepare a laminate composed of the insulating sheet base and the resin layer for forming projected parts integrally provided.
The above-described mask for exposure was arranged in such a manner that the one surface thereof comes into contact with one surface of the insulating sheet base in the composite body, and the insulating sheet base was irradiated with a laser beam under the following conditions through a plurality of the through-holes for beam transmission from the other surface side of the mask for exposure by means of the laser beam machine "Impact L-500" (manufactured by Sumitomo Heavy Industries, Ltd.), thereby forming a plurality of through-holes for forming conductive paths, each extending through in a thickness-wise direction of the insulating sheet base, in the insulating sheet base, and at the same time forming a plurality of through-holes for forming projected parts, each extending continuously with its corresponding through-hole for forming a conductive path in the thickness-wise direction, in the resin layer for forming projected parts, thus forming a primary composite body with the resin layer for forming projected parts provided on the other surface of an insulating sheet body.
Each of the through-holes for forming conductive paths and each of the through-holes for forming projected parts were both in a form of a substantially truncated pyramid that the diameter becomes gradually small from one surface toward the other surface, the size of an opening diameter a in the one surface of the insulating sheet body was maximum, and an opening diameter ratio a/b of the size of the opening diameter a in the one surface in the insulating sheet body to the size an opening diameter b in the other surface of the resin layer for forming projected parts was 1.2.

[Conditions for irradiation of laser beam]
- Laser species: TEA-CO₂
- Frequency (pulse number per second): 50 Hz
- Pattern (beam width): 0.5 x 1.92 mm
- Scanning speed (stage travel speed in the laser beam machine): 1,192 mm/min
- Voltage (excitation voltage): 20 kV
- Energy density (energy of laser beam irradiated per unit area): 12 J/cm²
- The number of scans: 4

The other surface side of the through-holes for forming conductive paths and through-holes for forming projected parts in the primary composite body was closed with a rubber sheet for sealing composed of fluorine-containing rubber within a chamber, the atmosphere in which had been controlled to a reduced pressure of 1 x 10⁻⁴ atm., and the conductive path element-forming material was then applied on to one surface of the primary composite body by means of a mask for printing in a state that the mask for exposure had remained arranged on the one surface of the composite body. Thereafter, the pressure of the atmosphere within the chamber was raised to, for example, an atmospheric pressure, thereby charging the conductive path element-forming material into spaces for forming conductive path elements, including internal spaces of the respective through-holes for beam transmission in the mask for exposure, internal spaces of the respective through-holes for forming conductive paths in the insulating sheet body and internal spaces of the respective through-holes for forming projected parts in the resin layer for forming projected parts, to form conductive path element-forming material layers within the spaces for forming conductive path elements.
Thereafter, the primary composite body, in which the conductive path element-forming material layers had been formed within the respective spaces for forming conductive path elements, was arranged between a pair of electromagnets equipped with a heater in a state supported by an upper side pressurizing plate and a lower side pressurizing plate, which were respectively arranged on one surface and the other surface of the composite body, composed of iron and each had a thickness of 6 mm, and the electromagnets were operated, whereby a parallel magnetic field of 2.2 T (teslas) on the average was applied to the conductive path element-forming material layers in the thickness-wise direction thereof, and the conductive path element-forming material layers were subjected to a heat treatment at 100°C for 1 hour while applying the parallel magnetic field, thereby curing the conductive path element-forming material layers to form a secondary composite body composed of the laminate of the mask for exposure, the insulating sheet body and the resin layer for forming projected parts, in which the conductive path element-forming material layers had been formed within the spaces for forming conductive path elements.

The mask for exposure was then separated and removed from the secondary composite body, thereby forming one surface-side projected parts. In this state, the whole of the secondary composite body was immersed in hot water of 80°C and left to stand for 3 hours to dissolve and remove the resin layer for forming projected parts, thereby forming the other surface-side projected parts, thus producing an anisotropically conductive sheet of the construction shown in Fig. 12. This anisotropically conductive sheet will hereinafter be referred to as "Anisotropically Conductive Sheet (C)".

The thus-obtained Anisotropically Conductive Sheet (C) is such that the conductive path elements are arranged at a pitch of 100 µm, a thickness at a portion where the conductive path element was formed is 143 µm, the projected height of the one surface-side projected part of the conductive path element is 18 µm, and the projected height of the other surface-side projected part of the conductive path element is 25 µm. Each of the conductive path elements is also such that the dimensions thereof are 200 µm in a vertical direction and 60 µm in a lateral direction in the interior of the insulating sheet body. The proportion of the conductive particles in each of the conductive path elements was 30% in terms of a volume fraction.

With respect to Anisotropically Conductive Sheet (A) according to Example 1, Anisotropically Conductive Sheet (B) according to Example 2 and Anisotropically Conductive Sheet (C) according to Example 3, an electric resistance between adjacent conductive path elements was measured. As a result, the electric resistance was 1 x 10¹⁴ Ω or higher in any sheet of Anisotropically Conductive Sheet (A), Anisotropically Conductive Sheet (B) and Anisotropically Conductive Sheet (C), and so it was confirmed that the conductive path elements are formed in a state that sufficient insulating property has been secured between adjacent conductive path elements.
Each of Anisotropically Conductive Sheet (A), Anisotropically Conductive Sheet (B) and Anisotropically Conductive Sheet (C) was pressurized in its thickness-wise direction in such a manner that a load of 5 g is applied per conductive path element, and an electric resistance of the conductive path elements was measured in this state. As a result, the electric resistance was 60 mΩ in any of Anisotropically Conductive Sheet (A), Anisotropically Conductive Sheet (B) and Anisotropically Conductive Sheet (C), and so it was confirmed that good pressure-sensitive conductivity is achieved.

<Comparative Example 1>
A comparative anisotropically conductive sheet was produced in the same manner as in Example 1 except that the mask for exposure was arranged in such a manner that the other surface thereof comes into contact with the one surface of the insulating sheet base in Example 1, and the insulating sheet base was irradiated with the laser beam through a plurality of the through-holes for beam transmission in the mask for exposure from the one surface side of the mask for exposure, thereby forming through-holes for forming conductive path elements.
The thus-obtained comparative anisotropically conductive sheet is such that each of the conductive path elements is in a tapered form (truncated pyramidal form) that it becomes gradually wide from one surface toward the other surface, i.e., has dimensions of 200 µm long and 60 µm broad at one surface thereof, and 240 µm long and 100 µm broad at the other surface.
With respect to the thus-obtained comparative anisotropically conductive sheet, an electric resistance between adjacent conductive path elements was measured. As a result, the electric resistance was 0.3 to 10 Ω, and so it was confirmed that sufficient insulating property is not achieved between adjacent conductive path elements. Insulating sheet body portions between adjacent conductive path elements were also observed. As a result, it was confirmed that portions where conductive path elements are formed joining with each other are present at the other surface of the anisotropically conductive sheet, and so the individual conductive path elements cannot be formed independently of one another, and the resulting anisotropically conductive sheet cannot be used in electrical inspection for circuit devices.

<Comparative Example 2>
A comparative anisotropically conductive sheet was produced in the same manner as in Example 3 except that the mask for exposure was arranged in such a manner that the other surface thereof comes into contact with the one surface of the insulating sheet base in Example 3, the insulating sheet base was irradiated with the laser beam through a plurality of the through-holes for beam transmission in the mask for exposure from the one surface side of the mask for exposure, thereby forming through-holes for forming conductive path elements in the insulating sheet base to form an insulating sheet body, masks for printing, in which openings had been formed in accordance with a pattern of conductive path elements to be formed, were arranged on both surfaces of the insulating sheet body to form conductive path element-forming material layers within spaces for forming conductive path elements, including internal spaces of the openings in the masks for printing and internal spaces of the through-holes for forming conductive paths in the insulating sheet base, the conductive path element-forming material layers were subjected to the curing treatment, thereby forming conductive path elements integrally provided in the insulating sheet body, and the masks for printing were separated and removed, thereby forming one surface-side projected parts and the other surface-side projected parts.
Each of the through-holes for forming conductive path elements in the insulating sheet body is in a tapered form (truncated pyramidal form) that its opening diameter, whose size in the one surface thereof is 0.2 mm long and 0.06 mm broad, and whose size in the other surface is 0.24 mm long and 0.1 mm broad, becomes gradually wide from one surface toward the other surface. The mask for printing arranged on the one surface side is such that the thickness thereof is 18 µm, and the size of each opening diameter is 200 µm long and 60 µm broad, and the mask for printing arranged on the other surface side is such that the thickness thereof is 25 µm, and the size of each opening diameter is 240 µm long and 100 µm broad.

With respect to the thus-obtained comparative anisotropically conductive sheet, an electric resistance between adjacent conductive path elements was measured. As a result, the electric resistance was 0.3 to 10 Ω, and so it was confirmed that sufficient insulating property is not achieved between adjacent conductive path elements.
Insulating sheet body portions between adjacent conductive path elements were also observed. As a result, it was confirmed that portions where conductive path elements are formed joining with each other are present, and so the individual conductive path elements cannot be formed independently of one another, and that about 0.5% of all the conductive path elements are those that one or both of their one surface-side projected parts and other surface-side projected parts are broken off.

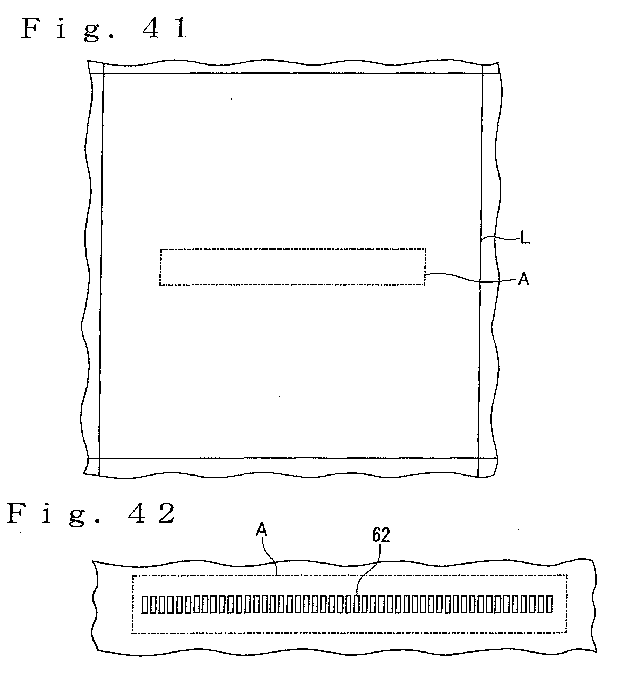

<Example 4>
[Production of wafer for evaluation]
As illustrated in Fig. 40, three hundred and ninety-three square integrated circuits in total, which each had dimensions of 8 mm x 8 mm, were formed on a wafer (60) made of silicon (coefficient of linear thermal expansion: 3.3 x 10⁻⁶/K) and having a diameter of 8 inches. Each of the integrated circuits (L) formed on the wafer (60) has a region (A) of electrodes to be inspected at its center as illustrated in Fig. 41. In the region (A) of the electrodes to be inspected, as illustrated in Fig. 42, fifty rectangular electrodes (62) to be inspected each having dimensions of 200 µm in a vertical direction (upper and lower direction in Fig. 42) and 50 µm in a lateral direction (left and right direction in Fig. 42) are arranged at a pitch of 100 µm in a line in the lateral direction. The total number of the electrodes (62) to be inspected in the whole wafer (60) is 19,650. All the electrodes to be inspected are electrically connected to a common lead electrode (not illustrated) formed at a peripheral edge of the wafer (60). This wafer will hereinafter be referred to as "Wafer W1 for evaluation".
Further, three hundred and ninety-three integrated circuits (L), which had the same construction as in the Wafer W1 for evaluation except that no common lead electrode was formed as to the fifty electrodes (62) to be inspected in each integrated circuit (L), and the electrodes to be inspected were electrically insulated from one another, were formed on a wafer (60). The total number of the electrodes to be inspected in the whole wafer is 19,650. This wafer will hereinafter be referred to as "Wafer W2 for evaluation".

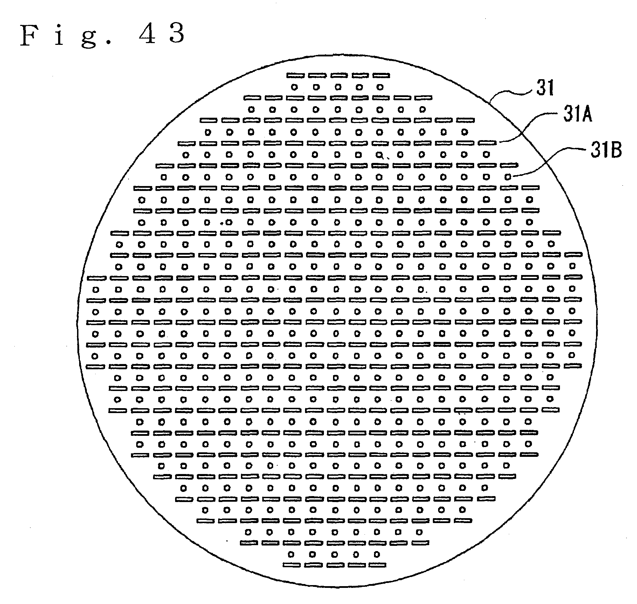

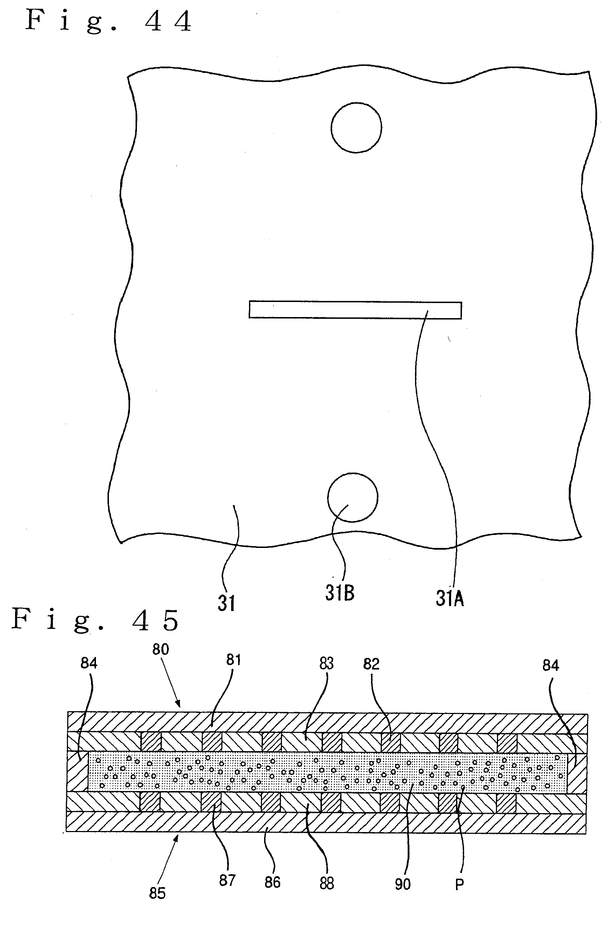

[Production of anisotropically conductive connector]
(1) Production of frame plate:
Forty frame plates (31) in total, each having a diameter of 8 inches and three hundred and ninety-three anisotropically conductive sheet-forming openings (31A) formed correspondingly to the regions of the electrodes to be inspected in Wafer W1 for evaluation, were produced under the following conditions in accordance with the construction shown in Figs. 43 and 44.
A material of such a frame plate is 42 alloy (saturation magnetization: 1.7 Wb/m²; coefficient of linear thermal expansion: 6.2 x 10⁻⁶/K), and the thickness thereof is 0.06 mm.
Each of the anisotropically conductive sheet-forming openings has dimensions of 5,000 µm in a lateral direction (left and right direction in Figs. 43 and 44) and 320 µm in a vertical direction (upper and lower direction in Figs. 43 and 44).
A circular air inflow hole (31B) having a diameter of 1,000 µm is formed at a central position between anisotropically conductive sheet-forming openings adjoining in the vertical direction.

(2) Production of spacer:
An upper side spacer and a lower side spacer for forming anisotropically conductive sheets, which each had a plurality of through-holes formed correspondingly to the regions of the electrodes to be inspected in Wafer W1 for evaluation, were produced under the following conditions. A material of these spacers is stainless steel (SUS304), and the thickness thereof is 20 µm.
The through-hole corresponding to each region of the electrodes to be inspected has dimensions of 6,000 µm in the lateral direction and 1,400 µm in the vertical direction.

(3) Production of mask for exposure:
A resist layer was formed on one surface of a mask base (having dimensions of 230 mm in a vertical direction and 230 mm in a lateral direction) composed of copper and having a thickness of 18 µm, a positive film mask, in which openings each having dimensions of 220 µm in a vertical direction and 75 µm in a lateral direction had been formed so as to align at a pitch of 100 µm in the lateral direction and a clearance of 6.34 mm in the vertical direction, was arranged on the one surface of the mask base to conduct an exposure treatment, and a development treatment was then conducted to form patterned holes in the resist layer. Thereafter, the mask base was subjected to a spray-etching treatment with an etchant comprising ferric chloride as a principal component at 45°C from the side of the one surface of the mask base, thereby forming a great number of through-holes for beam transmission. The resist layer was then removed, thereby obtaining a mask for exposure.
The through-holes for beam transmission in this mask for exposure each have a form forming an internal space of a truncated pyramidal form that an opening in one surface has dimensions of 220 µm in the vertical direction and 75 µm in the lateral direction, and an opening in the other surface has dimensions of 200 µm in the vertical direction and 60 µm in the lateral direction. The total number of the through-holes for beam transmission is 19,650. The through-holes for beam transmission are arranged so as to align at a pitch of 100 µm in the lateral direction and a clearance of 6.34 mm in the vertical direction.

(4) Production Example 1 of anisotropically conductive connector:
[Production of Anisotropically Conductive Connectors (A1) to (A10)]
The above-described frame plate, spacers and mask for exposure were used to form anisotropically conductive sheets in the frame plate in the following manner.
To and with 100 parts by weight of addition type liquid silicone rubber were added and mixed 375 parts by weight of conductive particles. Thereafter, the resultant mixture was subjected to a defoaming treatment by pressure reduction, thereby preparing a conductive path element-forming material. In this conductive path element-forming material, as the conductive particles, were used those obtained by using nickel particles having an average particle diameter of 10 µm as core particles and subjecting the core particles to chemical plating with gold so as to give a coating amount of 30% by weight based on the weight of the core particles.
As the addition type liquid silicone rubber, was used that of a two-pack type that the viscosity of Liquid A is 250 Pa·s, the viscosity of Liquid B is 250 Pa·s, and a cured product thereof has a compression set of 5% at 150°C, a durometer A hardness of 32 and tear strength of 25 kN/m.

The properties of the addition type liquid silicone rubber were determined in the following manner.
(a) Viscosity of addition type liquid silicone rubber:
   A viscosity at 23 ± 2°C was measured by a Brookfield viscometer.
(b) Compression set of cured product of silicone rubber:
   Liquid A and Liquid B in the addition type liquid silicone rubber of the two-pack type were stirred and mixed in proportions that their amounts become equal. After this mixture was then poured into a mold and subjected to a defoaming treatment by pressure reduction, a curing treatment was conducted under conditions of 120°C for 30 minutes, thereby producing a columnar body having a thickness of 12.7 mm and a diameter of 29 mm composed of a cured product of the silicone rubber. The columnar body was post-cured under conditions of 200°C for 4 hours. The columnar body thus obtained was used as a specimen to measure its compression set at 150 ± 2°C in accordance with JIS K 6249.
(c) Tear strength of cured product of silicone rubber:
   A curing treatment and post-curing of the addition type liquid silicone rubber were conducted under the same conditions as in the item (b) as above, thereby producing a sheet having a thickness of 2.5 mm. A crescent type specimen was prepared by punching from this sheet to measure its tear strength at 23 ± 2°C in accordance with JIS K 6249.
(d) Durometer A hardness:
   Five sheets produced in the same manner as in the item (c) were stacked on one another, and the resultant laminate was used as a specimen to measure its durometer A hardness at 23 ± 2°C in accordance with JIS K 6249.

[Formation of primary composite body]
A mask for printing was first arranged on a back surface supporting plate (having dimensions of 230 mm in a vertical direction and 230 mm in a lateral direction) having a thickness of 250 µm and composed of 42 alloy, and a polymeric substance-forming material composed of the above-described addition type liquid silicone rubber was applied on to the supporting plate by a printing method, thereby forming polymeric substance-forming material layers at positions corresponding to the openings for forming anisotropically conductive sheets in the frame plate on one surface of the back surface supporting plate. The mask for printing is such that a plurality of through-holes are formed at the positions corresponding to the openings for forming anisotropically conductive sheets in the frame plate in a mask base (having dimensions of 230 mm in a vertical direction and 230 mm in a lateral direction) having a thickness of 150 µm and composed of iron, and each of the through-holes has dimensions of 5,800 µm in a lateral direction and 600 µm in a vertical direction.
The back surface supporting plate, on which the polymeric substance-forming material layers have been formed, is then arranged on a flat plate-like lower side pressurizing plate composed of iron and having a thickness of 6 mm, the frame plate is arranged in alignment on this back surface supporting plate through the lower side spacer, the upper side spacer is arranged in alignment on the frame plate, the mask for exposure is further arranged in such a manner that the one surface of the mask for exposure, at which the opening diameter in each through-hole for beam transmission is greater, i.e., the surface, on which the resist layer has been formed upon the formation of the through-holes for beam transmission, comes into contact with one surface of the upper side spacer, an upper side pressurizing plate is arranged on the other surface of the mask for exposure through a releasing film, and these are pressurized in a laminating direction, thereby charging the polymeric substance-forming material into the spaces for forming anisotropically conductive sheets to form polymeric substance-forming material layers of the intended form. In this process, as the releasing film was used a Teflon (registered trademark) film having a thickness of 50 µm and dimensions of 230 mm in a vertical direction and 230 mm in a lateral direction.
In this state, a heat treatment was conducted at a temperature of 100°C for 90 minutes, thereby curing the polymeric substance-forming material layers to form insulating sheet bases in the respective openings of the frame plate. Thereafter, the upper side pressurizing plate, lower side pressurizing plate and releasing film were removed, thereby obtaining a primary composite body.

[Formation of secondary composite body]
The primary composite body obtained in the above-described manner was arranged on a working stage of a CO₂ laser beam machine "Impact L-500" (manufactured by Sumitomo Heavy Industries, Ltd.), and the insulating sheet bases provided in the respective openings of the frame plate were irradiated with a laser beam under the following conditions from the other surface side of the mask for exposure in the primary composite body, thereby forming a plurality of through-holes for forming conductive path elements in each of the insulating sheet bases. Thereafter, the back surface supporting plate was separated, thereby obtaining a secondary composite body.

[Formation of anisotropically conductive sheet]
The secondary composite body obtained in the above-described manner was arranged on a printing stage through a rubber sheet for sealing within a chamber of a vacuum printing machine, the above-described mask for printing was further arranged in alignment on the secondary composite body, and the pressure within the chamber of the vacuum printing machine was then reduced to 1 x 10⁻⁴ atm. In this state, the conductive path element-forming material was applied by screen printing, and the pressure of the atmosphere within the chamber was raised to an atmospheric pressure, thereby charging the conductive path element-forming material into internal spaces of the through-holes for forming conductive path elements and internal spaces of the through-holes for beam transmission in the mask for exposure. Thereafter, the mask for printing was removed, and the conductive paste material excessively remaining on the mask for exposure was removed by means of a squeegee, thereby forming conductive path element-forming material layers.
Thereafter, the secondary composite body, in which the conductive path element-forming material layers had been formed in the spaces for forming conductive path elements, was arranged between a pair of electromagnets equipped with a heater in a state supported by an upper side pressurizing plate and a lower side pressurizing plate, which were respectively arranged on one surface and the other surface of the composite body, composed of iron and each had a thickness of 6 mm, and the electromagnets were operated, whereby a parallel magnetic field of 2.2 T (teslas) on the average was applied to the conductive path element-forming material layers in the thickness-wise direction thereof, and the conductive path element-forming material layers were pressurized by pressing force of 2.3 kg/cm² and subjected to a heat treatment at 100°C for 1 hour while applying the parallel magnetic field, thereby orienting the conductive particles so as to align in the thickness-wise direction and curing the conductive path element-forming material layers to form anisotropically conductive sheets with conductive path elements integrally provided in respective insulating sheet bodies, thus producing an anisotropically conductive connector according to the present invention.

The anisotropically conductive sheets in the thus-obtained anisotropically conductive connector will be described specifically. Each of the anisotropically conductive sheets has dimensions of 6,000 µm in a lateral direction and 1,400 µm in a vertical direction. In each of the anisotropically conductive sheets, fifty conductive path elements corresponding to the electrodes to be inspected in Wafer W1 for evaluation are arranged at a pitch of 100 µm in a line. Each of the conductive path elements is in a columnar form of a rectangle in section that the thickness is 118 µm, and the dimensions are 60 µm in the lateral direction and 200 µm in the vertical direction. The thickness of the insulating sheet body portion mutually insulating the conductive path elements is 100 µm. A ratio (T2/T1) of the thickness T1 of the insulating sheet body portion to the thickness T2 of each of the conductive path elements is 1.18. The thickness (thickness of one of the forked portions) of a portion supported by the frame plate in each of the anisotropically conductive sheets is 20 µm.

Anisotropically conductive sheets were respectively formed in ten frame plates in the above-described manner to produce ten anisotropically conductive connectors in total. These anisotropically conductive connectors will hereinafter be referred to as Anisotropically Conductive Connector (A1) to Anisotropically Conductive Connector (A10).

[Production of comparative Anisotropically Conductive Connectors (B1) to (B10)]
Ten comparative anisotropically conductive connectors in total were produced in the same manner as in the production process of Anisotropically Conductive Connectors (A1) to (A10) except that the mask for exposure was arranged in such a manner that the other surface of the mask for exposure, at which the opening diameter in each through-hole for beam transmission is smaller, i.e., the surface opposite to the surface, on which the resist layer has been formed upon the formation of the through-holes for beam transmission, comes into contact with the one surface of the upper side spacer to form a primary composite body. These anisotropically conductive connectors will hereinafter be referred to as Anisotropically Conductive Connector (B1) to Anisotropically Conductive Connector (B10).
The anisotropically conductive sheets in the thus-obtained Anisotropically Conductive Connectors (B1) to (B10) will be described specifically. Each of the anisotropically conductive sheets has dimensions of 6,000 µm in a lateral direction and 1,200 µm in a vertical direction. In each of the anisotropically conductive sheets, fifty conductive path elements corresponding to the electrodes to be inspected in Wafer W1 for evaluation are arranged at a pitch of 100 µm in a line. Each of the conductive path elements has a sectional form that the thickness is 118 µm, and the dimensions are within a range of about 70 to 80 µm in the lateral direction and within a range of 210 to 220 µm in the vertical direction. The thickness of the insulating sheet body portion mutually insulating the conductive path elements is 100 µm. A ratio (T2/T1) of the thickness T1 of the insulating sheet body portion to the thickness T2 of each of the conductive path elements is 1.18. The thickness (thickness of one of the forked portions) of a portion supported by the frame plate in each of the anisotropically conductive sheets is 20 µm.

(5) Production Example 2 of anisotropically conductive connector:
[Production of Anisotropically Conductive Connectors (C1) to (C10)]
The above-described frame plate, spacers and mask for exposure were used to form anisotropically conductive sheets in the frame plate in the following manner.

First, 15 g of powder of polyvinyl alcohol having a weight average polymerization degree of 2,000 was added to 285 g of purified water, and the resultant mixture was stirred at 80°C, thereby preparing a resin layer-forming material composed of an aqueous polyvinyl alcohol solution containing polyvinyl alcohol at a concentration of 5% by weight.

[Formation of primary composite body]
The resin layer-forming material prepared above was then applied on to a supporting plate (having dimensions of 230 mm in a vertical direction and 230 mm in a lateral direction) having a thickness of 250 µm and composed of 42 alloy, and the resultant coating film was dried at 40°C, thereby forming a resin layer for forming projected parts having a thickness of 25 µm to prepare a laminate. A mask for printing was arranged on one surface of the resin layer for forming projected parts in the laminate to apply a polymeric substance-forming material composed of the above-described addition type liquid silicone rubber by a printing method, thereby forming polymeric substance-forming material layers at positions corresponding to the openings for forming anisotropically conductive sheets in the frame plate. The mask for printing used in forming polymeric substance-forming material layers is such that a plurality of through-holes are formed at the positions corresponding to the openings for forming anisotropically conductive sheets in the frame plate in a mask base (having dimensions of 230 mm in a vertical direction and 230 mm in a lateral direction) having a thickness of 150 µm and composed of iron, and each of the through-holes has dimensions of 5,800 µm in a lateral direction and 600 µm in a vertical direction.
The polymeric substance-forming material composed of the above-described addition type liquid silicone rubber was applied on to the one surface of the mask for exposure by a printing method in a state that the mask for exposure had been arranged on the other surface of a releasing film composed of a Teflon (registered trademark) film having a thickness of 50 µm and dimensions of 230 mm in a vertical direction and 230 mm in a lateral direction in such a manner that the other surface of the mask comes into contact therewith, thereby forming polymeric substance-forming material layers at the positions corresponding to the openings for forming anisotropically conductive sheets in the frame plate in a state charged into the through-holes for beam transmission in the mask for exposure.
Thereafter, the laminate, in which the polymeric substance-forming material layers had been formed, was arranged on a flat plate-like lower side pressurizing plate composed of iron and having a thickness of 6 mm, the frame plate was arranged in alignment on one surface of the laminate through the lower side spacer, the upper side spacer was arranged in alignment on the frame plate, the laminate composed of the mask for exposure, on which the polymeric substance-forming material layers had been formed, and the releasing film was further arranged to one surface of the upper side spacer in such a manner that the one surface of the mask for exposure, at which the opening diameter in each through-hole for beam transmission is greater, i.e., the surface, on which the resist layer has been formed upon the formation of the through-holes for beam transmission, faces one surface of the upper side spacer, a flat plate-like upper side pressurizing plate was arranged on one surface of the releasing film, and these were pressurized in a laminating direction, thereby charging the polymeric substance-forming material into the spaces for forming anisotropically conductive sheets to form polymeric substance-forming material layers of the intended form.
In this state, a heat treatment was conducted at a temperature of 100°C for 90 minutes, thereby curing the polymeric substance-forming material layers to form insulating sheet bases in the respective openings of the frame plate. The laminate was arranged on a working stage of a CO₂ laser beam machine "Impact L-500" (manufactured by Sumitomo Heavy Industries, Ltd.) in a state that the upper side pressurizing plate, lower side pressurizing plate and releasing film had been removed, and the insulating sheet bases provided in the respective openings of the frame plate were irradiated with a laser beam under the following conditions from the other surface side of the mask for exposure, thereby forming a plurality of through-holes for forming conductive path elements, each extending through in the thickness-wise direction, in each of the insulating sheet bases, and at the same time forming through-holes for forming projected parts, each extending continuously with its corresponding through-hole for forming a conductive path in the thickness-wise direction, in the resin layer for forming projected parts. Thereafter, the supporting plate was separated, thereby obtaining a primary composite body.

[Formation of secondary composite body]
The primary composite body obtained in the above-described manner was arranged on a printing stage through a rubber sheet for sealing composed of fluorine-containing rubber within a chamber of a vacuum printing machine, the above-described mask for printing was further arranged in alignment on the primary composite body, and the pressure within the chamber of the vacuum printing machine was then reduced to 1 x 10⁻⁴ atm. In this state, the conductive path element-forming material was applied by screen printing, and the pressure of the atmosphere within the chamber was raised to an atmospheric pressure, thereby charging the conductive path element-forming material into spaces for forming conductive path elements, including internal spaces of the through-holes for beam transmission in the mask for exposure, internal spaces of the through-holes for forming conductive path elements and internal spaces of the through-holes for forming projected parts in the resin layer for forming projected parts. Thereafter, the mask for printing was removed, and the conductive path element-forming material excessively remaining on the mask for exposure was removed by means of a squeegee, thereby forming conductive path element-forming material layers.
The primary composite body, in which the conductive path element-forming material layers had been formed in the spaces for forming conductive path elements, was arranged between a pair of electromagnets equipped with a heater in a state supported by an upper side pressurizing plate and a lower side pressurizing plate, which were respectively arranged on one surface and the other surface of the composite body, composed of iron and each had a thickness of 6 mm, and the electromagnets were operated, whereby a parallel magnetic field of 2.2 T (teslas) on the average was applied to the conductive path element-forming material layers in the thickness-wise direction thereof, and the conductive path element-forming material layers were pressurized by pressing force of 2.3 kg/cm² and subjected to a heat treatment at 100°C for 1 hour while applying the parallel magnetic field, thereby orienting the conductive particles so as to align in the thickness-wise direction and curing the conductive path element-forming material layers to form conductive path elements, thus obtaining a secondary composite body.

[Formation of anisotropically conductive sheet]
The mask for exposure was then separated and removed from the secondary composite body, thereby forming one surface-side projected parts of the respective conductive path elements. In this state, the whole of the secondary composite body was immersed in hot water of 80°C and left to stand for 3 hours to dissolve and remove the resin layer for forming projected parts, thereby forming the other surface-side projected parts of the respective conductive path elements, thus producing anisotropically conductive sheets, in each of which the conductive path elements were provided in a state protruding from both surfaces of the insulating sheet body, thus producing an anisotropically conductive connector according to the present invention.

The anisotropically conductive sheets in the thus-obtained anisotropically conductive connector will be described specifically. Each of the anisotropically conductive sheets has dimensions of 6,000 µm in a lateral direction and 1,400 µm in a vertical direction.
In each of the anisotropically conductive sheets, fifty conductive path elements corresponding to the electrodes to be inspected in Wafer W1 for evaluation are arranged at a pitch of 100 µm in a line. Each of the conductive path elements is in a columnar form of a rectangle in section that the thickness is 143 µm, and the dimensions are 60 µm in the lateral direction and 200 µm in the vertical direction. The thickness of the insulating sheet body portion mutually insulating the conductive path elements is 100 µm. A ratio (T2/T1) of the thickness T1 of the insulating sheet body portion to the thickness T2 of each of the conductive path elements is 1.43. The thickness (thickness of one of the forked portions) of a portion supported by the frame plate in each of the anisotropically conductive sheets is 20 µm.

Anisotropically conductive sheets were respectively formed in ten frame plates in the above-described manner to produce ten anisotropically conductive connectors in total. These anisotropically conductive connectors will hereinafter be referred to as Anisotropically Conductive Connector (C1) to Anisotropically Conductive Connector (C10).

[Production of comparative Anisotropically Conductive Connectors (D1) to (D10)]
Ten comparative anisotropically conductive connectors in total were produced in the same manner as in the production process of Anisotropically Conductive Connectors (C1) to (C10) except that no resin layer for forming projected parts was provided on one surface of the supporting plate in the production process of Anisotropically Conductive Connectors (C1) to (C10), the polymeric substance-forming material was charged into the spaces for forming anisotropically conductive sheets in a state that no mask for exposure was arranged to form polymeric substance-forming material layers of the intended form, the curing treatment was conducted to form insulating sheet bases, the mask for exposure was then arranged in such a manner that the other surface of the mask for exposure, at which the opening diameter in each through-hole for beam transmission is smaller, i.e., the surface opposite to the surface, on which the resist layer has been formed upon the formation of the through-holes for beam transmission, comes into contact with the one surfaces of the insulating sheet bases, the insulating sheet bases were irradiated with the laser beam from the one surface side of the mask for exposure, thereby forming through-holes for forming conductive paths, masks for printing, in which openings had been formed in accordance with a pattern corresponding to a pattern of the through-holes for forming conductive paths, were arranged on both surfaces of the insulating sheet bodies to form conductive path element-forming material layers within spaces for forming conductive path elements, including internal spaces of the openings in the masks for printing and internal spaces of the through-holes for forming conductive paths in the insulating sheet bodies, the conductive path element-forming material layers were subjected to the curing treatment, thereby forming conductive path elements, and the masks for printing were separated and removed, thereby forming one surface-side projected parts and the other surface-side projected parts, thus producing anisotropically conductive sheets, in each of which the conductive path elements were provided in a state protruding from both surfaces of the insulating sheet body. These anisotropically conductive connectors will hereinafter be referred to as Anisotropically Conductive Connector (D1) to Anisotropically Conductive Connector (D10).
The anisotropically conductive sheets in the thus-obtained Anisotropically Conductive Connectors (D1) to (D10) will be described specifically. Each of the anisotropically conductive sheets has dimensions of 6,000 µm in a lateral direction and 1,200 µm in a vertical direction. In each of the anisotropically conductive sheets, fifty conductive path elements corresponding to the electrodes to be inspected in Wafer W1 for evaluation are arranged at a pitch of 100 µm in a line. In each of the anisotropically conductive sheets, a thickness at a portion where the conductive path element was formed is within a range of 133 to 143 µm, and each of the conductive path elements has a sectional form that the dimensions thereof are within a range of about 70 to 80 µm in the lateral direction and within a range of 210 to 220 µm in the vertical direction in the interior of the insulating sheet body. The thickness of the insulating sheet body portion mutually insulating the conductive path elements is 100 µm. A ratio (T2/T1) of the thickness T1 of the insulating sheet body portion to the thickness T2 of each of the conductive path elements is 1.18. The thickness (thickness of one of the forked portions) of a portion supported by the frame plate in each of the anisotropically conductive sheets is 20 µm.

(6) Circuit board for inspection:
Alumina ceramic (coefficient of linear thermal expansion: 4.8 x 10⁻⁶/K) was used as a base material to produce a circuit board for inspection, in which inspection electrodes were formed in accordance with a pattern corresponding to the pattern of the electrodes to be inspected in Wafer W1 for evaluation. This circuit board for inspection has dimensions of 30 cm x 30 cm as a whole and is square. The inspection electrodes each have dimensions of 60 µm in the lateral direction and 200 µm in the vertical direction. This circuit board for inspection will hereinafter be referred to as "Circuit Board T for inspection".

[Evaluation of anisotropically conductive connector]
The respective initial conductive properties of Anisotropically Conductive Connectors (A1) to (A10), comparative Anisotropically Conductive Connectors (B1) to (B10), Anisotropically Conductive Connectors (C1) to (C10) and comparative Anisotropically Conductive Connectors (D1) to (D10) were evaluated in the following manner.
Namely, Wafer W1 for evaluation was arranged on a test table, and an anisotropically conductive connector to be evaluated was arranged in alignment on this Wafer W1 for evaluation in such a manner that the conductive parts for connection thereof are located on the respective electrodes to be inspected of Wafer W1 for evaluation. Circuit Board T for inspection was then arranged in alignment on this anisotropically conductive connector in such a manner that the inspection electrodes thereof are located on the respective conductive parts for connection of the anisotropically conductive connector. Circuit Board T for inspection was then pressurized downward under a load of 58.95 kg (load applied to every conductive part for connection: 3 g on the average). An electric resistance between each of the 19,650 inspection electrodes in Circuit Board T for evaluation and the lead electrode of Wafer W1 for evaluation was successively measured at room temperature (25°C) as an electric resistance (hereinafter referred to as "conduction resistance") in the conductive part for connection to calculate out a proportion of conductive parts for connection that the conduction resistance was lower than 1 Ω.
Further, Wafer W2 for evaluation was arranged on the test table, and an anisotropically conductive connector to be evaluated was arranged in alignment on this Wafer W2 for evaluation in such a manner that the conductive parts for connection thereof are located on the respective electrodes to be inspected of Wafer W2 for evaluation. Circuit Board T for inspection was then arranged in alignment on this anisotropically conductive connector in such a manner that the inspection electrodes thereof are located on the respective conductive parts for connection of the anisotropically conductive connector. Circuit Board T for inspection was then pressurized downward under a load of 158 kg (load applied to every conductive part for connection: 8 g on the average). An electric resistance between adjoining 2 inspection electrodes in Circuit Board T for inspection was successively measured at room temperature (25°C) as an electric resistance (hereinafter referred to as "insulation resistance") between adjoining two conductive parts for connection (hereinafter referred to as "pair of conductive parts") to calculate out a proportion of pairs of conductive parts that the insulation resistance was 10 MΩ or higher.
The results are shown in Table 1 and Table 2.

[Table 1]

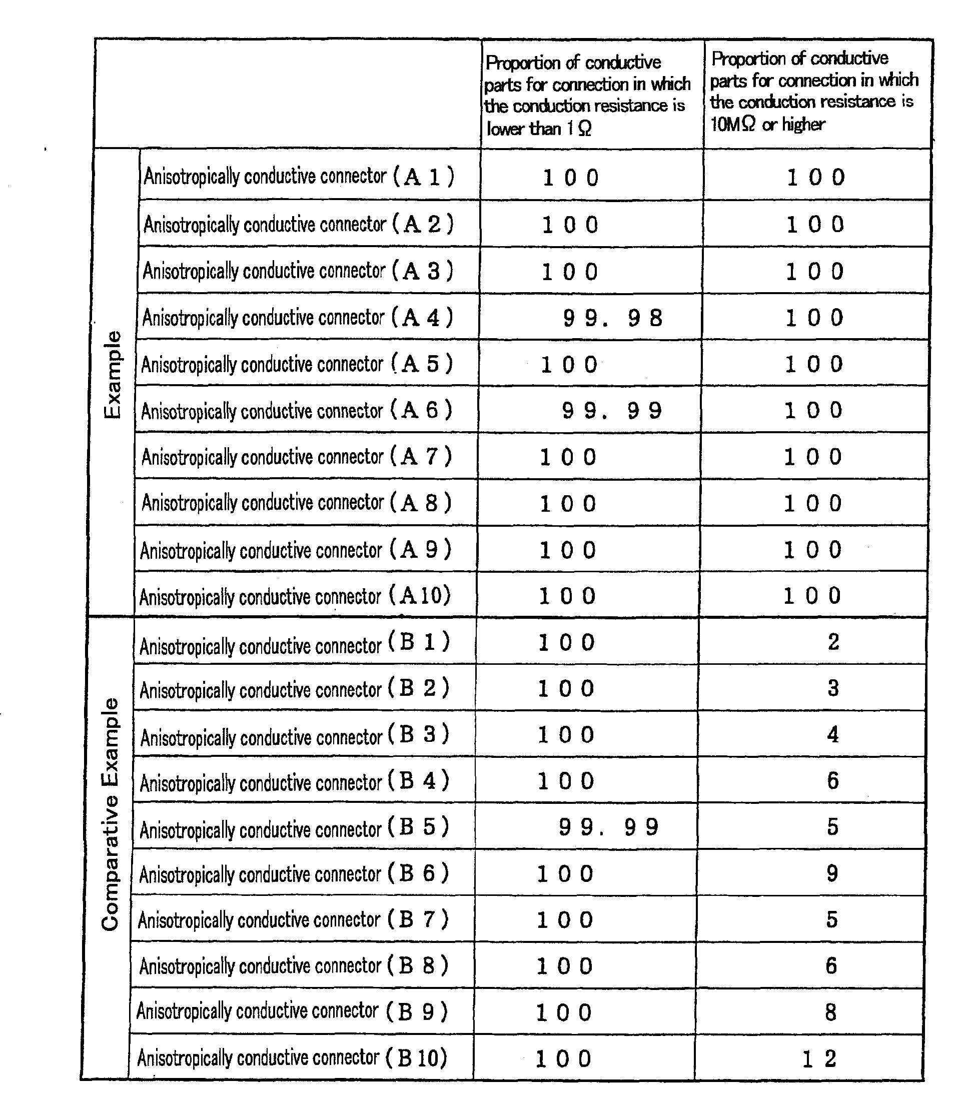

[Table 2]

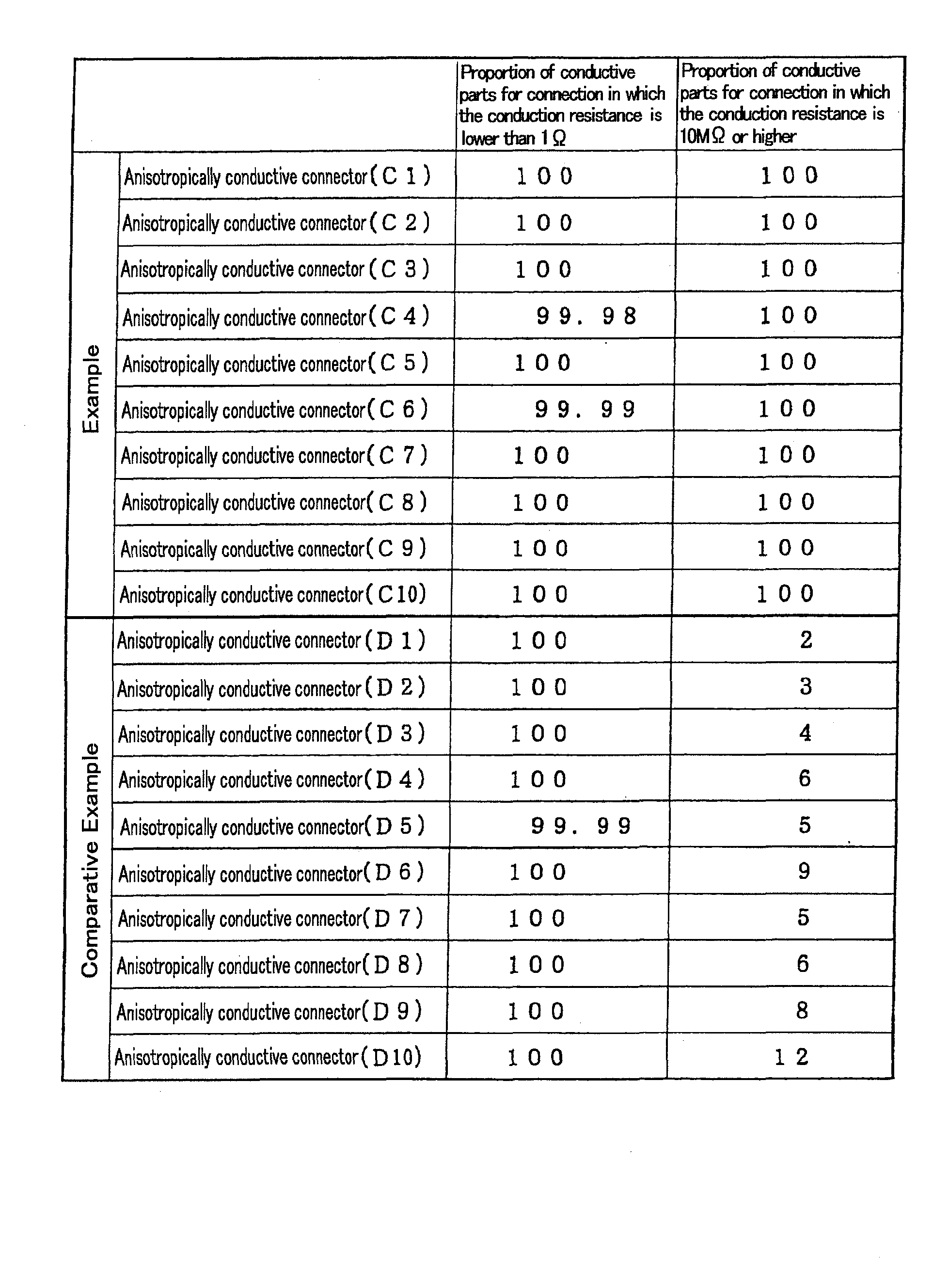

As apparent from the results described above, it was confirmed that according to Anisotropically Conductive Connectors (A1) to (A10) and Anisotropically Conductive Connectors (C1) to (C10) according to the present invention, sufficient insulating property can be secured between adjacent conductive path elements even when the pitch of the conductive path elements in each of the anisotropically conductive sheets is small, and moreover good conductive property can be achieved. In Anisotropically Conductive Connectors (C1) to (C10), it was also confirmed that the one surface-side projected parts and other surface-side projected parts in all the conductive path elements are formed in required forms.
On the other hand, it was confirmed that in comparative Anisotropically Conductive Connectors (B1) to (B10) and comparative Anisotropically Conductive Connectors (D1) to (D10), sufficient insulating property is not achieved between adjacent conductive path elements. Insulating sheet body portions between adjacent conductive path elements were also observed. As a result, it was confirmed that portions where conductive path elements are formed joining with each other are present, and so the individual conductive path elements cannot be formed independently of one another. In comparative Anisotropically Conductive Connectors (D1) to (D10) in particular, it was confirmed that about 0.5% of all the conductive path elements are those that one or both of their one surface-side projected parts and other surface-side projected parts are broken off.

## Claims

1. An anisotropically conductive sheet comprising an insulating sheet body formed of an elastic polymeric substance, in which a plurality of through-holes for forming conductive paths, each extending in a thickness-wise direction of the insulating sheet body, have been formed, and conductive path elements integrally provided in the respective through-holes for forming conductive paths of the insulating sheet body, wherein,
the through-holes for forming conductive paths in the insulating sheet body are formed by using a mask for exposure, in which a plurality of through-holes for beam transmission, the diameter of each of which becomes gradually small from one surface toward the other surface of the mask, have been formed in accordance with a pattern corresponding to a pattern of conductive path elements to be formed, and irradiating the insulating sheet body with a laser beam through the through-holes for beam transmission in the mask for exposure from the other surface side of the mask for exposure.

2. The anisotropically conductive sheet according to claim 1, wherein the conductive path elements contain conductive particles exhibiting magnetism in a state oriented in a thickness-wise direction thereof.

3. The anisotropically conductive sheet according to claim 1 or 2, wherein the elastic polymeric substance forming the insulating sheet body is silicone rubber.

4. The anisotropically conductive sheet according to any one of claims 1 to 3, wherein each of the conductive path elements has a projected part protruding from at least one surface of the insulating sheet body.

5. The anisotropically conductive sheet according to claim 4, wherein the one surface-side projected part protruding from the one surface of the insulating sheet body has a tapered shape that its diameter becomes gradually small from the proximal end toward the distal end thereof.

6. A process for producing an anisotropically conductive sheet, comprising:
the first step of providing a mask for exposure, in which a plurality of through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed, arranging the mask for exposure on one surface of an insulating sheet base formed of an elastic polymeric substance in such a manner that the one surface of the mask for exposure comes into contact with the one surface of the insulating sheet base, and irradiating the insulating sheet base with a laser beam through the through-holes for beam transmission in the mask for exposure from the other surface side of the mask for exposure, thereby forming an insulating sheet body in which a plurality of through-holes for forming conductive paths, each extending in a thickness-wise direction of the sheet body, have been formed, and
the second step of charging a conductive path element-forming material with conductive particles dispersed in a polymeric substance-forming material, which will become an elastic polymeric substance by being cured, into each of the through-holes for forming conductive paths in the insulating sheet body, thereby forming conductive path element-forming material layers in the respective through-holes for forming conductive paths in the insulating sheet body, and subjecting the conductive path element-forming material layers to a curing treatment, thereby forming conductive path elements provided integrally with the insulating sheet body.

7. The process according to claim 6 for producing the anisotropically conductive sheet, wherein particles exhibiting magnetism are used as the conductive particles in the conductive path element-forming material, and
a magnetic field is applied to the conductive path element-forming material layers formed integrally with the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers are subjected to the curing treatment in this state, thereby forming the conductive path elements.

8. The process according to claim 7 for producing the anisotropically conductive sheet, wherein a plurality of the through-holes for forming conductive paths are formed at a time by irradiating the insulating sheet base with the laser beam through a plurality of the through-holes for beam transmission in the mask for exposure.

9. The process according to any one of claims 6 to 8 for producing the anisotropically conductive sheet, wherein the conductive path element-forming material layers are formed by charging the conductive path element-forming material into the through-holes for forming conductive paths in the insulating sheet body and the through-holes for beam transmission in the mask for exposure in a state that the mask for exposure has remained arranged on the one surface of the insulating sheet body, and the conductive path element-forming material layers are subjected to the curing treatment, thereby forming conductive path elements each having a one surface-side projected part outwardly protruding from the one surface of the insulating sheet body, said projected part having a shape that its diameter becomes gradually small from the proximal end toward the distal end thereof.

10. A process for producing an anisotropically conductive sheet having an insulating sheet body formed of an elastic polymeric substance, in which a plurality of through-holes for forming conductive paths, each extending in a thickness-wise direction of the insulating sheet body, have been formed, and conductive path elements integrally provided in the respective through-holes for forming conductive paths of the insulating sheet body in a state protruding from at least one surface of the insulating sheet body, the process comprising:
the steps of providing a mask for exposure, in which a plurality of through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed,
preparing a laminate with a resin layer for forming projected parts formed on at least one surface of an insulating sheet base composed of the elastic polymeric substance, arranging the mask for exposure on one surface of the laminate in such a manner that the one surface of the mask for exposure comes into contact with the one surface of the laminate, and irradiating the insulating sheet base with a laser beam through the through-holes for beam transmission in the mask for exposure from the other surface side of the mask for exposure to form a plurality of through-holes for forming conductive paths, each extending in a thickness-wise direction of the insulating sheet base, in the insulating sheet base of the laminate, and at the same time form a plurality of through-holes for forming projected parts, each extending continuously with its corresponding through-hole for forming a conductive path in the thickness-wise direction, in the resin layer for forming projected parts of the laminate, thereby forming a primary composite body with the resin layer for forming projected parts formed on at least one surface of an insulating sheet body,
the steps of charging a conductive path element-forming material with conductive particles dispersed in a polymeric substance-forming material, which will become an elastic polymeric substance by being cured, into spaces for forming conductive path elements, including internal spaces of the through-holes for forming conductive paths in the insulating sheet body and internal spaces of the through-holes for forming projected parts in the resin layer for forming projected parts, thereby forming conductive path element-forming material layers in the respective spaces for forming conductive paths, and subjecting the conductive path element-forming material layers to a curing treatment to form conductive path elements, thereby forming a secondary composite body with a plurality of the conductive path elements integrally provided in the spaces for forming conductive path elements in the primary composite body, and
the step of dissolving the resin layer for forming projected parts of the secondary composite body to remove it, thereby forming projected parts protruding from at least one surface of the insulating sheet body on the respective conductive path elements.

11. The process according to claim 10 for producing the anisotropically conductive sheet, wherein silicone rubber is used as the elastic polymeric substance forming the insulating sheet body, and polyvinyl alcohol is used as a resin layer-forming material forming the resin layer for forming projected parts.

12. The process according to claim 11 for producing the anisotropically conductive sheet, wherein polyvinyl alcohol having an average polymerization degree of 100 to 5,000 is used.

13. The process according to any one of claims 10 to 12 for producing the anisotropically conductive sheet, wherein the resin layer for forming projected parts is formed in a thickness of 5 to 100 µm.

14. The process according to any one of claims 10 to 13 for producing the anisotropically conductive sheet, wherein particles exhibiting magnetism are used as the conductive particles in the conductive path element-forming material,
a magnetic field is applied to the conductive path element-forming material layers formed in the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers are subjected to the curing treatment in this state, thereby forming the conductive path elements.

15. The process according to any one of claims 10 to 14 for producing the anisotropically conductive sheet, wherein a plurality of the through-holes for forming conductive paths are formed at a time by irradiating the insulating sheet base with the laser beam through a plurality of the through-holes for beam transmission in the mask for exposure.

16. The process according to any one of claims 10 to 15 for producing the anisotropically conductive sheet, wherein a laminate with a resin layer for forming projected parts formed on the other surface of the insulating sheet base is used to form a primary composite body with the resin layer for forming projected parts formed on the other surface of the insulating sheet body,
the conductive path element-forming material is charged into spaces for forming conductive path elements, including internal spaces of the through-holes for beam transmission in the mask for exposure, internal spaces of the through-holes for forming conductive paths in the insulating sheet body and internal spaces of the through-holes for forming projected parts in the resin layer for forming projected parts, in a state that the mask for exposure has remained arranged on one surface of the insulating sheet body in the primary composite body to form the conductive path element-forming material layers, the conductive path element-forming material layers are subjected to the curing treatment to form conductive path elements,
the mask for exposure is removed to expose one end portions of the conductive path elements, thereby forming one surface-side projected parts each having a shape that its diameter becomes gradually small from the proximal end toward the distal end thereof, and the resin layer for forming projected parts is dissolved and removed, thereby forming the other surface-side projected parts protruding from the other surface of the insulating sheet body.

17. The process according to any one of claims 6 to 16 for producing the anisotropically conductive sheet, wherein the laser beam is emitted by means of a carbon dioxide gas laser.

18. The process according to any one of claims 6 to 17 for producing the anisotropically conductive sheet, wherein a mask having a thickness of 5 to 100 µm is used as the mask for exposure

19. The process according to any one of claims 6 to 18 for producing the anisotropically conductive sheet, wherein a mask having an opening diameter ratio r2/r1 of an opening diameter r2 in the other surface of the mask to an opening diameter r1 in one surface of the mask of from 0.2 to 0.98 is used as the mask for exposure.

20. The process according to any one of claims 6 to 19 for producing the anisotropically conductive sheet, wherein a mask composed of a metal is used as the mask for exposure.

21. An anisotropically conductive connector comprising a frame plate having an opening and the anisotropically conductive sheet according to any one of claims 1 to 5, which is arranged so as to close the opening in the frame plate and supported by an opening edge of the frame plate.

22. An anisotropically conductive connector suitable for use in conducting electrical inspection of each of a plurality of integrated circuits formed on a wafer in a state of the wafer, which comprises:
a frame plate, in which a plurality of openings have been formed correspondingly to regions, in which electrodes to be inspected in all of the integrated circuits formed on the wafer, which is an object of inspection, have been arranged, and a plurality of anisotropically conductive sheets respectively arranged so as to close the openings in the frame plate and supported by their corresponding opening edges of the frame plate, wherein each of the anisotropically conductive sheets is the anisotropically conductive sheet according to any one of claims 1 to 5.

23. An anisotropically conductive connector suitable for use in conducting electrical inspection of each of a plurality of integrated circuits formed on a wafer in a state of the wafer, which comprises:
a frame plate, in which a plurality of openings have been formed correspondingly to regions, in which electrodes to be inspected in a plurality of integrated circuits selected from among the integrated circuits formed on the wafer, which is an object of inspection, have been arranged, and a plurality of anisotropically conductive sheets respectively arranged so as to close the openings in the frame plate and supported by their corresponding opening edges of the frame plate, wherein each of the anisotropically conductive sheets is the anisotropically conductive sheet according to any one of claims 1 to 5.

24. A process for producing an anisotropically conductive connector, which comprising:
the first step of providing a frame plate, in which an opening has been formed, forming a layer of a polymeric substance-forming material, which will become an elastic polymeric substance by being cured, in the opening of the frame plate and at a peripheral edge portion thereof and subjecting the polymeric substance-forming material layer to a curing treatment, thereby forming a primary composite body with an insulating sheet base composed of the elastic polymeric substance and formed so as to close the opening in the frame plate supported by an opening edge of the frame plate,
the second step of irradiating the insulating sheet base with a laser beam through a plurality of through-holes for beam transmission in a mask for exposure, in which the through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed, from the side of the other surface of the mask for exposure, thereby forming a secondary composite body with an insulating sheet body, in which a plurality of through-holes for forming conductive paths, each extending in a thickness-wise direction of the sheet body, have been formed, and which has been formed so as to close the opening in the frame plate, supported by the opening edge of the frame plate, and
the third step of charging a conductive path element-forming material with conductive particles dispersed in a polymeric substance-forming material, which will become an elastic polymeric substance by being cured, into each of the through-holes for forming conductive paths in the secondary composite body, thereby forming conductive path element-forming material layers, and subjecting the conductive path element-forming material layers to a curing treatment, thereby forming an anisotropically conductive sheet with conductive path elements integrally provided in the through-holes for forming conductive path elements of the insulating sheet body.

25. A process for producing an anisotropically conductive connector, which comprises:
the first step of providing a frame plate, in which a plurality of openings each extending in a thickness-wise direction of the frame plate have been formed correspondingly to regions, in which electrodes to be inspected in all of integrated circuits formed on a wafer, which is an object of inspection, have been arranged, or regions, in which electrodes to be inspected in a plurality of integrated circuits selected from among the integrated circuits formed on the wafer have been arranged,
forming a layer of a polymeric substance-forming material, which will become an elastic polymeric substance by being cured, in each of the openings of the frame plate and at a peripheral edge portion thereof and subjecting the polymeric substance-forming material layer to a curing treatment, thereby forming a primary composite body with a plurality of insulating sheet bases each composed of the elastic polymeric substance and formed so as to close the openings in the frame plate supported by their corresponding opening edges of the frame plate,
the second step of irradiating the insulating sheet bases with a laser beam through a plurality of through-holes for beam transmission in a mask for exposure, in which the through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed, from the side of the other surface of the mask for exposure, thereby forming a secondary composite body with a plurality of insulating sheet bodies, in which a plurality of through-holes for forming conductive paths, each extending in a thickness-wise direction of each of the sheet bodies, have been formed, supported by their corresponding opening edges of the frame plate, and
the third step of charging a conductive path element-forming material with conductive particles dispersed in a polymeric substance-forming material, which will become an elastic polymeric substance by being cured, into each of the through-holes for forming conductive paths in the secondary composite body, thereby forming conductive path element-forming material layers, and subjecting the conductive path element-forming material layers to a curing treatment, thereby forming anisotropically conductive sheets with conductive path elements integrally provided in the through-holes for forming conductive path elements of each of the insulating sheet bodies.

26. The process according to claim 24 or 25 for producing the anisotropically conductive connector, wherein particles exhibiting magnetism are used as the conductive particles in the conductive path element-forming material, and
a magnetic field is applied to the conductive path element-forming material layers formed in the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers are subjected to the curing treatment in this state, thereby forming the anisotropically conductive sheet with the conductive path elements integrally provided in the through-holes for forming conductive path elements of the insulating sheet body.

27. The process according to any one of claims 24 to 26 for producing the anisotropically conductive connector, wherein the polymeric substance-forming material is applied on to one surface of a flat plate-like supporting plate, the frame plate is arranged in such a manner that the other surface of the frame plate is separated from and opposed to the one surface of the supporting plate, the mask for exposure is arranged in such a manner that one surface of the mask is separated from and opposed to one surface of the frame plate, these are superimposed on one another to pressurize them, thereby forming polymeric substance-forming material layers of the intended form in forming spaces including internal spaces of the openings of the frame plate, spaces between the frame plate and the mask for exposure and internal spaces of the through-holes for beam transmission in the mask for exposure, and the polymeric substance-forming material layers are subjected to the curing treatment, thereby forming a primary composite body, in which a plurality of insulating sheet bases each having projected part-forming portions are arranged so as to close the openings in the frame plate, and peripheral edge portions of the insulating sheet bases are supported by their corresponding opening edges of the frame plate,
the insulating sheet bases are irradiated with the laser beam through the through-holes for beam transmission in the mask for exposure from the other surface side of the mask for exposure, thereby forming a secondary composite body with a plurality of insulating sheet bodies, in which through-holes for forming conductive paths, each extending in a thickness-wise direction of the sheet body, have been formed in the projected part-forming portions, supported by their corresponding opening edges of the frame plate, and
the conductive path element-forming material with the conductive particles dispersed in the polymeric substance-forming material, which will become the elastic polymeric substance by being cured, is charged into the through-holes for forming conductive paths of the respective projected part-forming portions in the secondary composite body, thereby forming conductive path element-forming material layers, and the conductive path element-forming material layers are subjected to the curing treatment, thereby forming anisotropically conductive sheets with conductive path elements each having a one surface-side projected part protruding from the one surface of the insulating sheet body integrally provided in the through-holes for forming conductive path elements in each of the insulating sheet bodies.

28. A process for producing an anisotropically conductive connector equipped with a frame plate having an opening and an anisotropically conductive sheet arranged so as to close the opening in the frame plate and supported by an opening edge of the frame plate, in the anisotropically conductive sheet of which a plurality of conductive path elements each extending in a thickness-wise direction of the sheet are formed in a state protruding from at least one surface of an insulating sheet base composed of an elastic polymeric substance, the process comprising:
the steps of providing the frame plate, in which the opening has been formed, forming a layer of a polymeric substance-forming material, which will become the elastic polymeric substance by being cured, in the opening of the frame plate and at an opening edge portion thereof, and subjecting the polymeric substance-forming material layer to a curing treatment, thereby forming an insulating sheet base composed of the elastic polymeric substance in the opening of the frame plate and at the opening edge portion thereof to prepare a laminate with a resin layer for forming projected parts formed on at least one surface of the insulating sheet base,
the steps of arranging a mask for exposure, in which a plurality of through-holes for beam transmission, the diameter of each of which becomes gradually small from one surface toward the other surface of the mask, have been formed in accordance with a pattern corresponding to a pattern of conductive path elements to be formed, on one surface of the laminate in such a manner that the one surface of the mask for exposure comes into contact with the one surface of the laminate, and irradiating the insulating sheet base with a laser beam through the through-holes for beam transmission in the mask for exposure from the other surface side of the mask for exposure to form a plurality of through-holes for forming conductive paths, each extending in a thickness-wise direction of the insulating sheet base, in the insulating sheet base of the laminate, and at the same time form a plurality of through-holes for forming projected parts, each extending continuously with its corresponding through-hole for forming a conductive path in the thickness-wise direction, in the resin layer for forming projected parts of the laminate, thereby forming a primary composite body with the resin layer for forming projected parts formed on at least one surface of an insulating sheet body provided in the opening of the frame plate and at the opening edge portion thereof,
the steps of charging a conductive path element-forming material with conductive particles dispersed in a polymeric substance-forming material, which will become an elastic polymeric substance by being cured, into spaces for forming conductive path elements, including internal spaces of the through-holes for forming conductive paths in the insulating sheet body and internal spaces of the through-holes for forming projected parts in the resin layer for forming projected parts, thereby forming conductive path element-forming material layers in the respective spaces for forming conductive paths, and subjecting the conductive path element-forming material layers to a curing treatment to form conductive path elements, thereby forming a secondary composite body with a plurality of the conductive path elements integrally provided in the spaces for forming conductive path elements in the primary composite body, and
the step of dissolving the resin layer for forming projected parts of the secondary composite body to remove it, thereby forming projected parts protruding from at least one surface of the insulating sheet body on the respective conductive path elements.

29. A process for producing an anisotropically conductive connector, which comprises:
the steps of providing a frame plate, in which a plurality of openings each extending in a thickness-wise direction of the frame plate have been formed correspondingly to regions, in which electrodes to be inspected in all of integrated circuits formed on a wafer, which is an object of inspection, have been arranged, or regions, in which electrodes to be inspected in a plurality of integrated circuits selected from among the integrated circuits formed on the wafer have been arranged,
forming a layer of a polymeric substance-forming material, which will become an elastic polymeric substance by being cured, in each of the openings of the frame plate and at an opening edge portion thereof and subjecting the polymeric substance-forming material layer to a curing treatment, thereby preparing a laminate, in which insulating sheet bases composed of the elastic polymeric substance and formed so as to close the respective openings in the frame plate are supported by their corresponding opening edges of the frame plate, and a resin layer for forming projected parts is formed on at least one surface of the insulating sheet base,
the steps of arranging a mask for exposure, in which a plurality of through-holes for beam transmission, the diameter of each of which becomes gradually small from one surface toward the other surface of the mask, and each of which extends in a thickness-wise direction of the mask, have been formed in accordance with a pattern corresponding to a pattern of conductive path elements to be formed, on one surface of the laminate in such a manner that the one surface of the mask for exposure comes into contact with the one surface of the laminate, and irradiating the insulating sheet bases with a laser beam through the through-holes for beam transmission in the mask for exposure from the other surface side of the mask for exposure to form a plurality of through-holes for forming conductive paths, each extending in a thickness-wise direction of the insulating sheet base, in the insulating sheet bases of the laminate, and at the same time form a plurality of through-holes for forming projected parts, each extending continuously with its corresponding through-hole for forming a conductive path in the thickness-wise direction, in the resin layer for forming projected parts of the laminate, thereby forming a primary composite body with the resin layer for forming projected parts formed on at least one surface of each of insulating sheet bodies provided in the opening of the frame plate and at the opening edge portion thereof,
the steps of charging a conductive path element-forming material with conductive particles dispersed in a polymeric substance-forming material, which will become an elastic polymeric substance by being cured, into spaces for forming conductive path elements, including internal spaces of the through-holes for forming conductive paths in the insulating sheet bodies and internal spaces of the through-holes for forming projected parts in the resin layer for forming projected parts, thereby forming conductive path element-forming material layers in the respective spaces for forming conductive paths, and subjecting the conductive path element-forming material layers to a curing treatment to form conductive path elements, thereby forming a secondary composite body with a plurality of the conductive path elements integrally provided in the spaces for forming conductive path elements in the primary composite body, and
the step of dissolving the resin layer for forming projected parts of the secondary composite body to remove it, thereby forming projected parts protruding from at least one surface of each of the insulating sheet bodies on the respective conductive path elements.

30. The process according to claim 28 or 29 for producing the anisotropically conductive connector, wherein silicone rubber is used as the elastic polymeric substance forming the insulating sheet body, and polyvinyl alcohol is used as a resin layer-forming material forming the resin layer for forming projected parts.

31. The process according to claim 30 for producing the anisotropically conductive connector, wherein polyvinyl alcohol having an average polymerization degree of 100 to 5,000 is used.

32. The process according to any one of claims 28 to 31 for producing the anisotropically conductive connector, wherein the resin layer for forming projected parts is formed in a thickness of 5 to 100 µm.

33. The process according to any one of claims 28 to 32 for producing the anisotropically conductive connector, wherein particles exhibiting magnetism are used as the conductive particles in the conductive path element-forming material,
a magnetic field is applied to the conductive path element-forming material layers formed in the insulating sheet body in a thickness-wise direction thereof, thereby orienting the conductive particles dispersed in each of the conductive path element-forming material layers in the thickness-wise direction of the conductive path element-forming material layer, and the conductive path element-forming material layers are subjected to the curing treatment in this state, thereby forming the conductive path elements integrally provided in the through-holes for forming conductive path elements of the insulating sheet body.

34. The process according to any one of claims 28 to 33 for producing the anisotropically conductive connector, wherein a laminate material is prepared by forming a resin layer for forming projected parts on one surface of a flat plate-like supporting plate, the polymeric substance-forming material is applied on to either or both of one surface of the laminate material and one surface of the mask for exposure to form a polymeric substance-forming material layer, the frame plate is arranged in such a manner that the other surface of the frame plate is separated from and opposed to the one surface of the laminate material, the mask for exposure is arranged in such a manner that the one surface of the mask is separated from and opposed to one surface of the frame plate, these are superimposed on one another to pressurize them, thereby forming polymeric substance-forming material layers of the intended form in forming spaces including internal spaces of the openings of the frame plate, spaces between the frame plate and the mask for exposure and internal spaces of the through-holes for beam transmission in the mask for exposure, and the polymeric substance-forming material layers are subjected to the curing treatment, thereby forming insulating sheet bases,
the insulating sheet bases are irradiated with the laser beam through the through-holes for beam transmission in the mask for exposure from the other surface side of the mask for exposure to form a plurality of through-holes for forming conductive paths, each extending in the thickness-wise direction, in each of the insulating sheet bases, and at the same time form a plurality of through-holes for forming projected parts, each extending continuously with its corresponding through-hole for forming a conductive path in the thickness-wise direction, in each of the resin layers for forming projected parts, thereby forming a primary composite body with the resin layer for forming projected parts provided on the other surface of an insulating sheet body provided in each of the openings in the frame plate and at an opening edge portion thereof,
the conductive path element-forming material is charged into spaces for forming conductive path elements, including internal spaces of the through-holes for forming conductive paths in the insulating sheet bodies and internal spaces of the through-holes for forming projected parts in the resin layers for forming projected parts, thereby forming conductive path element-forming material layers, and the conductive path element-forming material layers are subjected to the curing treatment to form conductive path elements, and
the mask for exposure is removed to expose one end portions of the conductive path elements, thereby forming one surface-side projected parts each having a shape that its diameter becomes gradually small from the proximal end toward the distal end thereof, and the resin layers for forming projected parts are dissolved and removed, thereby forming the other surface-side projected parts protruding from the other surface of each of the insulating sheet bodies.

35. The process according to claim 27 or 34 for producing the anisotropically conductive connector, wherein one composed of the same material as used in the frame plate is use as the supporting plate.

36. The process according to any one of claims 24 to 35 for producing the anisotropically conductive connector, wherein the laser beam is emitted by means of a carbon dioxide gas laser.

37. The process according to any one of claims 24 to 36 for producing the anisotropically conductive connector, wherein a mask having a thickness of 5 to 100 µm is used as the mask for exposure

38. The process according to any one of claims 24 to 37 for producing the anisotropically conductive connector, wherein a mask having an opening diameter ratio r2/r1 of an opening diameter r2 in the other surface of the mask to an opening diameter r1 in one surface of the mask of from 0.2 to 0.98 is used as the mask for exposure.

39. The process according to any one of claims 24 to 38 for producing the anisotropically conductive connector, wherein a mask composed of a metal is used as the mask for exposure.

40. A probe for circuit inspection, which comprises a circuit board for inspection, on the surface of which inspection electrodes have been formed in accordance with a pattern corresponding to a pattern of electrodes to be inspected of a circuit device, which is an object of inspection, and the anisotropically conductive sheet according to any one of claims 1 to 5 or the anisotropically conductive connector according to claim 21, which is arranged on the surface of the circuit board for inspection.

41. A probe for circuit inspection that is suitable for use in conducting electrical inspection of each of a plurality of integrated circuits formed on a wafer in a state of the wafer, which comprises:
a circuit board for inspection, on the surface of which inspection electrodes have been formed in accordance with a pattern corresponding to a pattern of electrodes to be inspected in all of the integrated circuits formed on the wafer, which is an object of inspection, and the anisotropically conductive connector according to claim 22, which is arranged on the surface of the circuit board for inspection.

42. A probe for circuit inspection that is suitable for use in conducting electrical inspection of each of a plurality of integrated circuits formed on a wafer in a state of the wafer, which comprises:
a circuit board for inspection, on the surface of which inspection electrodes have been formed in accordance with a pattern corresponding to a pattern of electrodes to be inspected in a plurality of integrated circuits selected from among the integrated circuits formed on the wafer, which is an object of inspection, and the anisotropically conductive connector according to claim 23, which is arranged on the surface of the circuit board for inspection.

43. The probes for circuit inspection according to claim 41 or 42, wherein a sheet-like connector composed of an insulating sheet and a plurality of electrode structures each extending through in a thickness-wise direction of the insulating sheet and arranged in accordance with a pattern corresponding to the pattern of the inspection electrodes in the circuit board for inspection is arranged on the anisotropically conductive connector.

44. An electrical inspection apparatus for circuit devices, comprising the probe for circuit inspection according to any one of claims 40 to 43.
